(19) Europäisches Patentamt
European Patent Office
Office européen des brevets

(11) EP 4 024 096 A1

(12) **EUROPEAN PATENT APPLICATION**
published in accordance with Art. 153(4) EPC

(43) Date of publication:
**06.07.2022 Bulletin 2022/27**

(21) Application number: **20856853.5**

(22) Date of filing: **29.07.2020**

(51) International Patent Classification (IPC):
***G02B 5/22*** *(2006.01)* ***C09B 67/20*** *(2006.01)*
***G03F 7/004*** *(2006.01)* ***G03F 7/027*** *(2006.01)*
***H01L 27/144*** *(2006.01)* ***H01L 27/146*** *(2006.01)*
***H01L 31/0232*** *(2014.01)*

(52) Cooperative Patent Classification (CPC):
**G02B 5/22; G03F 7/004; G03F 7/027; H01L 27/144; H01L 27/146; H01L 31/0232**

(86) International application number:
**PCT/JP2020/028984**

(87) International publication number:
**WO 2021/039253 (04.03.2021 Gazette 2021/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.08.2019 JP 2019158800**
**20.02.2020 JP 2020027475**

(71) Applicant: **FUJIFILM Corporation**
**Tokyo 106-8620 (JP)**

(72) Inventors:
- **MIYATA, Tetsushi**
  **Haibara-gun, Shizuoka 421-0396 (JP)**
- **ARAYAMA, Kyohei**
  **Haibara-gun, Shizuoka 421-0396 (JP)**
- **YOKOYAMA, Norifumi**
  **Haibara-gun, Shizuoka 421-0396 (JP)**
- **TSUYAMA, Hiroaki**
  **Haibara-gun, Shizuoka 421-0396 (JP)**

(74) Representative: **HGF**
**HGF Limited**
**1 City Walk**
**Leeds LS11 9DX (GB)**

# (54) COMPOSITION, FILM, OPTICAL FILTER AND METHOD FOR PRODUCING SAME, SOLID-STATE IMAGING ELEMENT, INFRARED SENSOR AND SENSOR MODULE

(57) Provided are a composition having excellent moisture resistance of a film to be formed and excellent dispersion stability of a pigment; and a film formed of the composition. The composition includes a pigment, a pigment derivative which has at least one group selected from the group consisting of groups represented Formula (2): -L-NH-$R^2$, and the like, a dispersant which has a constitutional unit having an adsorbing group and a constitutional unit having a steric repulsive group, and is a random copolymer or an alternating copolymer, and a solvent. In Formula (2), L represents -CO-, -$SO_2$-, or -PO($R^{21}$)-, $R^{21}$ represents a hydrogen atom or a monovalent organic group having 1 or more carbon atoms, $R^2$ represents -$COR^{22}$, -$SO_2R^{22}$, or -PO($R^{22}$)$_2$, and $R^{22}$'s each independently represent a hydrogen atom or a monovalent organic group having 1 or more carbon atoms.

FIG. 1

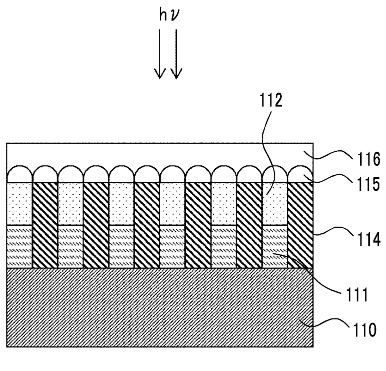


EP 4 024 096 A1

## Description

## BACKGROUND OF THE INVENTION

1. Field of the Invention

The present disclosure relates to a composition, a film, an optical filter and a method for manufacturing the same, a solid-state imaging element, an infrared sensor, and a sensor module.

2. Description of the Related Art

As an example of an optical filter, an infrared cut filter, an infrared transmitting filter, and the like, which include a pigment having absorption in an infrared region, have been known.

As a composition for obtaining the optical filter as described above, for example, JP2018-087939A discloses a near-infrared absorbing composition which contains a near-infrared absorbing coloring agent having a specific structure having a squarylium skeleton, a basic resin-type dispersant, and an organic solvent, in which the basic resin-type dispersant includes a basic resin-type dispersant which is a block copolymer consisting of an A block having a tertiary amino group or a quaternary ammonium salt group and a B block not having a tertiary amino group and a quaternary ammonium salt group in the side chain, an amine value of the basic resin-type dispersant in the solid content is 10 to 200 mgKOH/g and a quaternary ammonium salt value thereof is 10 to 90 mgKOH/g, and the organic solvent which has a boiling point at 760 mmHg of 120°C to 210°C and has a solubility parameter of 9.0 to 13.0.

## SUMMARY OF THE INVENTION

An object to be achieved by one embodiment of the present disclosure is to provide a composition having excellent moisture resistance of a film to be formed and excellent dispersion stability of a pigment.

An object to be achieved by another embodiment of the present disclosure is to provide a film formed of the composition, an optical filter and a method for manufacturing the optical filter, a solid-state imaging element, an infrared sensor, and a sensor module.

Methods for achieving the objects described above include the following aspects.

<1> A composition comprising:

a pigment;
a pigment derivative which has at least one group selected from the group consisting of groups represented by any one of Formula (1) to Formula (4);
a dispersant which has a constitutional unit having an adsorbing group and a constitutional unit having a steric repulsive group, and is a random copolymer or an alternating copolymer; and
a solvent,

Formula (1): $-NH-R^1$

in Formula (1), $R^1$ is a substituent represented by $-COR^{11}$, $-SO_2R^{11}$, or $PO(R^{11})_2$, which has a total carbon number of 10 or less, and $R^{11}$'s each independently represent a hydrogen atom or a monovalent organic group having 1 or more carbon atoms,

Formula (2): $-L-NH-R^2$

in Formula (2), L represents -CO-, $-SO_2-$, or $-PO(R^{21})-$, $R^{21}$ represents a hydrogen atom or a monovalent organic group having 1 or more carbon atoms, $R^2$ represents $-COR^{22}$, $-SO_2R^{22}$, or $-PO(R^{22})_2$, and $R^{22}$'s each independently represent a hydrogen atom or a monovalent organic group having 1 or more carbon atoms,

Formula (3): $-N^+(R^3)_3\ X^-$

in Formula (3), $R^3$'s each independently represent a hydrogen atom or a monovalent organic group having 1 or more carbon atoms, at least one of three $R^3$'s is an alkyl group having 3 or more carbon atoms, and $X^-$ represents a counter anion,

Formula (4): $-L-N^+(R^4)_3\ X^-$

in Formula (4), L represents -CO-, $-SO_2-$, or $-PO(R^{42})-$, $R^{42}$ represents a hydrogen atom or a monovalent organic group having 1 or more carbon atoms, $R^4$'s each independently represent a hydrogen atom or a monovalent organic group having 1 or more carbon atoms, at least one of three $R^4$'s is an alkyl group having 3 or more carbon atoms, and $X^-$ represents a counter anion.

<2> The composition according to <1>,
in which the pigment derivative has a group represented by Formula (2).
<3> The composition according to <2>,
in which L in Formula (2) represents -CO-, $R^2$ represents $-SO_2R^{22}$, and $R^{22}$ represents a monovalent organic group having 1 or more carbon atoms.
<4> The composition according to <2> or <3>,
in which L in Formula (2) represents -CO-, $R^2$ represents $-SO_2R^{22}$, and $R^{22}$ represents a monovalent organic group including a fluorine atom and having 1 or more carbon atoms.
<5> The composition according to any one of <1> to <4>,
in which the dispersant is a random copolymer.
<6> The composition according to any one of <1> to <5>,
in which the dispersant has a basic group as the adsorbing group.
<7> The composition according to any one of <1> to <6>,
in which the pigment includes a pigment having absorption in an infrared region.
<8> The composition according to any one of <1> to <7>,
in which the pigment and the pigment derivative have the same coloring agent skeleton.
<9> The composition according to <8>,
in which the coloring agent skeleton is a squarylium coloring agent skeleton or a croconium coloring agent skeleton.
<10> The composition according to any one of <1> to <9>,
in which the pigment includes a chromatic pigment.
<11> The composition according to any one of <1> to <10>, further comprising:

a polymerizable compound; and
a polymerization initiator.

<12> A film which consists of the composition according to <11> or is obtained by curing the composition.
<13> An optical filter comprising:
the film according to <12>.
<14> The optical filter according to <13>,
in which the optical filter is an infrared cut filter or an infrared transmitting filter.
<15> A solid-state imaging element comprising:
the film according to <12>.
<16> An infrared sensor comprising:
the film according to <12>.
<17> A method for manufacturing an optical filter, comprising:

applying the composition according to <11> to a support to form a composition layer;
exposing the composition layer in a patterned manner; and
developing and removing a non-exposed portion of the composition layer to form a pattern.

<18> A method for manufacturing an optical filter, comprising:

applying the composition according to <11> to a support to form a composition layer and curing the composition to form a cured composition layer;
forming a photoresist layer on the cured composition layer;
obtaining a resist pattern by patterning the photoresist layer by exposure and development; and
dry-etching the layer using the resist pattern as an etching mask.

<19> A sensor module comprising:

a photoelectric conversion element; and

the optical filter according to <13> or <14>.

According to one embodiment of the present disclosure, a composition having excellent moisture resistance of a film to be formed and excellent dispersion stability of a pigment is provided.

According to another embodiment of the present disclosure, a film formed of the composition, an optical filter and a method for manufacturing the optical filter, a solid-state imaging element, an infrared sensor, and a sensor module are provided.

## BRIEF DESCRIPTION OF THE DRAWINGS

Fig. 1 is a schematic diagram indicating an embodiment of an infrared sensor according to the present disclosure.

## DESCRIPTION OF THE PREFERRED EMBODIMENTS

Hereinafter, the contents of the present disclosure will be described in detail.

In the present specification, a "total solid content" refers to a total mass of components obtained by removing a solvent from the whole composition of the composition. In addition, a "solid content" is a component obtained by removing a solvent as described above, and for example, the component may be solid or may be liquid at 25°C.

In a case where substitution or unsubstitution is not noted in regard to the notation of a "group" (atomic group) in the present specification, the "group" includes not only a group not having a substituent but also a group having a substituent. For example, an "alkyl group" includes not only an alkyl group having no substituent (unsubstituted alkyl group), but also an alkyl group having a substituent (substituted alkyl group).

In the present specification, unless specified otherwise, "exposure" denotes not only exposure using light but also drawing using a corpuscular beam such as an electron beam or an ion beam. In addition, generally, examples of light used for the exposure include actinic rays or radiation such as a bright line spectrum of a mercury lamp, far ultraviolet rays typified by an excimer laser, extreme ultraviolet rays (EUV light), X-rays, or electron beams.

In the present specification, "(meth)acrylate" denotes either or both of acrylate and methacrylate, "(meth)acryl" denotes either or both of acryl and methacryl, and "(meth)acryloyl" denotes either or both of acryloyl and methacryloyl.

In the present specification, in a chemical formula, Me represents a methyl group, Et represents an ethyl group, Pr represents a propyl group, Bu represents a butyl group, Ac represents an acetyl group, Bn represents a benzyl group, and Ph represents a phenyl group.

In the present specification, the term "step" is not only an independent step, but also includes a step which is not clearly distinguished from other steps in a case where an intended action of the step is obtained.

In addition, in the present disclosure, "mass%" is identical to "weight%" and "part by mass" is identical to "part by weight".

Further, in the present disclosure, a combination of two or more preferred aspects is a more preferred aspect.

In addition, unless otherwise specified, a transmittance in the present disclosure is a transmittance at 25°C.

In the present specification, a weight-average molecular weight and a number-average molecular weight are defined as values in terms of polystyrene measured by gel permeation chromatography (GPC).

In the present disclosure, in a case where the content of a "constitutional unit" in a resin is defined by a molar ratio, the "constitutional unit" is synonymous with the "monomer unit". However, the "monomer unit" in the present disclosure may be modified after polymerization by a polymer reaction or the like.

<Composition>

A composition according to an embodiment of the present disclosure includes a pigment, a pigment derivative (hereinafter, also referred to as a specific pigment derivative) which has at least one group selected from the group consisting of groups represented by any one of Formula (1) to Formula (4), a dispersant (hereinafter, also referred to as a specific dispersant) which has a constitutional unit having an adsorbing group and a constitutional unit having a steric repulsive group, and is a random copolymer or an alternating copolymer, and a solvent.

Formula (1): $-NH-R^1$

In Formula (1), $R^1$ is a substituent represented by $-COR^{11}$, $-SO_2R^{11}$, or $PO(R^{11})_2$, which has a total carbon number of 10 or less, and $R^{11}$'s each independently represent a hydrogen atom or a monovalent organic group having 1 or more carbon atoms.

Formula (2): $-L-NH-R^2$

In Formula (2), L represents -CO-, $-SO_2-$, or $-PO(R^{21})-$, $R^{21}$ represents a hydrogen atom or a monovalent organic group having 1 or more carbon atoms, $R^2$ represents $-COR^{22}$, $-SO_2R^{22}$, or $-PO(R^{22})_2$, and $R^{22}$'s each independently represent a hydrogen atom or a monovalent organic group having 1 or more carbon atoms.

Formula (3): $-N^+(R^3)_3\ X^-$

In Formula (3), $R^3$'s each independently represent a hydrogen atom or a monovalent organic group having 1 or more carbon atoms, at least one of three $R^3$'s is an alkyl group having 3 or more carbon atoms, and $X^-$ represents a counter anion.

Formula (4): $-L-N^+(R^4)_3\ X^-$

In Formula (4), L represents -CO-, $-SO_2-$, or $-PO(R^{42})-$, $R^{42}$ represents a hydrogen atom or a monovalent organic group having 1 or more carbon atoms, $R^4$'s each independently represent a hydrogen atom or a monovalent organic group having 1 or more carbon atoms, at least one of three $R^4$'s is an alkyl group having 3 or more carbon atoms, and $X^-$ represents a counter anion.

A composition including a pigment, a pigment derivative, a dispersant, and a solvent has been known.

In the related art, as the dispersant used in combination with a pigment derivative, it has been known that a dispersant called a multipoint terminal type or a surface adsorption-type, for example, a dispersant having an unevenly distributed adsorption site with a pigment derivative by a block copolymer as disclosed in JP2018-087939A is preferable.

On the other hand, as the pigment derivative, a pigment derivative having an adsorption site with a dispersant in a middle part of the molecular chain, instead of a terminal part of the molecular chain, has been studied.

In a case of the pigment derivative having an adsorption site with a dispersant in the middle part of the molecular chain, in a case where the dispersant having an unevenly distributed adsorption site with the pigment derivative is combined, a certain degree of pigment dispersibility is obtained, but the desired dispersion stability is not achieved.

Therefore, in the present invention, in a case where a study is conducted on a dispersant to be combined with the pigment derivative having an adsorption site with the dispersant in the middle part of the molecular chain, by using a dispersant in which the adsorption site with the pigment derivative is not unevenly distributed, that is, a dispersant which has a constitutional unit having an adsorbing group and a constitutional unit having a steric repulsive group, and is a random copolymer or an alternating copolymer, it has been found that a composition having excellent dispersion stability of the pigment is obtained.

That is, the composition according to the embodiment of the present disclosure includes a pigment, a specific pigment derivative which has at least one group selected from the group consisting of groups represented by any one of Formula (1) to Formula (4), a specific dispersant which has a constitutional unit having an adsorbing group and a constitutional unit having a steric repulsive group, and is a random copolymer or an alternating copolymer, and a solvent.

By using the specific pigment derivative and the specific dispersant in combination, the specific dispersant is efficiently adsorbed on the specific pigment derivative, and steric repulsion is likely to occur between the specific pigment derivatives. As a result, it is presumed that the pigment adsorbed on the specific pigment derivative can be stably dispersed.

In addition, in a case where the composition according to the embodiment of the present disclosure is a curable composition and a film is formed by the curable composition, even in the film, it is possible to maintain a state in which the dispersion stability of the pigment is high. As a result, in a case where a part of the formed film is removed by development or the like, it is presumed that generation of residue due to aggregation of the pigment is reduced.

In the composition including a pigment, a pigment derivative, a dispersant, and a solvent, depending on the type of the pigment derivative (for example, a pigment derivative having a coloring agent skeleton which absorbs up to the infrared region), moisture resistance of a film to be formed may be reduced.

Here, the "moisture resistance of a film is reduced" means that the transmittance of the film with light at a certain wavelength (for example, a wavelength of 700 nm to 1000 nm) is lower after a humidity test under high humidity than before the humidity test.

It is considered that the reason why the moisture resistance of the film is reduced is that the pigment derivatives associate in the film during the humidity test, thereby forming foreign matters.

The mechanism by which the foreign matters are formed is presumed as follows.

The pigment derivative in the related art has a structure in which an adsorbing group such as an acid group and a basic group is introduced into a coloring agent skeleton, and the adsorbing group is bonded to the terminal part of the molecular chain. Since such a pigment derivative includes a coloring agent skeleton having a $\pi$-conjugated system, the association is likely to occur, and in particular, as the absorption wavelength exists on the long-wave side, the $\pi$-conjugated system expands widely. Therefore, since a $\pi$-conjugated surface is formed, it is easy to develop high association. Since the adsorbing group induced in the pigment derivative exhibits hydrophilicity, water is coordinated with the hydrophilic adsorbing group during the humidity test, and the water-coordinated adsorbing group repels the hydrophobic $\pi$-conjugated surface. Therefore, it is presumed that the association between the $\pi$-conjugated surfaces is induced to form the foreign matters.

On the other hand, in the composition according to the embodiment of the present disclosure, the specific pigment derivative which has at least one group selected from the group consisting of groups represented by any one of Formula (1) to Formula (4) is used. In the specific pigment derivative, the group represented by Formula (1) to Formula (4) has a hydrophilic site but does not exist at the terminal part, so that a hydrophobic site such as an organic group is bonded to the terminal part adjacent to the hydrophilic site. In the specific pigment derivative having such a structure, it is considered that the coordination of water to the hydrophilic site is suppressed during the humidity test, the above-described association between the $\pi$-conjugated surfaces is not induced, and the foreign matters are less likely to be formed.

Therefore, according to the composition according to the embodiment of the present disclosure, it is presumed that the foreign matters derived from the specific pigment derivative are less likely to be formed in the film, and as a result, decrease in moisture resistance is suppressed.

Hereinafter, details of each component included in the composition according to the embodiment of the present disclosure will be described.

<Specific pigment derivative>

The composition according to the embodiment of the present disclosure includes a specific pigment derivative which has at least one group selected from the group consisting of groups represented by any one of Formula (1) to Formula (4).

The specific pigment derivative is a compound in which the above-described group is bonded to a coloring agent skeleton.

[Specific functional group]

First, the group represented by Formula (1) to Formula (4), included in the specific pigment derivative, will be described. Hereinafter, the group represented by Formula (1) to Formula (4) is also collectively referred to as a specific functional group.

From the viewpoint of enhancing dispersion stability of the pigment, the specific pigment derivative preferably has a group represented by Formula (2).

Formula (1): $-NH-R^1$

In Formula (1), $R^1$ is a substituent represented by $-COR^{11}$, $-SO_2R^{11}$, or $PO(R^{11})_2$, which has a total carbon number of 10 or less, and $R^{11}$'s each independently represent a hydrogen atom or a monovalent organic group having 1 or more carbon atoms.

In Formula (1), $R^1$ is preferably $-SO_2R^{11}$. Here, $R^{11}$ is preferably a monovalent organic group having 1 or more carbon atoms, and particularly preferably an organic group including a fluorine atom and having 1 or more carbon atoms. In a case where $R^1$ represents $-SO_2R^{11}$ and $R^{11}$ is an organic group including a fluorine atom and having 1 or more carbon atoms, since the group represented by Formula (1) is a strong acid, it is easy to improve dispersibility of the pigment, and since the coordination of water can be inhibited by the presence of fluorine atom, the formation of foreign matters can be suppressed and moisture resistance or the like of the film to be formed can be enhanced.

Specific examples of the group represented by Formula (1) include $-NH-SO_2CH_3$, $-NH-SO_2CF_3$, $-NH-SO_2C_2F_5$, $-NH-SO_2C_4F_9$, $-NH-SO_2CH_2CF_3$, and $-NH-SO_2CF_2CH_3$.

Formula (2): $-L-NH-R^2$

In Formula (2), L represents -CO-, $-SO_2-$, or $-PO(R^{21})-$, $R^{21}$ represents a hydrogen atom or a monovalent organic group having 1 or more carbon atoms, $R^2$ represents $-COR^{22}$, $-SO_2R^{22}$, or $-PO(R^{22})_2$, and $R^{22}$'s each independently represent a hydrogen atom or a monovalent organic group having 1 or more carbon atoms.

In Formula (2), L is preferably -CO-.

In Formula (2), $R^2$ is preferably $-SO_2R^{22}$. Here, $R^{22}$ is preferably a monovalent organic group having 1 or more carbon atoms, and particularly preferably an organic group including a fluorine atom and having 1 or more carbon atoms. In a case where $R^2$ represents $-SO_2R^{22}$ and $R^{22}$ is an organic group including a fluorine atom and having 1 or more carbon atoms, since the group represented by Formula (2) is a strong acid, it is easy to improve dispersibility of the

pigment, and since the coordination of water can be inhibited by the presence of fluorine atom, the formation of foreign matters can be suppressed and moisture resistance or the like of the film to be formed can be enhanced.

That is, from the viewpoint of enhancing dispersion stability of the pigment, in Formula (2), it is preferable that L represents -CO-, $R^2$ represents $-SO_2R^{22}$, and $R^{22}$ represents a monovalent organic group having 1 or more carbon atoms, and it is more preferable that L represents -CO-, $R^2$ represents $-SO_2R^{22}$, and $R^{22}$ represents a monovalent organic group including a fluorine atom and having 1 or more carbon atoms.

Examples of $R^{22}$ include an alkyl group having 1 to 10 carbon atoms and an alkyl fluoride group having 1 to 10 carbon atoms, and among these, an alkyl fluoride group having 1 to 8 carbon atoms is preferable and an alkyl fluoride group having 1 or 2 carbon atoms is particularly preferable.

The above-described alkyl group and alkyl fluoride group may have an ether bond.

The above-described alkyl group and alkyl fluoride group are preferably linear.

In addition, the above-described alkyl fluoride group is preferably a perfluoroalkyl group.

$R^{22}$ is particularly preferably a trifluoromethyl group.

Specific examples of the group represented by Formula (2) include $-CO-NH-SO_2CH_3$, $-CO-NH-SO_2CF_3$, $-CO-NH-SO_2C_2F_5$, $-CO-NH-SO_2C_4F_9$, $-CO-NH-SO_2CH_2CF_3$, and $-CO-NH-SO_2CF_2CH_3$.

Formula (3): $-N^+(R^3)_3\ X^-$

In Formula (3), $R^3$'s each independently represent a hydrogen atom or a monovalent organic group having 1 or more carbon atoms, at least one of three $R^4$'s is an alkyl group having 3 or more carbon atoms, and $X^-$ represents a counter anion.

In Formula (3), examples of the monovalent organic group represented by $R^3$ include an alkyl group, and a linear alkyl group is particularly preferable.

In Formula (3), it is preferable that two of three $R^3$'s are alkyl groups, and at least one of the two alkyl groups is an alkyl group having 3 or more carbon atoms.

In Formula (3), examples of the counter anion represented by $X^-$ include a halogen ion, a boron halide ion, and a phosphorus halogenated ion, and among these, a halogen ion (for example, $Cl^-$ and $I^-$), a boron halide ion (for example, $BF_4^-$), or a phosphorus halogenated ion (for example, $PF_6^-$) is preferable.

Specific examples of the group represented by Formula (3) include $-N^+H(CH_3)(C_3H_7)\ Cl^-$, $-N^+H(C_2H_5)(C_6H_{13})\ I^-$, $-N^+H(C_8H_{17})_2\ BF_4^-$, and $-N^+H(C_5H_{10})_2\ PF_6^-$.

Here, the alkyl group in the above-described specific examples may be linear or branched, each independently. For example, in a case where the alkyl group in the above-described specific examples is linear, dispersibility of the pigment tends to be improved, and in a case where the alkyl group in the above-described specific examples is branched, moisture resistance of the film to be formed tends to be excellent.

Formula (4): $-L-N^+(R^4)_3\ X^-$

In Formula (4), L represents -CO-, $-SO_2-$, or $-PO(R^{42})-$, $R^{42}$ represents a hydrogen atom or a monovalent organic group having 1 or more carbon atoms, $R^4$'s each independently represent a hydrogen atom or a monovalent organic group having 1 or more carbon atoms, at least one of three $R^5$'s is an alkyl group having 3 or more carbon atoms, and $X^-$ represents a counter anion.

In Formula (4), L is preferably -CO-.

In Formula (4), examples of the monovalent organic group represented by $R^4$ include an alkyl group, and a linear alkyl group is particularly preferable.

In Formula (4), it is preferable that two of three $R^4$'s are alkyl groups, and at least one of the two alkyl groups is an alkyl group having 3 or more carbon atoms.

In Formula (4), examples of the counter anion represented by $X^-$ include a halogen ion, a boron halide ion, and a phosphorus halogenated ion, and among these, a halogen ion (for example, $Cl^-$ and $I^-$), a boron halide ion (for example, $BF_4^-$), or a phosphorus halogenated ion (for example, $PF_6^-$) is preferable.

Specific examples of the group represented by Formula (4) include $-CO-N^+H(CH_3)(C_3H_7)\ Cl^-$, $-CO-N^+H(C_2H_5)(C_6H_{13})\ I^-$, $-CO-N^+H(C_8H_{17})_2\ BF_4^-$, and $-CO-N^+H(C_5H_{10})_2\ PF_6^-$.

Here, the alkyl group in the above-described specific examples may be linear or branched, each independently. For example, in a case where the alkyl group in the above-described specific examples is linear, dispersibility of the pigment tends to be improved, and in a case where the alkyl group in the above-described specific examples is branched, moisture resistance of the film to be formed tends to be excellent.

[Coloring agent skeleton]

Examples of a coloring agent skeleton to which the above-described specific functional group is bonded include the following.

That is, as the coloring agent skeleton included in the specific pigment derivative, coloring agent skeletons derived from a coloring agent compound having absorption in the infrared region are preferable, and among these, a coloring agent skeleton derived from a coloring agent compound having absorption in the near infrared region is more preferable.

In particular, it is preferable that the coloring agent skeleton in the specific pigment derivative and the coloring agent skeleton of the pigment have the same coloring agent skeleton.

Specific examples of the coloring agent skeleton include a squarylium coloring agent skeleton, a croconium coloring agent skeleton, a pyrrolopyrrole coloring agent skeleton, a diketo pyrrolopyrrole coloring agent skeleton, a quinacridone coloring agent skeleton, an anthraquinone coloring agent skeleton, a dianthraquinone coloring agent skeleton, a benzoisoindole coloring agent skeleton, a thiazine indigo coloring agent skeleton, an azo coloring agent skeleton, a quinophthalone coloring agent skeleton, a phthalocyanine coloring agent skeleton, a naphthalocyanine coloring agent skeleton, a dioxazine coloring agent skeleton, a perylene coloring agent skeleton, a perinone coloring agent skeleton, a benzimidazolone coloring agent skeleton, a benzothiazole coloring agent skeleton, a benzimidazole coloring agent skeleton, and a benzoxazole coloring agent skeleton.

Among these, the coloring agent skeleton included in the specific pigment derivative is preferably a pyrrolopyrrole coloring agent skeleton, a phthalocyanine coloring agent skeleton, a squarylium coloring agent skeleton, or a croconium coloring agent skeleton, and from the viewpoint of production suitability, a squarylium coloring agent skeleton or a croconium coloring agent skeleton is particularly preferable.

Examples of the specific pigment derivative include a compound represented by Formula (B1).

$$P\left(L-(X)_n\right)_m \qquad (B1)$$

In Formula (B1), P represents a coloring agent skeleton, L represents a single bond or a linking group, X represents the specific functional group (that is, the group represented by any one of Formula (1), Formula (2), Formula (3), or Formula (4)), m represents an integer of 1 or more, n represents an integer of 1 or more, in a case where m represents 2 or more, a plurality of L's and a plurality of X's may be different from each other, and in a case where n represents 2 or more, a plurality of X's may be different from each other.

The coloring agent skeleton represented by P corresponds to the above-described coloring agent skeleton, and is preferably at least one selected from a squarylium coloring agent skeleton, a croconium coloring agent skeleton a pyrrolopyrrole coloring agent skeleton, a diketo pyrrolopyrrole coloring agent skeleton, a quinacridone coloring agent skeleton, an anthraquinone coloring agent skeleton, a dianthraquinone coloring agent skeleton, a benzoisoindole coloring agent skeleton, a thiazine indigo coloring agent skeleton, an azo coloring agent skeleton, a quinophthalone coloring agent skeleton, a phthalocyanine coloring agent skeleton, a naphthalocyanine coloring agent skeleton, a dioxazine coloring agent skeleton, a perylene coloring agent skeleton, a perinone coloring agent skeleton, a benzimidazolone coloring agent skeleton, a benzothiazole coloring agent skeleton, a benzimidazole coloring agent skeleton, and a benzoxazole coloring agent skeleton. Among these, a pyrrolopyrrole coloring agent skeleton, a diketo pyrrolopyrrole coloring agent skeleton, a phthalocyanine coloring agent skeleton, a squarylium coloring agent skeleton, or a croconium coloring agent skeleton is preferable, and from the viewpoint of production suitability, a squarylium coloring agent skeleton or a croconium coloring agent skeleton is particularly preferable.

The linking group represented by L is preferably a group composed of 1 to 100 carbon atoms, 0 to 10 nitrogen atoms, 0 to 50 oxygen atoms, 1 to 200 hydrogen atoms, and 0 to 20 sulfur atoms, and among these, a group including an ether bond and an alkylene group is preferable.

The linking group represented by L may be unsubstituted or may further have a substituent.

Examples of the substituent include the following substituent T.

-Substituent T-

Examples of the substituent T include a halogen atom, a cyano group, a nitro group, an alkyl group, an alkenyl group, an alkynyl group, an aryl group, a heteroaryl group, $-ORt^1$, $-CORt^1$, $-COORt^1$, $-OCORt^1$, $-NRt^1Rt^2$, $-NHCORt^1$, $-CONRt^1Rt^2$, $-NHCONRt^1Rt^2$, $-NHCOORt^1$, $-SRt^1$, $-SO_2Rt^1$, $-SO_2ORt^1$, $-NHSO_2Rt^1$, and $-SO_2NRt^1Rt^2$. $Rt^1$ and $Rt^2$ each independently represent a hydrogen atom, an alkyl group, an alkenyl group, an alkynyl group, an aryl group, or a

heteroaryl group. $Rt^1$ and $Rt^2$ may be bonded to each other to form a ring.

As the specific functional group represented by X, the group represented by Formula (2) is particularly preferable.

The specific pigment derivative is preferably a compound having a maximal absorption wavelength in a wavelength range of 700 nm to 1,200 nm, preferably a compound having a maximal absorption wavelength in a wavelength range of 700 nm to 1,100 nm, and preferably a compound having a maximal absorption wavelength in a wavelength range of 700 nm to 1,000 nm.

In a pigment derivative having a maximal absorption wavelength in the above-described wavelength range, a spread of π-conjugated plane can be easily brought close to the pigment, adsorptivity to the pigment is improved, and more excellent dispersion stability can be easily obtained.

In addition, the specific pigment derivative is also preferably a compound including an aromatic ring, and more preferably a compound including a structure in which two or more aromatic rings are condensed.

Further, the specific pigment derivative is also preferably a compound having a π-conjugated plane, and more preferably a compound having a π-conjugated plane having the same structure as the π-conjugated plane included in the pigment. Here, the number of π electrons included in the π-conjugated plane of the specific pigment derivative is preferably 8 to 100. The upper limit is preferably 90 or less and more preferably 80 or less. The lower limit of the number of π electrons is preferably 10 or more and more preferably 12 or more.

In addition, it is preferable that the specific pigment derivative is a compound having a π-conjugated plane including a partial structure represented by Formula (SQ) or Formula (CR) (that is, a squarylium coloring agent skeleton or a croconium coloring agent skeleton).

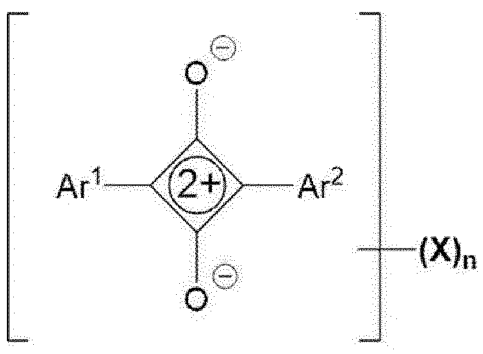

(SQ)

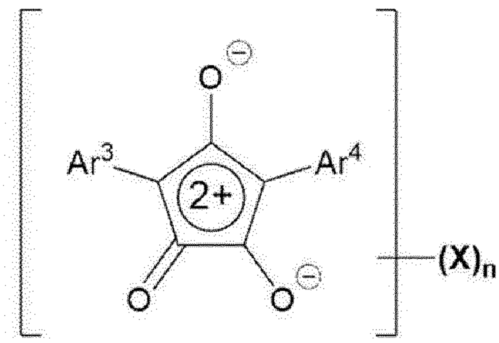

(CR)

In Formula (SQ), $A^1$ and $A^2$ each independently represent an aromatic ring group, and X represents the specific functional group and is bonded to at least one of $A^1$ or $A^2$. n represents an integer of 1 to 4.

In Formula (CR), $A^3$ and $A^4$ each independently represent an aromatic ring group, and X represents the specific functional group and is bonded to at least one of $A^3$ or $A^4$. n represents an integer of 1 to 4.

Here, the aromatic ring group represented by $A^1$, $A^2$, $A^3$, and $A^4$ includes an aryl group and a heteroaryl group.

In Formulae (SQ) and (CR), an aromatic ring constituting the aromatic ring group represented by $A^1$, $A^2$, $A^3$, and $A^4$ may be a monocyclic ring or a fused ring.

Specific examples of the aromatic ring include a benzene ring, a naphthalene ring, a pentalene ring, an indene ring, an azulene ring, a heptalene ring, an indacene ring, a perylene ring, a pentacene ring, an acenaphthene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indridine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring, and a benzene ring or a naphthalene ring is preferable.

These aromatic rings may be unsubstituted or may have a substituent. Here, examples of the substituent include the above-described substituent T.

In a case where a plurality of substituents T are introduced into the aromatic ring, the plurality of substituents T may be bonded to each other to form a ring.

In Formula (SQ), as $A^1$ and $A^2$, a group represented by Formula (R1) is particularly preferable.

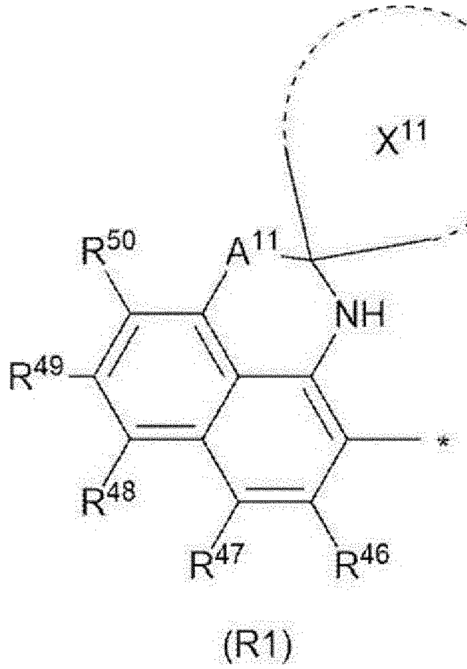

(R1)

In Formula (R1), $X^{11}$ represents a ring structure, $A^{11}$ represents -O- or $-NR^{51}-$, $R^{46}$ to $R^{51}$ each independently represent a hydrogen atom or a substituent, $R^{47}$ and $R^{48}$ may be bonded to each other to form a ring, and * represents a bonding site.

In Formula (R1), the ring structure represented by $X^{11}$ may be a monocyclic ring or a fused ring. The specific functional group represented by X is bonded to the ring structure represented by $X^{11}$.

In Formula (R1), $A^{11}$ is preferably $-NR^{51}-$.

As shown below, cations in Formula (SQ) and Formula (CR) are present without being localized. Examples shown below indicate the same squarylium coloring agent skeleton or croconium coloring agent skeleton, except that notation positions of the resonance structures of cations and anions are different.

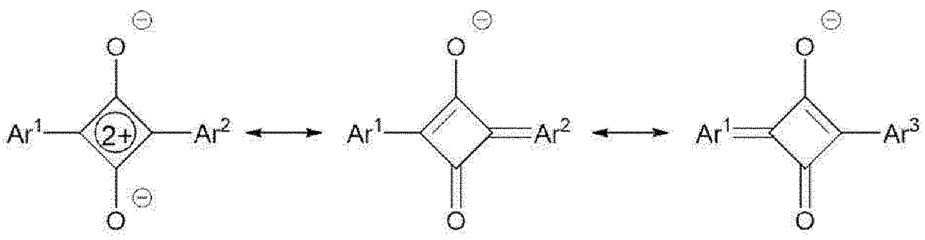

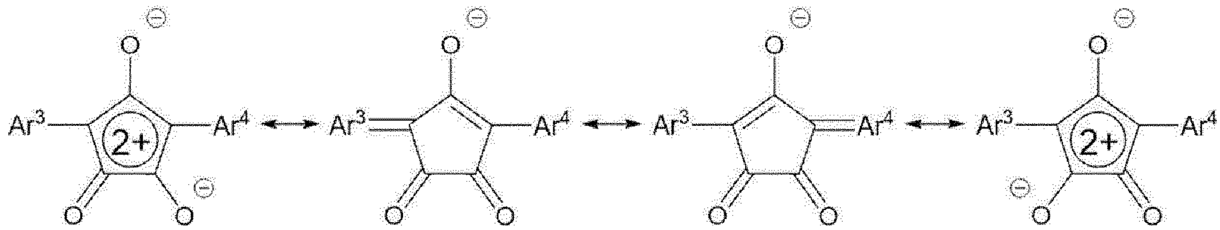

Specific examples of the specific pigment derivative include compounds having the following structures.

In the following specific examples, "CuPc" represents phthalocyanine copper (II). In addition, in the following specific examples, Me represents a methyl group and Ph represents a phenyl group.

In addition, as the specific pigment derivative, compounds having the specific functional group among specific examples of compound A described in paragraph 0067 of WO2018/230387A can also be used, the contents of which are incorporated herein by reference.

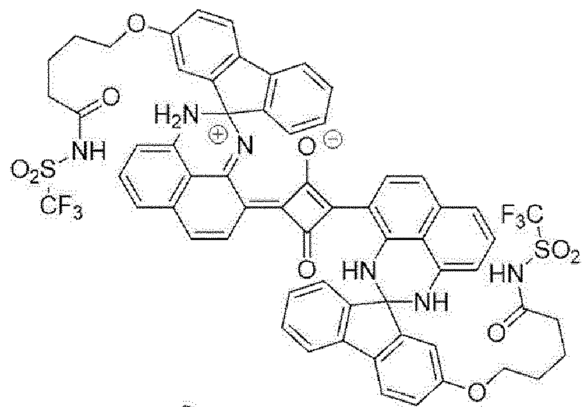

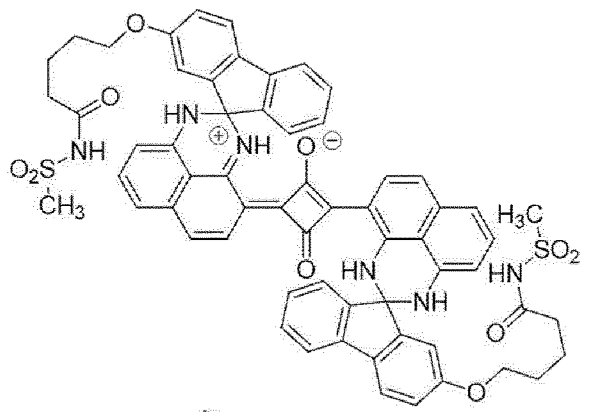

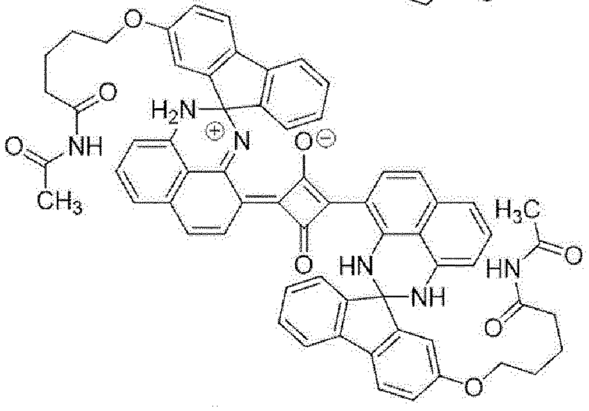

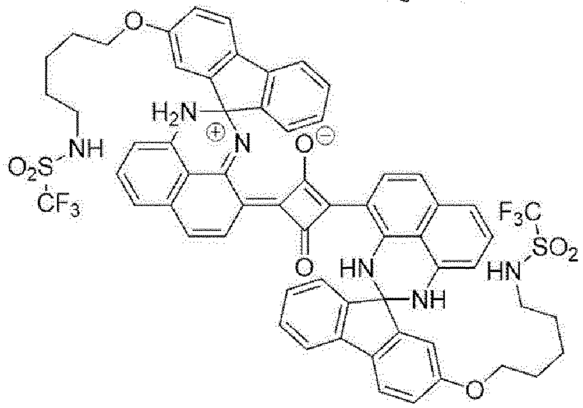

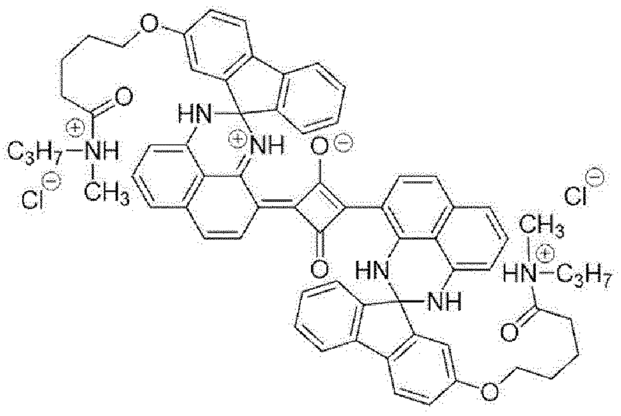

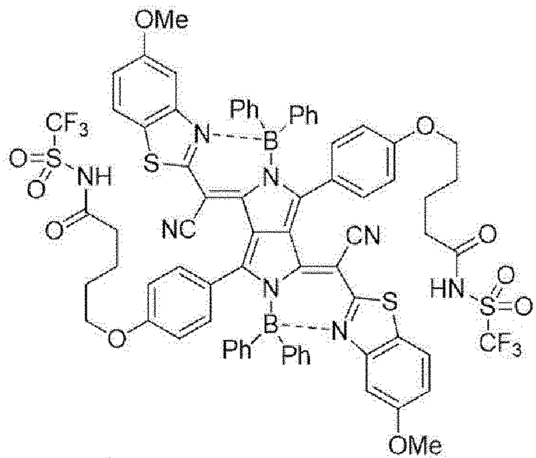

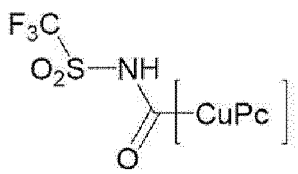

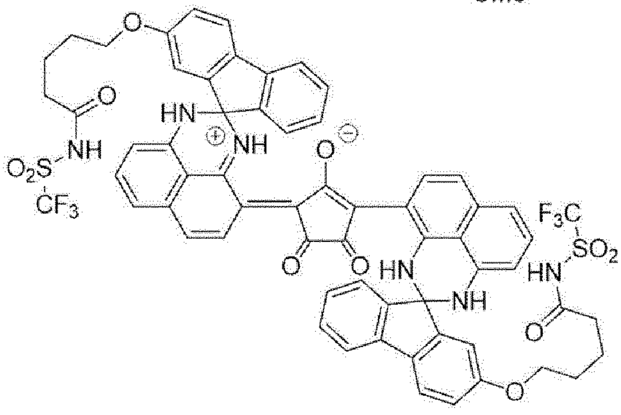

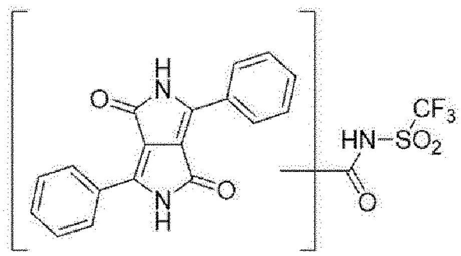

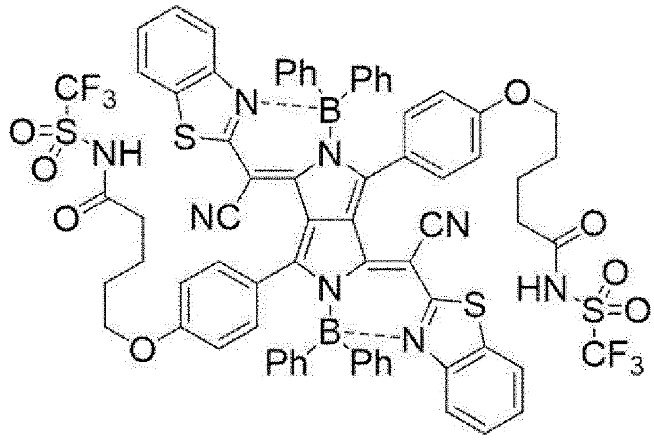

A method for synthesizing the specific pigment derivative is not particularly limited, and for example, the same method as the synthesis example described in paragraphs 0281 to 0292 of WO2018/230387A can be used.

In the composition according to the embodiment of the present disclosure, the specific pigment derivative may be used singly or in combination of two or more kinds thereof.

The content of the specific pigment derivative in the composition according to the embodiment of the present disclosure is preferably 1 mass% to 30 mass%, more preferably 5 mass% to 30 mass%, and still more preferably 10 mass% to 30 mass% with respect to the total amount of all pigments.

<Pigment>

The composition according to the embodiment of the present disclosure includes a pigment.

Examples of the pigment include a white pigment, a black pigment, a chromatic pigment, and a near-infrared absorbing pigment.

In the present disclosure, it is one of the preferred examples that the pigment is an infrared absorbing pigment having absorption in the infrared region. Among these, it is one of the more preferred examples that the pigment is a near-infrared absorbing pigment having absorption in the near infrared region.

In the present disclosure, the "near infrared region" refers to a region in a wavelength of more than 700 nm to 2,500 nm or less, and the "near infrared ray" refers to an infrared ray having a wavelength of more than 700 nm and 2,500 nm or less.

In the present disclosure, a pigment means a coloring agent which is not dissolved in a solvent. Here, the "not dissolved in a solvent" refers to that the solubility of a target substance in 100 mg of the solvent at 25°C is 0.1 g or less. Here, examples of the solvent include propylene glycol monomethyl ether acetate and water, a coloring agent having the above-described solubility in any solvent is the pigment.

It is preferable that a coloring agent skeleton in the pigment and the coloring agent skeleton of the specific pigment derivative have the same coloring agent skeleton.

In a case where the pigment in the present disclosure is the near-infrared absorbing pigment, it is preferable that the pigment has a maximal absorption wavelength in a wavelength range of more than 700 nm and 1800 nm or less. In addition, in the near-infrared absorbing pigment, a ratio $A^1/A^2$, which is a ratio of an absorbance $A^1$ at a wavelength of 500 nm to an absorbance $A^2$ at the maximal absorption wavelength, is preferably 0.08 or less and more preferably 0.04 or less.

Examples of the near-infrared absorbing pigment include a squarylium compound, a croconium compound, a pyrrolopyrrole compound, a phthalocyanine compound, a cyanine compound, a naphthalocyanine compound, a quaterrylene compound, a merocyanine compound, an oxonol compound, an iminium compound, a dithiol compound, a triarylmethane compound, a pyrromethene compound, an azomethine compound, an anthraquinone compound, a dibenzofuranone compound, a metal oxide, and a metal boride.

Among these, as the near-infrared absorbing pigment, a squarylium compound, a croconium compound, a pyrrolopyrrole compound, or a phthalocyanine compound is preferable, and from the viewpoint of production suitability, a squarylium compound or a croconium compound is particularly preferable.

[Squarylium compound]

The squarylium compound is not particularly limited as long as it is a compound corresponding to a pigment

having a squarylium coloring agent skeleton, and preferred examples thereof include compounds obtained by removing the specific functional group represented by X from the compound represented by Formula (SQ) in the specific pigment derivative.

Specific examples of the squarylium compound include the following compounds.

In addition, examples of the squarylium compound include compounds described in paragraphs 0044 to 0049 of JP2011-208101A, compounds described in paragraphs 0060 and 0061 of JP6065169B, compounds described in paragraph 0040 of WO2016/181987A, compounds described in WO2013/133099A, compounds described in WO2014/088063A, compounds described in JP2014-126642A, compounds described in JP2016-146619A, compounds described in JP2015-176046A, compounds described in JP2017-25311A, compounds described in WO2016/154782A, compounds described in JP5884953B, compounds described in JP6036689B, compounds described in JP5810604B, and compounds described in JP2017-068120A, the contents of which are incorporated herein by reference.

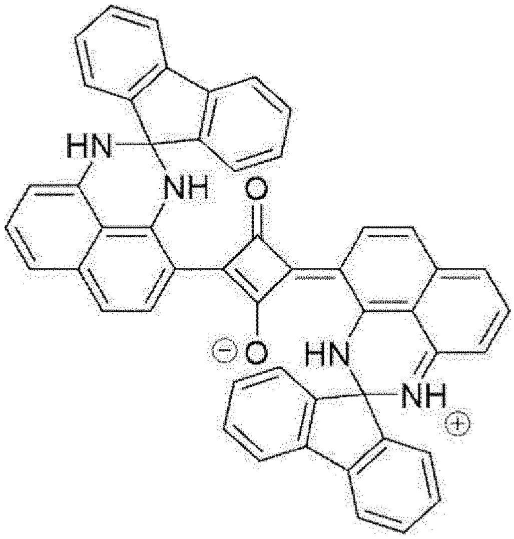

[Croconium compound]

The croconium compound is not particularly limited as long as it is a compound corresponding to a pigment having a croconium coloring agent skeleton, and preferred examples thereof include compounds obtained by removing the specific functional group represented by X from the compound represented by Formula (CR) in the specific pigment derivative.

Specific examples of the croconium compound include the following compounds.

In addition, examples of the croconium compound include compounds described in paragraph 0049 of JP2007-271745A, JP2007-31644A, JP2007-169315A, and the like, the contents of which are incorporated herein by reference.

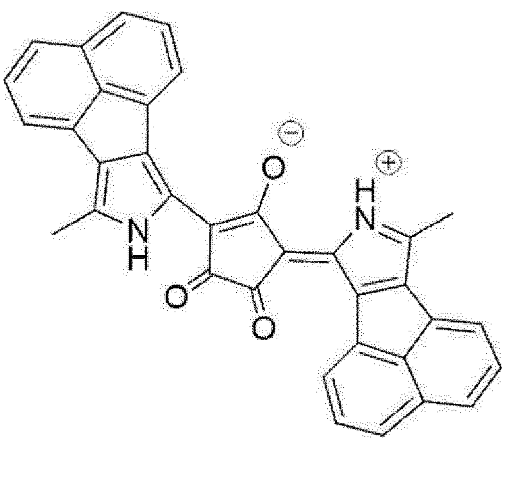

[Pyrrolopyrrole compound]

The pyrrolopyrrole compound is not particularly limited as long as it is a compound corresponding to a pigment having a pyrrolopyrrole coloring agent skeleton.

As the pyrrolopyrrole compound, a compound represented by Formula (PP) is preferable.

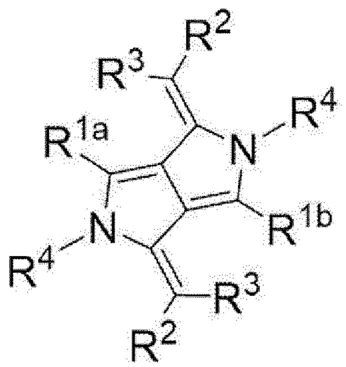

(PP)

In Formula (PP), $R^{1a}$ and $R^{1b}$ each independently represent an alkyl group, an aryl group, or a heteroaryl group, $R^2$ and $R^3$ each independently represent a hydrogen atom or a substituent, $R^2$ and $R^3$ may be bonded to each other to form a ring, $R^4$'s each independently represent a hydrogen atom, an alkyl group, an aryl group, a heteroaryl group, $-BR^{4A}R^{4B}$, or a metal atom, $R^4$ may be covalently or coordinately bonded to at least one selected from $R^{1a}$, $R^{1b}$, or $R^3$, and $R^{4A}$ and $R^{4B}$ each independently represent a substituent.

With regard to details of Formula (PP), reference can be made to the description in paragraphs 0016 to 0047 of JP2009-263614A, paragraphs 0011 to 0036 of JP2011-68731A, paragraphs 0010 to 0024 of WO2015/166873A, and paragraphs 0025 to 0051 of WO2017/146092A, the contents of which are incorporated herein by reference.

In Formula (PP), $R^{1a}$ and $R^{1b}$ are each independently preferably an aryl group or a heteroaryl group, and more preferably an aryl group. In addition, the alkyl group, aryl group, and heteroaryl group represented by $R^{1a}$ and $R^{1b}$ may have a substituent or may be unsubstituted.

Examples of the substituent include the above-described substituent T.

In Formula (PP), $R^2$ and $R^3$ each independently represent a hydrogen atom or a substituent. Examples of the substituent include the above-described substituent T. At least one of $R^2$ or $R^3$ is preferably an electron withdrawing group, more preferably a cyano group, a carboxy group, an acyl group, an alkoxycarbonyl group, an aryloxycarbonyl group, a carbamoyl group, an alkylcarbonyl group, an arylcarbonyl group, an alkylsulfonyl group, or an arylsulfonyl group, and still more preferably a cyano group.

In Formula (PP), it is preferable that $R^2$ represents an electron withdrawing group (preferably, a cyano group) and $R^3$ represents a heteroaryl group. It is preferable that the heteroaryl group is a 5-membered ring or a 6-membered ring. In addition, the heteroaryl group is preferably a monocyclic ring or a fused ring, preferably a monocyclic ring or a fused ring composed of 2 to 8 rings, and more preferably a monocyclic ring or a fused ring composed of 2 to 4 rings. The number of heteroatoms constituting the heteroaryl group is preferably 1 to 3 and more preferably 1 or 2. Examples of the heteroatom include a nitrogen atom, an oxygen atom, and a sulfur atom. It is preferable that the heteroaryl group has one or more nitrogen atoms. Two $R^2$'s in Formula (PP) may be the same or different from each other. In addition, two $R^3$'s in Formula (PP) may be the same or different from each other.

In Formula (PP), $R^4$ is preferably a hydrogen atom, an alkyl group, an aryl group, a heteroaryl group, or a group represented by $-BR^{4A}R^{4B}$, more preferably a hydrogen atom, an alkyl group, an aryl group, or a group represented by $-BR^{4A}R^{4B}$, and still more preferably a group represented by $-BR^{4A}R^{4B}$. As the substituent represented by $R^{4A}$ and $R^{4B}$, a halogen atom, an alkyl group, an alkoxy group, an aryl group, or a heteroaryl group is preferable, an alkyl group, an aryl group, or a heteroaryl group is more preferable, and an aryl group is particularly preferable. These groups may further have a substituent. Two $R^4$'s in Formula (PP) may be the same or different from each other. $R^{4A}$ and $R^{4B}$ may be bonded to each other to form a ring.

Specific examples of the compound represented by Formula (PP) include the following compounds.

In the following structural formulae, Me represents a methyl group and Ph represents a phenyl group. In addition, examples of the pyrrolopyrrole compound include compounds described in paragraphs 0048 to 0058 of JP2009-263614A, compounds described in paragraphs 0037 to 0052 of JP2011-68731A, and compounds described in paragraphs 0052 and 0053 of WO2017/146092A, the contents of which are incorporated herein by reference.

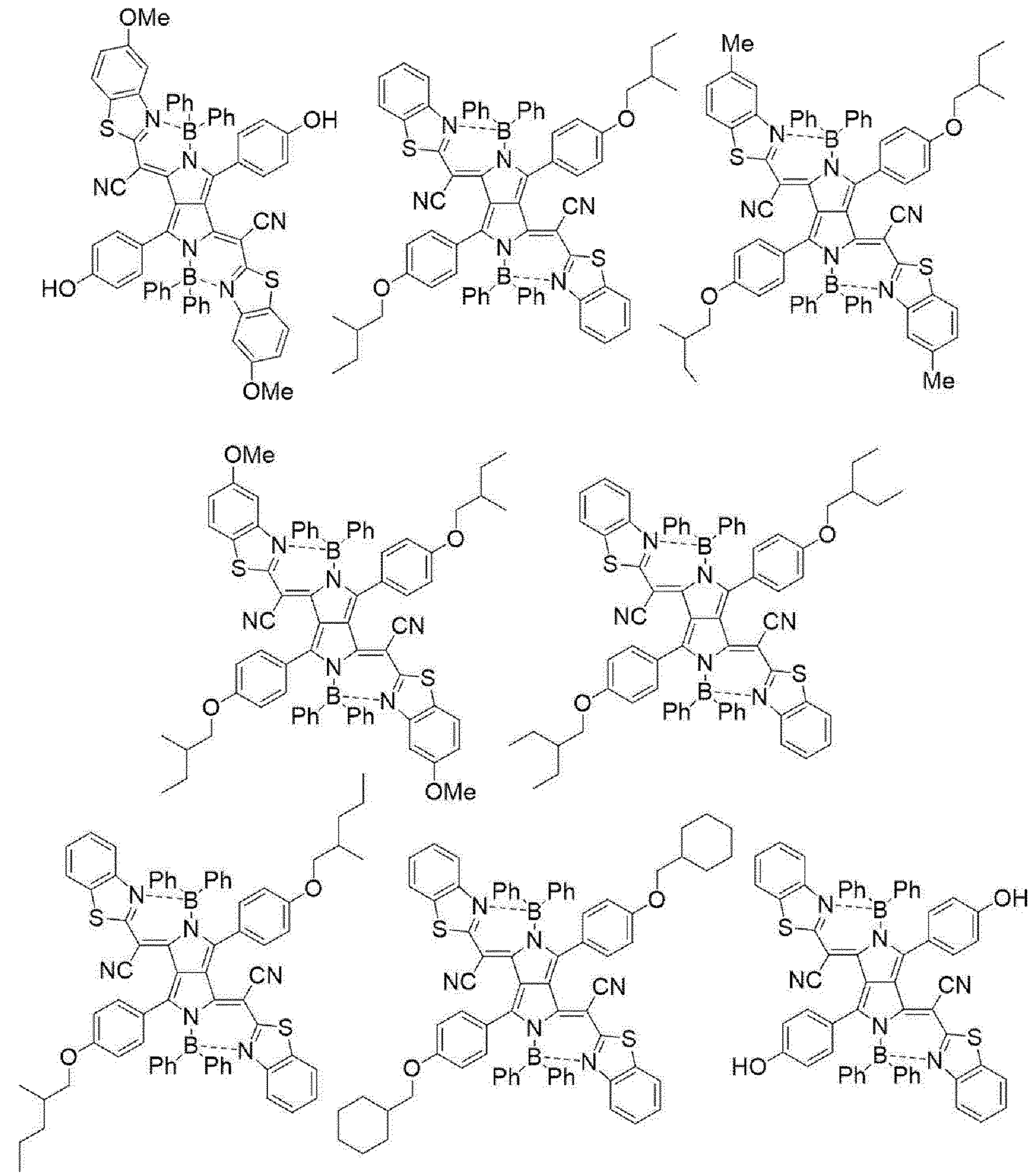

In addition, the pigment in the present disclosure may be a white pigment, a black pigment, or a chromatic pigment, and it is preferable to include a chromatic pigment as a part or all of the pigment.

In the present disclosure, the white pigment includes not only a pure white pigment but also a bright gray (for example, grayish-white, light gray, and the like) pigment close to white. In addition, as the pigment, an organic pigment is preferable.

As the chromatic pigment, for example, a pigment having a maximal absorption wavelength in a wavelength range of 400 nm to 700 nm is more preferable.

Examples of the chromatic pigment include a red pigment, a green pigment, a blue pigment, a yellow pigment, a violet pigment, and an orange pigment.

Specific examples of the chromatic pigment include Color Index (C. I.) Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170,

171, 172, 173, 174, 175, 176, 177, 179, 180, 181, 182, 185, 187, 188, 193, 194, 199, 213, 214, 215, 228 (directly connected quinophthalone dimer described in WO2013/098836A), 231, 232 (methine-based), 233 (quinoline-based), and the like (all of which are yellow pigments);

C. I. Pigment Orange 2, 5, 13, 16, 17:1, 31, 34, 36, 38, 43, 46, 48, 49, 51, 52, 55, 59, 60, 61, 62, 64, 71, and 73 (all of which are orange pigments);
C. I. Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 270, 272, 279, 294 (xanthene-based, Organo Ultramarine, Bluish Red), 295 (monoazo-based), 296 (diazo-based), and the like (all of which are red pigments);
C. I. Pigment Green 7, 10, 36, 37, 58, 59, 62, and 63 (all of which are green pigments);
C. I. Pigment Violet 1, 19, 23, 27, 32, 37, 42, 60 (triarylmethane-based), 61 (xanthene-based), and the like (all of which are violet pigments); and
C. I. Pigment Blue 1, 2, 15, 15:1, 15:2, 15:3, 15:4, 15:6, 16, 22, 29, 60, 64, 66, 79, 80, 87 (monoazo-based), 88 (methine-based), and the like (all of which are blue pigments).

In addition, a halogenated zinc phthalocyanine pigment having an average number of halogen atoms in one molecule of 10 to 14, an average number of bromine atoms in one molecule of 8 to 12, and an average number of chlorine atoms in one molecule of 2 to 5 can also be used as the green pigment. Specific examples thereof include the compounds described in WO2015/118720A. In addition, as the green pigment, compounds described in CN2010-6909027A, phthalocyanine compounds described in WO2012/102395A, which have a phosphoric acid ester as a ligand, or the like can also be used.

In addition, as the green pigment, green pigments described in JP2018-180023A may be used.

In addition, an aluminum phthalocyanine compound having a phosphorus atom can also be used as the blue pigment. Specific examples thereof include the compounds described in paragraphs 0022 to 0030 of JP2012-247591A and paragraph 0047 of JP2011-157478A.

In addition, as the yellow pigment, quinophthalone pigments described in JP2018-203798A, JP2018-62578A, JP6432077B, JP6432076B, JP2018-155881A, JP2018-111757A, JP2018-40835A, JP2017-197640A, JP2016-145282A, JP2014-85565A, JP2014-21139A, JP2013-209614A, JP2013-209435A, JP2013-181015A, JP2013-61622A, JP2013-54339A, JP2013-32486A, JP2012-226110A, JP2008-74987A, JP2008-81565A, JP2008-74986A, JP2008-74985A, JP2008-50420A, JP2008-31281A, or JP1973-32765B (JP-S48-32765B) can also be suitably used.
In addition, pigments described in JP6443711B can also be used.

In addition, as the yellow pigment, the quinophthalone compounds described in paragraphs 0011 to 0034 of JP2013-54339A, the quinophthalone compounds described in paragraphs 0013 to 0058 of JP2014-26228A, yellow pigments described in JP2019-8014A, or the like can be used.

In addition, as the yellow pigment, compounds described in JP2018-062644A can also be used. This compound can also be used as a pigment derivative other than the specific pigment derivative.

Further, as described in JP2018-155881A, C. I. Pigment Yellow 129 may be added.

As the red pigment, diketopyrrolopyrrole compounds described in JP2017-201384A, in which the structure has at least one substituted bromine atom, diketopyrrolopyrrole compounds described in paragraphs 0016 to 0022 of JP6248838B, diketopyrrolopyrrole compounds described in WO2012/102399A, diketopyrrolopyrrole compounds described in WO2012/117965A, naphtholazo compounds described in JP2012-229344, and the like can also be used. In addition, as the red pigment, a compound having a structure that an aromatic ring group in which a group bonded with an oxygen atom, a sulfur atom, or a nitrogen atom is introduced to an aromatic ring is bonded to a diketopyrrolopyrrole skeleton can be used.

Examples of the white pigment include titanium oxide, strontium titanate, barium titanate, zinc oxide, magnesium oxide, zirconium oxide, aluminum oxide, barium sulfate, silica, talc, mica, aluminum hydroxide, calcium silicate, aluminum silicate, hollow resin particles, and zinc sulfide. The white pigment is preferably particles having a titanium atom, more preferably titanium oxide. In addition, the white pigment is preferably a particle having a refractive index of 2.10 or more with respect to light having a wavelength of 589 nm. The above-mentioned refractive index is preferably 2.10 to 3.00 and more preferably 2.50 to 2.75.

In addition, as the white pigment, the titanium oxide described in "Titanium Oxide-Physical Properties and Applied Technology, written by Manabu Kiyono, pages 13 to 45, published in June. 25, 1991, published by Shuppan Co., Ltd." can also be used.

The white pigment is not limited to a compound formed of a single inorganic substance, and may be particles combined with other materials. For example, it is preferable to use a particle having a pore or other materials therein, a

particle having a number of inorganic particles attached to a core particle, or a core-shell composite particle composed of a core particle formed of polymer particles and a shell layer formed of inorganic fine nanoparticles. With regard to the core-shell composite particle composed of a core particle formed of polymer particles and a shell layer formed of inorganic fine nanoparticles, reference can be made to, for example, the descriptions in paragraphs 0012 to 0042 of JP2015-047520A, the contents of which are incorporated herein by reference.

As the white pigment, hollow inorganic particles can also be used. The hollow inorganic particles refer to inorganic particles having a structure with a cavity therein, and the cavity is enclosed by an outer shell. As the hollow inorganic particles, hollow inorganic particles described in JP2011-075786A, WO2013/061621A, JP2015-164881A, and the like can be used, the contents of which are incorporated herein by reference.

The black pigment is not particularly limited, and a known black pigment can be used.

Examples of the black pigment include carbon black, titanium black, and graphite, and carbon black or titanium black is preferable and titanium black is more preferable. The titanium black is black particles containing a titanium atom, and is preferably lower titanium oxide or titanium oxynitride. The surface of the titanium black can be modified, as necessary, according to the purpose of improving dispersibility, suppressing aggregating properties, and the like. For example, the surface of the titanium black can be coated with silicon oxide, titanium oxide, germanium oxide, aluminum oxide, magnesium oxide, or zirconium oxide.

In addition, a treatment with a water-repellent substance as described in JP2007-302836A can be performed. Examples of the black pigment include Color Index (C. I.) Pigment Black 1 and 7.

It is preferable that the titanium black has a small primary particle diameter of the individual particles and has a small average primary particle diameter. Specifically, the average primary particle diameter thereof is preferably 10 nm to 45 nm. The titanium black can be used as a dispersion. Examples thereof include a dispersion which includes titanium black particles and silica particles and in which the content ratio of Si atoms to Ti atoms is adjusted to a range of 0.20 to 0.50. With regard to the dispersion, reference can be made to the description in paragraphs 0020 to 0105 of JP2012-169556A, the contents of which are incorporated herein by reference. Examples of a commercially available product of the titanium black include Titanium black 10S, 12S, 13R, 13M, 13M-C, 13R-N, 13M-T (trade name; manufactured by Mitsubishi Materials Corporation) and Tilack D (trade name; manufactured by Akokasei Co., Ltd.).

The average primary particle diameter of the pigment in the present disclosure is preferably 1 nm to 200 nm, more preferably 5 nm to 180 nm, still more preferably 10 nm to 150 nm, and particularly preferably 10 nm to 100 nm.

The primary particle diameter of the pigment can be determined from an image obtained by observing primary particles of the pigment using a transmission electron microscope. Specifically, a projected area of the primary particles of the pigment is determined, and the corresponding equivalent circle diameter is calculated as the primary particle diameter of the pigment. In addition, the average primary particle diameter in the present disclosure is the arithmetic average value of the primary particle diameters with respect to 400 primary particles of the pigment. In addition, the primary particle of the pigment refers to a particle which is independent without aggregation.

The composition according to the embodiment of the present disclosure may include only one kind of pigment or two or more kinds thereof.

The content of the pigment in the composition according to the embodiment of the present disclosure may be appropriately determined according to the purpose of use, application, and the like of the composition according to the embodiment of the present disclosure.

For example, from the viewpoint of expressing functions required for the pigment, the content of the pigment is preferably 5 mass% to 80 mass% and more preferably 10 mass% to 70 mass% with respect to the total solid content of the composition.

<Specific dispersant>

The composition according to the embodiment of the present disclosure includes a specific dispersant which has a constitutional unit having an adsorbing group and a constitutional unit having a steric repulsive group, and is a random copolymer or an alternating copolymer.

In particular, the specific dispersant is preferably a random copolymer.

Here, examples of the adsorbing group include an acid group, a basic group, a group including a heterocyclic ring, and a group including a coloring agent skeleton, and from the viewpoint of large interaction and good dispersion, an acid group or a basic group is preferable and a basic group is particularly preferable.

In addition, it is sufficient that the steric repulsive group is a group having a large steric hindrance, and for example, a polyester resin structure, an acrylic resin structure, a polyalkylene glycol structure, or the like is preferable and a polyester resin structure is still more preferable.

The above-described polyester resin structure is not particularly limited, but a linear polyester resin structure is preferable, and a polycaprolactone structure or a polyvalerolactone structure is more preferable.

The steric repulsive group is preferably a group having a total carbon number of 20 or more, more preferably

a group having a total carbon number of 30 or more, still more preferably a group having a total carbon number of 50 or more, and particularly preferably a group having a total carbon number of 50 to 200.

A multipoint adsorption-type dispersant in which a constitutional unit having an adsorbing group and a constitutional unit having a steric repulsive group are separated and a surface adsorption-type dispersant having a planar adsorbing group such as an oligoimine derivative are not included in the specific dispersant.

In the specific dispersant, the content of the constitutional unit having an adsorbing group is preferably 5 mol% to 95 mol%, more preferably 10 mol% to 90 mol%, and still more preferably 15 mol% to 85 mol% with respect to the total mass of the specific dispersant.

In the specific dispersant, the content of the constitutional unit having a steric repulsive group is preferably 5 mol% to 95 mol%, more preferably 10 mol% to 90 mol%, and still more preferably 15 mol% to 85 mol% with respect to the total mass of the specific dispersant.

As described above, the specific dispersant preferably has a basic group as the adsorbing group.

As the basic group, a group including a nitrogen atom is preferable, and more specifically, a primary amino group, a secondary amino group, a tertiary amino group, a quaternary ammonium salt group, or the like is more preferable.

As the specific dispersant having a basic group, for example, a random copolymer or an alternating copolymer, which has a tertiary amino group as the basic group, is preferable. That is, as the specific dispersant having a basic group, a random copolymer or an alternating copolymer, which has at least a constitutional unit having a tertiary amino group or a constitutional unit having a steric repulsive group, is preferable.

In addition, the specific dispersant having a basic group may have a quaternary ammonium salt group as the basic group in addition to the tertiary amino group.

Examples of a monomer for obtaining the above-described constitutional unit having a tertiary amino group (that is, a monomer having a tertiary amino group) include an ethylenically unsaturated compound having a tertiary amino group, and specific examples thereof include dimethylaminoethyl (meth)acrylate, diethylaminoethyl (meth)acrylate, dimethylaminopropyl (meth)acrylate, diethylaminopropyl (meth)acrylate, and dimethylaminopropyl (meth)acrylamide.

Examples of a monomer for obtaining the above-described constitutional unit having a quaternary ammonium salt group (that is, a monomer having a quaternary ammonium salt group) include an ethylenically unsaturated compound having a quaternary ammonium salt group, and specific examples thereof include (meth)acryloylaminopropyl trimethylammonium chloride, (meth)acryloyloxyethyl trimethylammonium chloride, (meth)acryloyloxyethyl triethylammonium chloride, (meth)acryloyloxyethyl (4-benzoylbenzyl)dimethylammonium bromide, (meth)acryloyloxyethylbenzyldimethylammonium chloride, and (meth)acryloyloxyethylbenzyldiethylammonium chloride.

Examples of the ethylenically unsaturated compound having a tertiary amino group and the ethylenically unsaturated compound having a quaternary ammonium salt group include compounds described in paragraphs 0150 to 0170 of WO2018/230486A, the contents of which are incorporated herein by reference.

The constitutional unit having a steric repulsive group may be a constitutional unit introduced by using a monomer having a steric repulsive group (so-called macromonomer), or may be a constitutional unit introduced by bonding a steric repulsive group to a constitutional unit which is obtained by using a monomer having no steric repulsive group by a polymer reaction.

Examples of the constitutional unit having a steric repulsive group include the following structures.

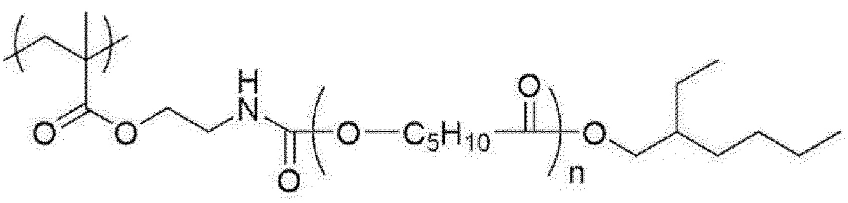

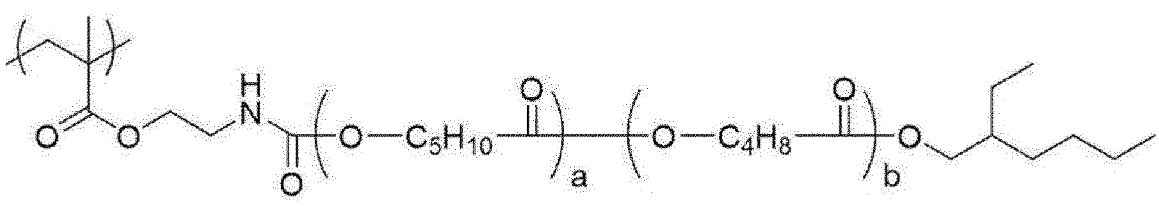

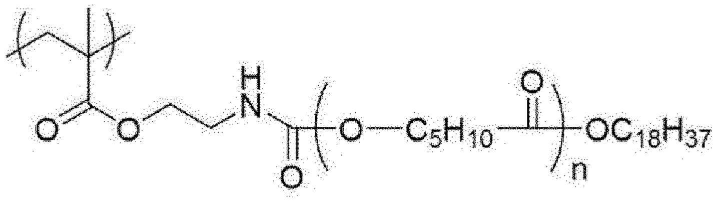

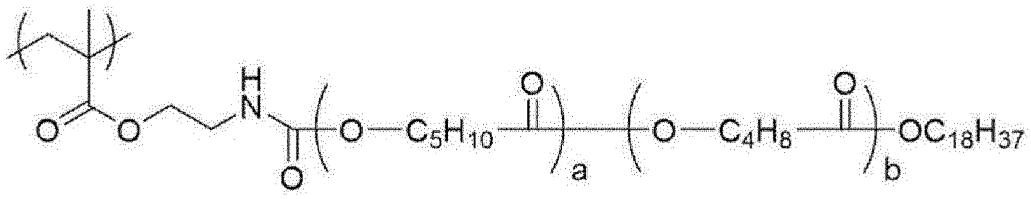

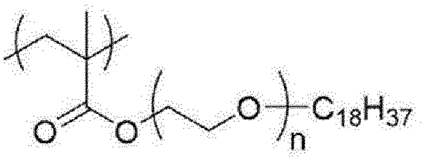

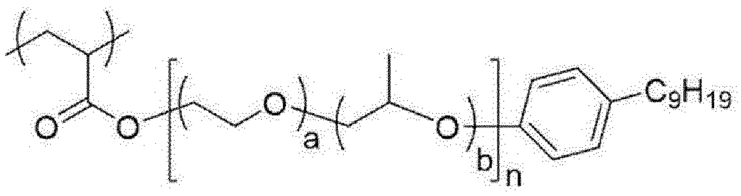

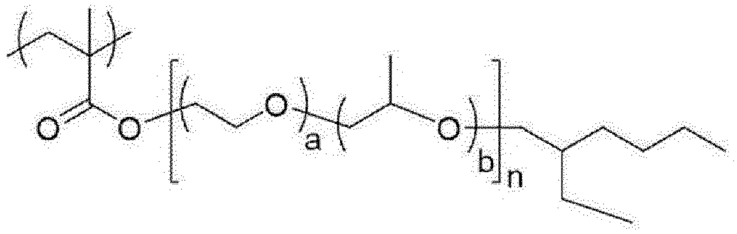

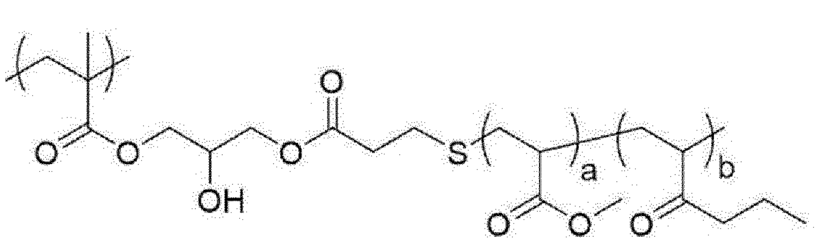

n, a, and b each independently represent an integer of 1 or more.

The dispersant having a basic group may further include a constitutional unit having an acid group.

Examples of the acid group include a carboxy group (carboxylic acid group), a sulfonamide group, a phosphonic acid group, a sulfonic acid group, a phenolic hydroxyl group, and a sulfonylimide group. Among these, a carboxy group is particularly preferable.

Preferred specific examples of the constitutional unit having an acid group include the following structures.

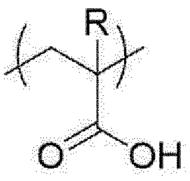

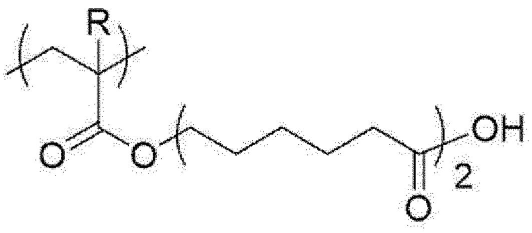

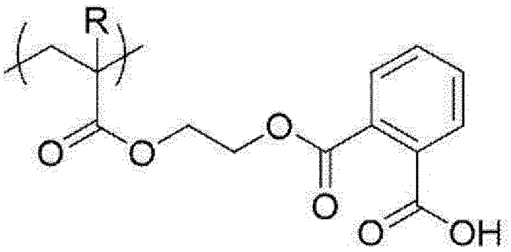

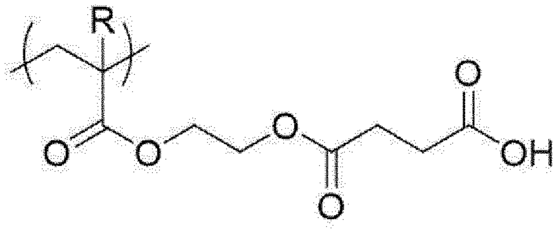

R represents a hydrogen atom or a methyl group.

The specific dispersant may be a dispersant having an acid group as the adsorbing group.

Examples of the dispersant having an acid group include a random copolymer or an alternating copolymer, which includes a constitutional unit having an acid group and a constitutional unit having a steric repulsive group.

Examples of the constitutional unit having an acid group include the same constitutional units having an acid group used in the above-described specific dispersant having a basic group.

In addition, examples of the constitutional unit having a steric repulsive group include the same constitutional units having a steric repulsive group used in the above-described specific dispersant having a basic group.

Specific examples of the specific dispersant include compounds having the following structures (numerical value added to each constitutional unit of a main chain is a molar ratio).

All of the compounds having the following structures may be a random copolymer or an alternating copolymer.

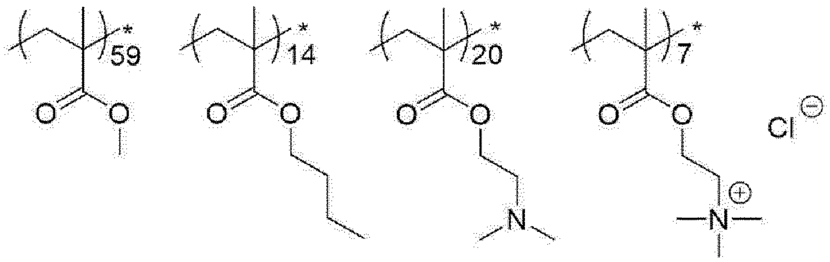

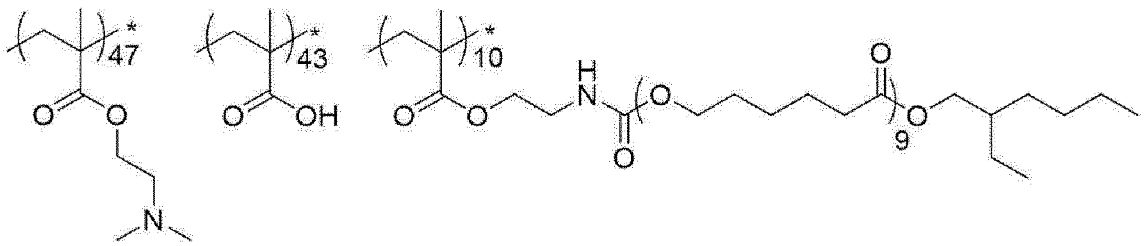

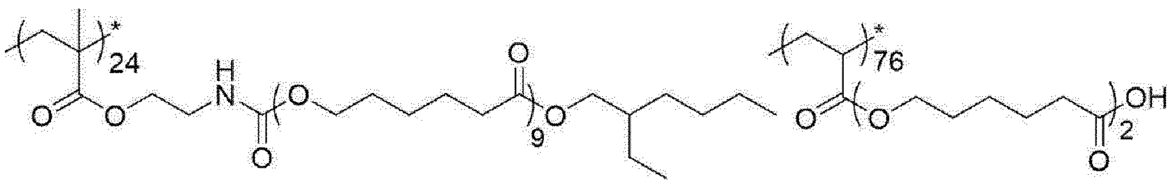

The specific dispersant may further have a reactive group, which exhibits reactivity with heat and/or light, such as a cyclic ether (epoxy and oxetane) and an ethylenically unsaturated bond.

More specifically, the specific dispersant may have a constitutional unit having the above-described reactive group in addition to the constitutional unit having an adsorbing group and the constitutional unit having a steric repulsive group.

As a method for synthesizing the specific dispersant, a known method capable of synthesizing a random copolymer or an alternating copolymer may be used, and there is no particular limitation.

In addition, confirmation that the specific dispersant is a random copolymer or an alternating copolymer can be performed by using nuclear magnetic resonance (NMR).

The weight-average molecular weight of the specific dispersant is preferably 2500 to 200000, more preferably 5000 to 150000, and still more preferably 7500 to 100000.

In the present disclosure, the specific dispersant may be used singly or in combination of two or more kinds thereof.

The content of the specific dispersant in the composition according to the embodiment of the present disclosure may be appropriately set according to the type and content of the pigment and the pigment derivative.

For example, the content of the specific dispersant is preferably 5 mass% to 200 mass%, more preferably 10 mass% to 150 mass%, and still more preferably 15 mass% to 100 mass% with respect to the total amount of the pigment and the pigment derivative.

[Solvent]

The curable composition in the present disclosure preferably includes a solvent.

Examples of the solvent include esters such as ethyl acetate, n-butyl acetate, isobutyl acetate, amyl formate, isoamyl acetate, isobutyl acetate, butyl propionate, isopropyl butyrate, ethyl butyrate, butyl butyrate, alkyl esters, methyl lactate, ethyl lactate, methyl oxyacetate, ethyl oxyacetate, butyl oxyacetate, methyl methoxyacetate, ethyl methoxyacetate, butyl methoxyacetate, methyl ethoxyacetate, ethyl ethoxyacetate, alkyl esters of 3-oxypropionate such as methyl 3-oxypropionate and ethyl 3-oxypropionate (for example, methyl 3-methoxypropionate, ethyl 3-methoxypropionate, methyl 3-ethoxypropionate, and ethyl 3-ethoxypropionate), alkyl esters of 2-oxypropionate such as methyl 2-oxypropionate, ethyl 2-oxypropionate, and propyl 2-oxypropionate (for example, methyl 2-methoxypropionate, ethyl 2-methoxypropionate, propyl 2-methoxypropionate, methyl 2-ethoxypropionate, ethyl 2-ethoxypropionate, methyl 2-oxy-2-methylpropionate, 2-ethyl 2-oxy-2-methylpropionate, methyl 2-methoxy-2-methylpropionate, and ethyl 2-ethoxy-2-methylpropionate), methyl pyruvate, ethyl pyruvate, propyl pyruvate, methyl acetoacetate, ethyl acetoacetate, methyl 2-oxobutate, and ethyl 2-oxobutate;

ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol methyl ether acetate, propylene glycol ethyl ether acetate, and propylene glycol propyl ether acetate;
ketones such as methyl ethyl ketone, cyclopentanone, cyclohexanone, 2-heptanone, and 3-heptanone; and
aromatic hydrocarbons such as toluene and xylene.

However, it may be preferable that the content of aromatic hydrocarbons (such as benzene, toluene, xylene, and ethylbenzene) as the organic solvent is low (for example, 50 ppm or less, 10 ppm or less, or 1 ppm by mass or less with respect to the total mass of the organic solvent) in consideration of environmental aspects and the like.

Among these, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclopentanone, cyclohexanone, ethyl carbitol acetate, butyl carbitol acetate, propylene glycol monomethyl ether, propylene glycol methyl ether acetate, or the like is suitable.

The solvent may be used alone or in combination of two or more thereof.

In the present disclosure, an organic solvent having a low metal content is preferably used. For example, the metal content in the organic solvent is preferably 10 ppb or less. Optionally, an organic solvent having a metal content at a ppt level may be used. For example, such an organic solvent is available from Toyo Gosei Co., Ltd. (The Chemical Daily, November 13, 2015).

Examples of a method for removing impurities such as a metal from the organic solvent include distillation (such as molecular distillation and thin-film distillation) and filtration using a filter. The filter pore size of the filter used for the filtration is preferably 10 μm or less, more preferably 5 μm or less, and still more preferably 3 μm or less. As a material of the filter, polytetrafluoroethylene, polyethylene, or nylon is preferable.

The organic solvent may include an isomer (a compound having the same number of atoms and a different

structure). In addition, only one kind of isomers may be included, or a plurality of isomers may be included.

The organic solvent preferably has the content of peroxides of 0.8 mmol/L or less, and more preferably, the organic solvent does not substantially include peroxides.

In the composition according to the embodiment of the present disclosure, the solvent may be used singly or in combination of two or more kinds thereof.

The content of the solvent in the composition according to the embodiment of the present disclosure may be appropriately determined based on the solid content determined according to the purpose of use, application, and the like of the composition according to the embodiment of the present disclosure.

[Other components]

The composition according to the embodiment of the present disclosure may be a pigment dispersion liquid including the pigment, the specific pigment derivative, the specific dispersant, and the solvent, or may include a component other than these components.

The composition according to the embodiment of the present disclosure is preferably a composition from which a film can be obtained, and is preferably a curable composition from which a cured film can be finally obtained by curing.

In addition, for example, the composition according to the embodiment of the present disclosure is preferably a curable composition capable of forming a pattern of a cured film by pattern exposure and removing a non-exposed portion by development. That is, the composition according to the embodiment of the present disclosure is preferably a negative type curable composition.

In a case where the composition according to the embodiment of the present disclosure is a negative type curable composition, an aspect in which a polymerization initiator and a polymerizable compound are further included in addition to the pigment, the specific pigment derivative, the specific dispersant, and the solvent described above is preferable.

In addition, the composition according to the embodiment of the present disclosure may include a pigment derivative other than the specific pigment derivative and a dispersant other than the specific dispersant described above, as long as the effects of the composition according to the embodiment of the present disclosure are not impaired.

For example, in the composition according to the embodiment of the present disclosure, the specific dispersant and a dispersant other than the specific dispersant may be used in combination. In the composition according to the embodiment of the present disclosure, in a case of using the specific dispersant and a dispersant other than the specific dispersant in combination, the content of the specific dispersant is preferably 30 mass% or more and less than 100 mass%, more preferably 40 mass% or more and less than 100 mass%, and still more preferably 50 mass% or more and less than 100 mass% with respect to the total amount of the specific dispersant and the dispersant other than the specific dispersant.

In a case where the composition according to the embodiment of the present disclosure is a positive type composition, examples of the composition according to the embodiment of the present disclosure include an aspect of including a photoacid generator, a polymer which has a constitutional unit having a group in which an acid group is protected by an acid-decomposable group, and a polymer which has a constitutional unit having a crosslinkable group, in addition to the pigment, the specific pigment derivative, the specific dispersant, and the solvent.

Examples of each component included in the aspect in which the composition according to the embodiment of the present disclosure is a positive type composition include each component described in WO2014/003111A, and the preferred aspect thereof is also the same.

[Curable composition]

As described above, the composition according to the embodiment of the present disclosure preferably includes a polymerizable compound and a polymerization initiator in addition to the pigment, the specific pigment derivative, the specific dispersant, and the solvent, that is, it is preferable to be a so-called curable composition.

Since the above-described curable composition includes the composition according to the embodiment of the present disclosure, it is possible to maintain a state in which dispersion stability of the pigment is high even in the film formed from the curable composition. As a result, according to the above-described curable composition, in a case where a part of the formed film is removed by development, residues derived from aggregation of the pigment are less likely to occur, and development residues are reduced.

Hereinafter, the case where the composition according to the embodiment of the present disclosure is a negative type curable composition will be described in detail.

The content of the pigment in the curable composition in the present disclosure is preferably 1 mass% to 80 mass%, more preferably 5 mass% to 75 mass%, and still more preferably 10 mass% to 70 mass% with respect to the total solid content of the curable composition.

In a case where the content of the pigment is within the above-described range, the function of the pigment is sufficiently exhibited.

The content of the specific pigment derivative in the curable composition in the present disclosure is preferably 0.1 mass% to 30 mass%, more preferably 1 mass% to 20 mass%, and still more preferably 3 mass% to 15 mass% with respect to the total solid content of the curable composition.

In a case where the content of the specific pigment derivative is within the above-described range, dispersion stability of the pigment is excellent.

The content of the specific dispersant in the curable composition in the present disclosure is preferably 0.2 mass% to 30 mass%, more preferably 1 mass% to 20 mass%, and still more preferably 5 mass% to 15 mass% with respect to the total solid content of the curable composition.

In a case where the content of the specific dispersant is within the above-described range, dispersion stability of the pigment is excellent.

The solid content of the curable composition in the present disclosure varies depending on the coating method and the like, but for example, is preferably 1 mass% or more and less than 100 mass%, more preferably 5 mass% to 50 mass%, and still more preferably 10 mass% to 30 mass%.

That is, in the curable composition in the present disclosure, the solvent may be used so that the solid content is within the above-described range.

[Polymerizable compound]

The curable composition in the present disclosure preferably includes a polymerizable compound.

The polymerizable compound is more preferably an ethylenically unsaturated compound, and particularly preferably a compound having a terminal ethylenically unsaturated group.

As such as a group of compounds, a known compound can be used without particular limitation.

For example, the polymerizable compound has a chemical form such as a monomer, a prepolymer, that is, a dimer, a trimer, and an oligomer, or a mixture thereof, and a copolymer thereof, and refers to a compound having a molecular weight or weight-average molecular weight (Mw) of less than 2,000.

Examples of the polymerizable compound include unsaturated carboxylic acids (such as acrylic acid, methacrylic acid, itaconic acid, crotonic acid, isocrotonic acid, and maleic acid), and esters and amides thereof, and esters of an unsaturated carboxylic acid and an aliphatic polyhydric alcohol compound or amides of an unsaturated carboxylic acid and an aliphatic polyvalent amine compound are preferably used.

Suitable examples of the polymerizable compound include an addition reaction product of unsaturated carboxylic acid esters or amides, which have a nucleophilic substituent such as a hydroxy group, an amino group, and a mercapto group, with monofunctional or polyfunctional isocyanates or epoxies; and a dehydration-condensation reaction product of unsaturated carboxylic acid esters or amides, which have a nucleophilic substituent such as a hydroxy group, an amino group, and a mercapto group, with a monofunctional or polyfunctional carboxylic acid.

Further, suitable examples of the polymerizable compound also include an addition reaction product of unsaturated carboxylic acid esters or amides, which have an electrophilic substituent such as an isocyanate group and an epoxy group, with monofunctional or polyfunctional alcohols, amines, or thiols; and a substitution reaction product of unsaturated carboxylic acid esters or amides, which have a dissociable substituent such as a halogen atom and a tosyloxy group, with monofunctional or polyfunctional alcohols, amines, or thiols.

In addition, other examples of the polymerizable compound include a group of compounds in which the above-described unsaturated carboxylic acid is replaced with unsaturated phosphonic acid, styrene, vinyl ether, or the like.

Specific examples of a monomer of the ester of the aliphatic polyhydric alcohol compound and the unsaturated carboxylic acid include, as acrylic acid esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer, and isocyanuric acid EO-modified triacrylate.

Specific examples of the monomer of the ester of the aliphatic polyhydric alcohol compound and the unsaturated carboxylic acid include, as methacrylic acid esters, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl] dimethylmethane, and bis-[p-(methacryloxyethoxy)phenyl] dimethylmethane.

In addition, as the polymerizable compound, urethane-based addition polymerizable compounds produced using an addition reaction between an isocyanate group and a hydroxy group are also suitable, and specific examples thereof include vinyl urethane compounds having two or more polymerizable vinyl groups in one molecule obtained by adding vinyl monomers having a hydroxy group represented by Formula (I) to a polyisocyanate compound having two or more isocyanate groups in one molecule which is described in JP1973-41708B (JP-S48-41708B).

$$CH_2=C(R)COOCH_2CH(R')OH \qquad (I)$$

(however, R and R' represent H or $CH_3$)

In addition, urethane acrylates described in JP1976-37193A (JP-S51-37193A), JP1990-32293B (JP-H2-32293B), or JP1990-16765B (JP-H2-16765B), or urethane compounds having an ethylene oxide skeleton, described in JP1983-49860B (JP-S58-49860B), JP1981-17654B (JP-S56-17654B), JP1987-39417B (JP-S62-39417B), or JP1987-39418B (JP-S62-39418B), are also suitable. Further, by using addition polymerizable compounds having an amino structure or a sulfide structure in the molecule, described in JP1988-277653A (JP-S63-277653A), JP1988-260909A (JP-S63-260909A), or JP1989-105238A (JP-H1-105238A), a composition having very high photosensitive speed can be obtained.

In addition, examples of the polymerizable compound include compounds described in paragraphs 0178 to 0190 of JP2007-277514A.

In addition, as the polymerizable compound, epoxy compounds described in JP2015-187211A may be used.

In the curable composition in the present disclosure, the polymerizable compound may be used singly or in combination of two or more kinds thereof.

The content of the polymerizable compound in the curable composition in the present disclosure is preferably 1 mass% to 90 mass%, more preferably 5 mass% to 80 mass%, and still more preferably 10 mass% to 70 mass% with respect to the total solid content of the curable composition. In a case where the content of the polymerizable compound is within the above-described range, curing properties of the curable composition are excellent.

[Polymerization initiator]

The curable composition in the present disclosure preferably includes a polymerization initiator.

As the polymerization initiator, a photopolymerization initiator is particularly preferable.

The photopolymerization initiator is not particularly limited as long as it has an ability to initiate the polymerization of the polymerizable compound, and can be appropriately selected from known photopolymerization initiators. For example, a compound having photosensitivity to light in a range from an ultraviolet range to a visible range is preferable. In addition, the photopolymerization initiator may be a compound which produces an active radical by causing some action with a photoexcited sensitizer. Among these, the photopolymerization initiator is particularly preferably a photoradical polymerization initiator.

Examples of the photopolymerization initiator include a halogenated hydrocarbon derivative (for example, a compound having a triazine skeleton or a compound having an oxadiazole skeleton), an acylphosphine compound, a hexaarylbiimidazole, an oxime compound, an organic peroxide, a thio compound, a ketone compound, an aromatic onium salt, an $\alpha$-hydroxyketone compound, and an $\alpha$-aminoketone compound. From the viewpoint of exposure sensitivity, as the photopolymerization initiator, a trihalomethyltriazine compound, a benzyldimethylketal compound, an $\alpha$-hydroxyketone compound, an $\alpha$-aminoketone compound, an acylphosphine compound, a phosphine oxide compound, a metallocene compound, an oxime compound, a triarylimidazole dimer, an onium compound, a benzothiazole compound, a benzophenone compound, an acetophenone compound, a cyclopentadiene-benzene-iron complex, a halomethyl oxadiazole compound, or a 3-aryl-substituted coumarin compound is preferable, a compound selected from an oxime compound, an $\alpha$-hydroxyketone compound, an $\alpha$-aminoketone compound, or an acylphosphine compound is more preferable, and an oxime compound is still more preferable. With regard to the photopolymerization initiator, reference can be made to the description in paragraphs 0065 to 0111 of JP2014-130173A and paragraphs 0274 to 0306 of JP2013-29760A, and the contents of which are incorporated herein by reference.

Examples of a commercially available product of the $\alpha$-hydroxyketone compound include DAROCUR 1173 and IRGACURE 500, both of which are manufactured by BASF, Omnirad 184 (formerly IRGACURE 184), Omnirad 2959 (formerly IRGACURE 2959), and Omnirad 127 (formerly IRGACURE-127), all of which are manufactured by IGM Resins B.V.

Examples of a commercially available product of the $\alpha$-aminoketone compound include Omnirad 907 (formerly IRGACURE-907), Omnirad 369 (formerly IRGACURE 369), Omnirad 379 (formerly IRGACURE 379), and Omnirad 379EG (formerly IRGACURE-379EG), all of which are manufactured by IGM Resins B.V.

Examples of a commercially available product of the acylphosphine compound include Omnirad 819 (formerly IRGACURE 819) manufactured by IGM Resins B.V., and Omnirad TPO H (formerly IRGACURE TPO) manufactured

by BASF.

Examples of the oxime compound include the compounds described in JP2001-233842A, the compounds described in JP2000-80068A, the compounds described in JP2006-342166A, the compounds described in J. C. S. Perkin II (1979, pp. 1653 to 1660), the compounds described in J. C. S. Perkin II (1979, pp. 156 to 162), the compounds described in Journal of Photopolymer Science and Technology (1995, pp. 202 to 232), the compounds described in JP2000-66385A, the compounds described in JP2000-80068A, the compounds described in JP2004-534797A, the compounds described in JP2006-342166A, the compounds described in JP2017-19766A, the compounds described in JP6065596B, the compounds described in WO2015/152153A, and the compounds described in WO2017/051680A. Specific examples of the oxime compound include 3-benzoyloxyiminobutane-2-one, 3-acetoxyiminobutane-2-one, 3-propionyloxyiminobutane-2-one, 2-acetoxyiminopentane-3 -one, 2-acetoxyimino-1-phenylpropane-1-one, 2-benzoyloxyimino-1-phenylpropane-1-one, 3-(4-toluene sulfonyloxy)iminobutane-2-one, and 2-ethoxycarbonyloxyimino-1-phenylpropane-1-one.

As a commercially available product of the oxime compound, IRGACURE OXE01, IRGACURE OXE02, IRGACURE OXE03, and IRGACURE OXE04, all of which are manufactured by BASF, are also suitably used.

In addition, examples of a commercially available product of the oxime compound include TRONLY TR-PBG-304, TRONLY TR-PBG-309, and TRONLY TR-PBG-305, all of which are manufactured by CHANGZHOU TRONLY NEW ELECTRONIC MATERIALS CO., LTD., and ADEKA ARKLS NCI-930 and ADEKA OPTOMER N-1919 (a photopolymerization initiator 2 described in JP2012-14052A), both of which are manufactured by ADEKA Corporation.

In addition, as oxime compounds other than the above-described oxime compounds, the compounds described in JP2009-519904A in which oxime is linked to N of a carbazole ring, the compounds described in US7626957B in which a hetero-substituent is introduced into a benzophenone site, the compounds described in JP2010-15025A in which a nitro group is introduced into a coloring agent site, the compounds described in US2009-292039A, the ketoxime compounds described in WO2009/131189A, the compounds described in US7556910B, which contains a triazine skeleton and an oxime skeleton in the same molecule, the compound described in JP2009-221114A, which has a maximum absorption at 405 nm and has good sensitivity to a light source of g-rays, and the like may be used.

An oxime compound having a fluorene ring can also be used as the photopolymerization initiator. Specific examples of the oxime compound having a fluorene ring include the compounds described in JP2014-137466A, the contents of which are incorporated herein by reference.

An oxime compound having a benzofuran skeleton can also be used as the photopolymerization initiator. Specific examples of the oxime compound having a benzofuran skeleton include compounds OE-01 to OE-75 described in WO2015/036910A.

As the photopolymerization initiator, an oxime compound having a skeleton in which at least one benzene ring of a carbazole ring is a naphthalene ring can also be used. Specific examples of this oxime compound include the compounds described in WO2013/083505A.

An oxime compound having a fluorine atom can also be used as the photopolymerization initiator. Specific examples of the oxime compound having a fluorine atom include the compounds described in JP2010-262028A, the compounds 24, and 36 to 40 described in JP2014-500852A, and the compound (C-3) described in JP2013-164471A, the contents of which are incorporated herein by reference.

An oxime compound having a nitro group can be used as the photopolymerization initiator. The oxime compound having a nitro group is also preferably used in the form of a dimer. Specific examples of the oxime compound having a nitro group include the compounds described in paragraphs 0031 to 0047 of JP2013-114249A and paragraphs 0008 to 0012 and 0070 to 0079 of JP2014-137466A, the compounds described in paragraphs 0007 to 0025 of JP4223071B, and ADEKAARKLS NCI-831 (manufactured by ADEKA Corporation).

Specific examples of the oxime compound which are preferably used in the present disclosure are shown below, but the present disclosure is not limited thereto.

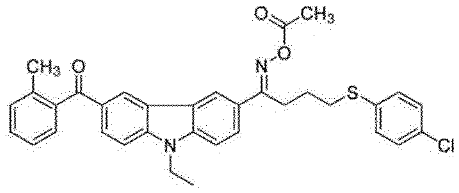

(C-1)

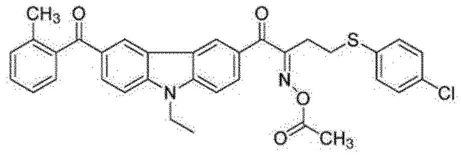

(C-2)

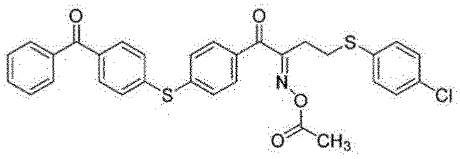

(C-3)

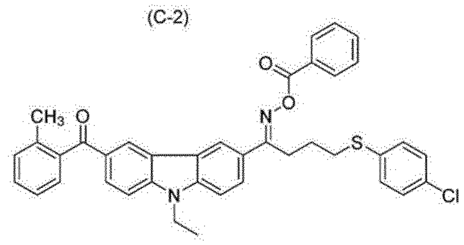

(C-4)

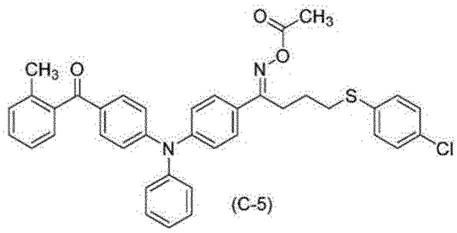

(C-5)

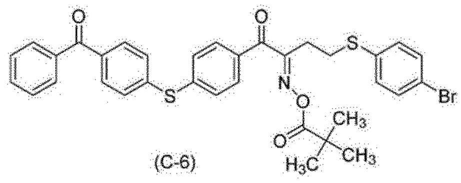

(C-6)

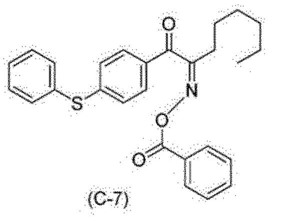

(C-7)

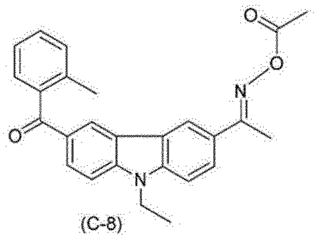

(C-8)

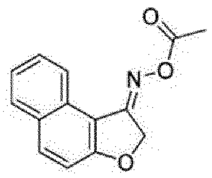

(C-9)

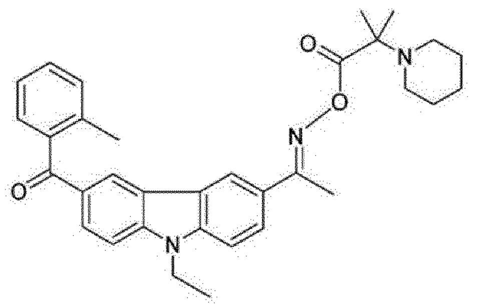

(C-10)

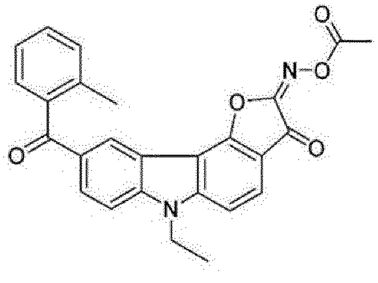

(C-11)

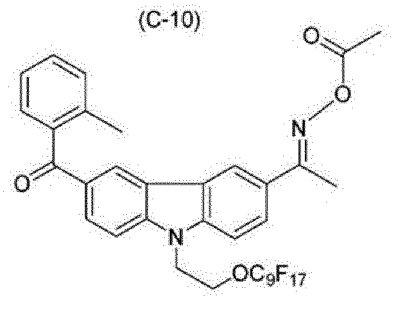

(C-12)

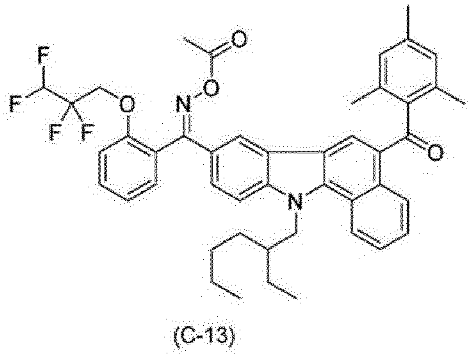

(C-13)

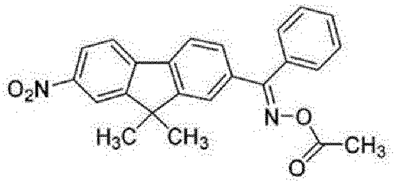

(C-14)

The oxime compound is preferably a compound having a maximal absorption wavelength in a wavelength region of 350 nm to 500 nm and more preferably a compound having a maximal absorption wavelength in a wavelength region of 360 nm to 480 nm. The oxime compound is preferably a compound having a high absorbance at wavelengths of 365 nm and 405 nm.

From the viewpoint of sensitivity, the molar absorption coefficient of the oxime compound at wavelengths of 365 nm or 405 nm is preferably 1,000 to 300,000, more preferably 2,000 to 300,000, and particularly preferably 5,000 to 200,000. The molar absorption coefficient of a compound can be measured using a known method. For example, the molar absorption coefficient is preferably measured by an ultraviolet-visible spectrophotometer (Cary-5 spectrophotometer, manufactured by Varian) using an ethyl acetate solvent at a concentration of 0.01 g/L.

As the photopolymerization initiator, a bifunctional or tri- or higher functional photopolymerization initiator may be used. Specific examples of such a photopolymerization initiator include the dimers of the oxime compounds described in JP2010-527339A, JP2011-524436A, WO2015/004565A, paragraphs 0412 to 0417 of JP2016-532675A, and paragraphs 0039 to 0055 of WO2017/033680A, the compound (E) and the compound (G) described in JP2013-522445A, and Cmpd 1 to 7 described in WO2016/034963A.

In the curable composition in the present disclosure, the polymerization initiator may be used singly or in combination of two or more kinds thereof.

The content of the polymerization initiator in the curable composition in the present disclosure is preferably 0.1 mass% to 50 mass%, more preferably 0.5 mass% to 30 mass%, and particularly preferably 1 mass% to 20 mass% with respect to the total solid content of the curable composition.

In a case where the content of the polymerization initiator is within the above-described range, good sensitivity and pattern formability can be obtained.

[Other components]

The curable composition in the present disclosure may include a component other than the above-described components.

Examples of other components include a binder resin, a polymerization inhibitor, a solvent, a sensitizer, a co-sensitizer, and other additives.

(Binder resin)

From the viewpoint of film-forming property, the curable composition in the present disclosure preferably includes a binder resin.

The binder resin is a component which does not correspond to the above-described specific dispersant.

Specific examples of the binder resin include an acrylic resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamidoimide resin, a polyolefin resin, a cyclic olefin resin, a polyester resin, a styrene resin, a siloxane resin, a urethane resin, and an epoxy resin. Among these, it is preferable to include an acrylic resin.

From the viewpoint of improving heat resistance, as the cyclic olefin resin, a norbornene resin can be preferably used.

Examples of a commercially available product of the norbornene resin include ARTON series (for example, ARTON F4520) manufactured by JSR Corporation. Examples of a commercially available product of the polyimide resin include Neoprim (registered trademark) series (for example, C3450) manufactured by MITSUBISHI GAS CHEMICAL COMPANY, INC.

In addition, as the binder resin, resins described in Examples of WO2016/088645A, resins described in JP2017-57265A, resins described in JP2017-32685A, resins described in JP2017-075248A, and resins described in JP2017-66240A can also be used, the contents of which are incorporated herein by reference.

In addition, as the binder resin, a resin having a fluorene skeleton can also be preferably used. With regard to the resin having a fluorene skeleton, reference can be made to the description in US2017/0102610A, the content of which is incorporated herein by reference.

The weight-average molecular weight (Mw) of the binder resin is preferably 2,000 to 2,000,000. The upper limit is more preferably 1,000,000 or less and still more preferably 500,000 or less. The lower limit is more preferably 3,000 or more and still more preferably 5,000 or more.

In the curable composition in the present disclosure, the binder resin may be used singly or in combination of two or more kinds thereof.

The content of the binder resin in the curable composition in the present disclosure is preferably 10 mass% to 80 mass% and more preferably 15 mass% to 60 mass% with respect to the total solid content of the curable composition.

(Polymerization inhibitor)

From the viewpoint of storage stability, the curable composition in the present disclosure preferably includes a polymerization inhibitor.

The polymerization inhibitor is not particularly limited, and a known polymerization inhibitor can be used.

Examples of the polymerization inhibitor include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), an N-nitrosophenylhydroxylamine salt (an ammonium salt, a cerous salt, or the like), and 2,2,6,6-tetramethylpiperidin-1-oxyl. The polymerization inhibitor may also function as an antioxidant.

In the curable composition in the present disclosure, the polymerization inhibitor may be used singly or in combination of two or more kinds thereof.

From the viewpoint of storage stability, the content of the polymerization inhibitor in the curable composition in the present disclosure is preferably 0.1 ppm to 1,000 ppm, more preferably 1 ppm to 500 ppm, and particularly preferably 1 ppm to 100 ppm with respect to the total solid content of the curable composition.

Here, the "ppm", and "ppb" and "ppt" described later are all based on mass.

(Sensitizer)

The curable composition in the present disclosure may contain a sensitizer in order to improve generation efficiency of polymerization initiation species such as radicals and cations of the polymerization initiator and lengthening the photosensitive wavelength.

It is preferable that the sensitizer sensitizes the above-described photopolymerization initiator using an electron migration mechanism or an energy-transfer mechanism.

Examples of the sensitizer include a sensitizer which belongs to compounds listed below and has an absorption wavelength in a wavelength region of 300 nm to 450 nm.

Examples of a preferred sensitizer include a sensitizer which belongs to the following compounds and has an absorption wavelength in a wavelength region of 330 nm to 450 nm.

Examples thereof include polynuclear aromatic compounds (for example, phenanthrene, anthracene, pyrene, perylene, triphenylene, and 9,10-dialkoxyanthracene), xanthenes (for example, fluoressein, eosin, erythrosin, Rhodamine B, and rose bengal), thioxanthons (isopropylthioxanthone, diethylthioxanthone, and chlorothioxanthone), cyanines (for example, thiacarbocyanine and oxacarbocyanine), merocyanines (for example, merocyanine and carbomerocyanine), phthalocyanines, thiazines (for example, thionine, methylene blue, and toluidine blue), acridines (for example, acridine orange, chloroflavin, and acriflavin), anthraquinones (for example, anthraquinone), squaryliums (for example, squarylium), acridine orange, coumarins (for example, 7-diethylamino-4-methylcoumarin), ketocoumarins, phenothiazines, phenazines, styrylbenzenes, azo compounds, diphenylmethane, triphenylmethane, distyrylbenzenes, carbazoles, porphyrin, spiro compounds, quinacridone, indigo, styryl, pyrylium compounds, pyrromethene compounds, pyrazorotriazole compounds, benzothiazole compounds, barbituric acid derivatives, thiobarbituric acid derivatives, aromatic ketone compounds such as acetophenone, benzophenone, and Michler's ketone, and heterocyclic compounds such as N-aryloxazolidinone. Further, examples thereof include compounds described in EP568993B, US4508811A, US5227227A, JP2001-125255A, JP1999-271969A (JP-H11-271969A), and the like.

The sensitizer may be used alone or in combination of two or more kinds thereof.

In a case where the curable composition in the present disclosure contains a sensitizer, from the viewpoint of light absorption efficiency to a deep portion and initial decomposition efficiency, the content of the sensitizer is preferably 0.1 mass% to 20 mass% and more preferably 0.5 mass% to 15 mass% with respect to the total solid content of the

curable composition.

(Co-sensitizer)

The curable composition in the present disclosure may contain a co-sensitizer.
The co-sensitizer has a function of further improving sensitivity of the sensitizing coloring agent or the initiator to radioactive ray, or of suppressing inhibition of polymerization of the polymerizable compound due to oxygen.
In addition, examples of the co-sensitizer include compounds described in paragraphs 0233 to 0241 of JP2007-277514A.
The co-sensitizer may be used alone or in combination of two or more kinds thereof.
In a case where the curable composition in the present disclosure contains a co-sensitizer, from the viewpoint of improving curing rate by balancing polymerization growth rate and chain transfer, the content of these co-sensitizers is preferably in a range of 0.1 mass% to 30 mass%, more preferably in a range of 0.5 mass% to 25 mass%, and still more preferably in a range of 1 mass% to 20 mass% with respect to the total solid content of the curable composition.

(Other additives)

Optionally, the curable composition in the present disclosure can contain various additives such as a surfactant, a colorant other than the near-infrared absorbing pigment, an adhesion promoter, an antioxidant, an ultraviolet absorber, and an anti-aggregation agent.
Examples of other components include compounds described in paragraphs 0238 to 0249 of JP2007-277514A.

[Preparation of curable composition]

The curable composition in the present disclosure can be prepared by mixing each of the above-described components. In addition, it is preferable that the composition is filtered through a filter, for example, in order to remove foreign matters or to reduce defects. As the filter, any filters that have been used in the related art for filtration use and the like may be used without particular limitation. Examples of the filter include filters formed of a fluororesin such as polytetrafluoroethylene (PTFE), a polyamide-based resin such as nylon (for example, nylon-6 and nylon-6,6), or a polyolefin resin (including a polyolefin resin having a high-density or an ultrahigh molecular weight) such as polyethylene and polypropylene (PP). Among these materials, polypropylene (including a high-density polypropylene) or nylon is preferable.
The pore size of the filter is preferably 0.01 μm to 7.0 μm, more preferably 0.01 μm to 3.0 μm, and still more preferably 0.05 μm to 0.5 μm. Within this range, it is possible to reliably remove fine foreign matters which hinder the preparation of uniform and smooth composition in the subsequent step. In addition, it is also preferable to use a fibrous filter medium, and examples of the filter medium include polypropylene fiber, nylon fiber, and glass fiber, and specifically, filter cartridges of SBP type series (SBP008 and the like), TPR type series (TPR002, TPR005, and the like), or SHPX type series (SHPX003 and the like), all manufactured by Roki Techno Co., Ltd, can be used.
In a case of using a filter, different filters may be combined. In this case, the filtration with a first filter may be performed once or may be performed twice or more times.
In addition, first filters having different pore sizes within the above-described range may be combined. Here, the pore size of the filter can refer to a nominal value of a manufacturer of the filter. As a commercially available filter, for example, various filters provided by Nihon Pall Corporation (DFA4201NIEY and the like), Advantec Toyo Kaisha., Ltd., Nihon Entegris G. K., Kitz Microfilter Corporation, or the like can be selected.

[Use of curable composition]

Since the curable composition in the present disclosure can be liquid, for example, a film can be easily manufactured by applying the curable composition in the present disclosure to a base material or the like, and drying the curable composition in the present disclosure.
In a case where the film is formed by coating, from the viewpoint of application property, the viscosity of the composition according to the embodiment of the present disclosure at 25°C is preferably 1 mPa·s to 100 mPa·s. The lower limit is more preferably 2 mPa·s or more and still more preferably 3 mPa·s or more. The upper limit is more preferably 50 mPa·s or less, still more preferably 30 mPa·s or less, and particularly preferably 15 mPa·s or less.
The viscosity in the present disclosure is measured using a viscometer (trade name: VISCOMETER TV-22) manufactured by Toki Sangyo Co., Ltd. at 25°C.
The use of the curable composition in the present disclosure is not particularly limited. For example, the composition according to the embodiment of the present disclosure can be preferably used to form an infrared cut filter or

the like. For example, the composition according to the embodiment of the present disclosure can be preferably used for an infrared cut filter on a light-receiving side of a solid-state imaging element (for example, for an infrared cut filter for a wafer level lens), an infrared cut filter on a back surface side (opposite to the light-receiving side) of the solid-state imaging element, and the like. In particular, the composition according to the embodiment of the present disclosure can be preferably used as an infrared cut filter on a light-receiving side of a solid-state imaging element. In addition, by further adding the colorant which shields visible light to the curable composition in the present disclosure, it is possible to form an infrared transmitting filter capable of transmitting infrared rays of a specific wavelength or higher. For example, it is also possible to form an infrared transmitting filter capable of transmitting a part of infrared rays having a wavelength of 850 nm or more by shielding light from a wavelength of 400 nm to 850 nm.

In addition, the curable composition in the present disclosure is preferably stored in a storage container.

As the storage container, for the purpose of preventing impurities from being infiltrated into raw materials and the composition, a multilayer bottle in which a container interior wall having a six-layer structure is formed of six kinds of resins or a bottle in which a container interior wall having a seven-layer structure is formed of six kinds of resins is preferably used. Examples of these containers include containers described in JP2015-123351A.

<Film>

The film according to an embodiment of the present disclosure is a film which consists of the curable composition in the present disclosure (composition further including the polymerizable compound and the polymerization initiator in addition to the pigment, the specific pigment derivative, the specific dispersant, and the solvent) or is obtained by curing the curable composition in the present disclosure.

In addition, since the curable composition in the present disclosure includes a solvent, it is preferable to dry the curable composition.

The film according to the embodiment of the present disclosure can be preferably used as an infrared cut filter. In addition, the film according to the embodiment of the present disclosure can also be used as a heat ray shielding filter or an infrared transmitting filter. The film according to the embodiment of the present disclosure may be used by being laminated on a support, or may be used by being peeled off from a support. The film according to the embodiment of the present disclosure may be a film having a pattern or a film (flat film) not having a pattern.

In the "drying" in the present disclosure, it is sufficient to remove at least a part of the solvent and it is not necessary to completely remove the solvent, and the amount of the solvent removed can be set as desired.

In addition, the above-described curing may be performed as long as the hardness of the film is improved, but curing by polymerization is preferable.

The thickness of the film according to the embodiment of the present disclosure can be appropriately adjusted according to the purpose. The thickness of the film is preferably 20 μm or less, more preferably 10 μm or less, and still more preferably 5 μm or less. The lower limit of the thickness of the film is preferably 0.1 μm or more, more preferably 0.2 μm or more, and still more preferably 0.3 μm or more.

The film according to the embodiment of the present disclosure preferably has a maximal absorption wavelength in a wavelength range of 650 nm to 1,500 nm, more preferably has a maximal absorption wavelength in a wavelength range of 680 nm to 1,300 nm, and still more preferably has a maximal absorption wavelength in a wavelength range of 700 nm to 850 nm.

In a case where the film according to the embodiment of the present disclosure is used as an infrared cut filter, the film according to the embodiment of the present disclosure preferably satisfies at least one condition of the following (1) to (4), and still more preferably satisfies all the conditions of (1) to (4).

(1) transmittance at a wavelength of 400 nm is preferably 70% or more, more preferably 80% or more, still more preferably 85% or more, and particularly preferably 90% or more.
(2) transmittance at a wavelength of 500 nm is preferably 70% or more, more preferably 80% or more, still more preferably 90% or more, and particularly preferably 95% or more.
(3) transmittance at a wavelength of 600 nm is preferably 70% or more, more preferably 80% or more, still more preferably 90% or more, and particularly preferably 95% or more.
(4) transmittance at a wavelength of 650 nm is preferably 70% or more, more preferably 80% or more, still more preferably 90% or more, and particularly preferably 95% or more.
In a case where the film according to the embodiment of the present disclosure is used as an infrared transmitting filter, the film according to the embodiment of the present disclosure preferably satisfies at least one condition of the following (5) to (8).
(5) maximum value of the transmittance at a wavelength of 450 to 800 nm is 20% or less, and the minimum value of the transmittance at a wavelength of 900 to 1200 nm is 70% or more.
(6) maximum value of the transmittance at a wavelength of 450 to 850 nm is 20% or less, and the minimum value

of the transmittance at a wavelength of 950 to 1200 nm is 70% or more.
(7) maximum value of the transmittance at a wavelength of 450 to 950 nm is 20% or less, and the minimum value of the transmittance at a wavelength of 1050 to 1200 nm is 70% or more.
(8) maximum value of the transmittance at a wavelength of 450 to 1050 nm is 20% or less, and the minimum value of the transmittance at a wavelength of 1150 to 1200 nm is 70% or more.

The film according to the embodiment of the present disclosure can be used in combination with a color filter including a chromatic colorant.

Here, the color filter can be manufactured using a coloring composition including a chromatic colorant. Examples of the chromatic colorant include known chromatic colorants in the related art. The coloring composition can further contain a resin, a polymerizable compound, a polymerization initiator, a surfactant, a solvent, a polymerization inhibitor, an ultraviolet absorber, and the like, in addition to the chromatic colorant. As each component contained in the coloring composition, in addition to each known component in the related art, each component described above may be appropriately used.

In a case where the film according to the embodiment of the present disclosure and the color filter are used in combination, it is preferable that the color filter is disposed on an optical path of the film according to the embodiment of the present disclosure. For example, the film according to the embodiment of the present disclosure and the color filter can be laminated to be used as a laminate. In the laminate, the film according to the embodiment of the present disclosure and the color filter may be or may not be adjacent to each other in a thickness direction. In a case where the film according to the embodiment of the present disclosure is not adjacent to the color filter in the thickness direction, the film according to the embodiment of the present disclosure may be formed on another support other than a support on which the color filter is formed, or another member (for example, a microlens or a planarizing layer) constituting a solid-state imaging element may be interposed between the film according to the embodiment of the present disclosure and the color filter.

In the present disclosure, an infrared cut filter refers to a filter which allows transmission of light (visible light) in the visible range and shields at least a part of light (infrared rays) in the near infrared region. The infrared cut filter may be a filter which allows transmission of light in the entire wavelength range of the visible range, or may be a filter which allows transmission of light in a specific wavelength range of the visible range and shields light in another specific wavelength range of the visible range. In addition, in the present disclosure, a color filter refers to a filter which allows transmission of light in a specific wavelength range of the visible range and shields light in another specific wavelength range of the visible range. In addition, in the present disclosure, an infrared transmitting filter refers to a filter which shields visible light and allows transmission of at least a part of near-infrared rays.

The film according to the embodiment of the present disclosure can be used in various devices including a solid-state imaging element such as a charge coupled device (CCD) or a complementary metal-oxide semiconductor (CMOS), an infrared sensor, or an image display device.

<Method for producing film>

Next, a method for manufacturing the film according to the embodiment of the present disclosure will be described. The film according to the embodiment of the present disclosure can be manufactured through a step of applying the composition according to the embodiment of the present disclosure.

In the method for manufacturing the film according to the embodiment of the present disclosure, it is preferable that the composition is applied to a support. Examples of the support include a substrate formed of a material such as silicon, non-alkali glass, soda glass, PYREX (registered trademark) glass, or quartz glass. For example, an organic film or an inorganic film may be formed on the substrate. Examples of a material of the organic film include the resins described above. In addition, as the support, a substrate formed of the above-described resin can also be used. In addition, a charge coupled device (CCD), a complementary metal-oxide semiconductor (CMOS), a transparent conductive film, or the like may be formed on the support. In addition, a black matrix which separates pixels from each other may be formed on the support. In addition, optionally, an undercoat layer may be provided on the support to improve adhesiveness with a layer above the support, to prevent diffusion of materials, or to planarize the surface of the support such as a substrate. In addition, in a case where a glass substrate is used as the support, it is preferable that an inorganic film is formed on the glass substrate or the glass substrate may be dealkalized to be used. According to this aspect, it is easy to manufacture a film in which the generation of foreign matters is further suppressed.

As a method of applying the composition, a known method can be used. Examples thereof include a dropping method (drop casting); a slit coating method; a spray method; a roll coating method; a spin coating method (spin coating); a cast coating method; a slit and spin method; a pre-wet method (for example, a method described in JP2009-145395A), various printing methods such as an ink jet (for example, on-demand type, piezo type, thermal type), a discharge printing such as nozzle jet, a flexo printing, a screen printing, a gravure printing, a reverse offset printing, and a metal mask

printing; a transfer method using molds and the like; and a nanoimprinting method. A method for applying the ink jet is not particularly limited, and examples thereof include a method described in "Extension of Use of Ink Jet -Infinite Possibilities in Patent-" (February, 2005, S. B. Research Co., Ltd.) (particularly, pp. 115 to 133) and methods described in JP2003-262716A, JP2003-185831A, JP2003-261827A, JP2012-126830A, and JP2006-169325A.

A composition layer formed by applying the composition may be dried (pre-baked). In a case where a pattern is formed through a low-temperature process, pre-baking is not necessarily performed. In a case of performing the pre-baking, the pre-baking temperature is preferably 150°C or lower, more preferably 120°C or lower, and still more preferably 110°C or lower. The lower limit is, for example, preferably 50°C or higher and more preferably 80°C or higher. By setting the pre-baking temperature to be 150°C or lower, the characteristics can be effectively maintained, for example, even in a case where a photoelectric conversion film of an image sensor is formed of an organic material.

The pre-baking time is preferably 10 seconds to 3,000 seconds, more preferably 40 seconds to 2,500 seconds, and still more preferably 80 seconds to 220 seconds. Drying can be performed using a hot plate, an oven, or the like.

The method of manufacturing the film according to the embodiment of the present disclosure may further include a step of forming a pattern. Examples of a pattern forming method include a pattern forming method using a photolithography method or a pattern forming method using a dry etching method. In a case where the film according to the embodiment of the present disclosure is used as a flat film, the step of forming a pattern is not necessarily performed. Hereinafter, the step of forming a pattern will be described in detail.

-Case where pattern is formed using photolithography method-

It is preferable that the pattern forming method using a photolithography method includes: a step (exposing step) of exposing the composition layer, which is formed by applying the composition according to the embodiment of the present disclosure, in a patterned manner; and a step (developing step) of forming a pattern by removing a non-exposed portion of the composition layer by development. Optionally, the pattern forming method may further include a step (post-baking step) of baking the developed pattern. Hereinafter, the respective steps will be described.

«Exposing Step»

In the exposing step, the composition layer is exposed in a patterned manner. For example, the composition layer can be exposed in a pattern shape using an exposure device such as a stepper through a mask having a predetermined mask pattern. Thus, the exposed portion can be cured. As radiation (light) used during the exposure, ultraviolet rays such as g-rays or i-rays are preferable, and i-rays are more preferable. For example, the irradiation amount (exposure amount) is preferably 0.03 $J/cm^2$ to 2.5 $J/cm^2$, more preferably 0.05 $J/cm^2$ to 1.0 $J/cm^2$, and particularly preferably 0.08 $J/cm^2$ to 0.5 $J/cm^2$. The oxygen concentration during the exposure can be appropriately selected, and the exposure may also be performed, for example, in a low-oxygen atmosphere having an oxygen concentration of 19% by volume or less (for example, 15% by volume, 5% by volume, and substantially oxygen-free) or in a high-oxygen atmosphere having an oxygen concentration of more than 21% by volume (for example, 22% by volume, 30% by volume, and 50% by volume), in addition to an atmospheric air. In addition, the exposure illuminance can be appropriately set, and can be preferably selected from a range of 1,000 $W/m^2$ to 100,000 $W/m^2$ (for example, 5,000 $W/m^2$, 15,000 $W/m^2$, or 35,000 $W/m^2$). Appropriate conditions of each of the oxygen concentration and the exposure illuminance may be combined, and for example, a combination of the oxygen concentration of 10% by volume and the illuminance of 10,000 $W/m^2$, a combination of the oxygen concentration of 35% by volume and the illuminance of 20,000 $W/m^2$, or the like is available.

«Developing Step»

Next, a pattern is formed by removing a non-exposed portion of the exposed composition layer by development. The non-exposed portion of the composition layer can be removed by development using a developer. As a result, a non-exposed portion of the composition layer in the exposing step is eluted into the developer, and only the photocured portion remains on the support. As the developer, an alkali developer which does not cause damages to a solid-state imaging element, a circuit, or the like of a base is desired. The temperature of the developer is preferably, for example, 20°C to 30°C. The development time is preferably 20 seconds to 180 seconds. In addition, in order to improve residue removing properties, a step of removing the developer by shaking off per 60 seconds and supplying a fresh developer may be repeated multiple times.

Examples of the alkali agent used in the developer include organic alkaline compounds such as ammonia water, ethylamine, diethylamine, dimethylethanolamine, diglycol amine, diethanolamine, hydroxyamine, ethylenediamine, tetramethylammonium hydroxide, tetraethylammonium hydroxide, tetrapropylammonium hydroxide, tetrabutylammonium hydroxide, benzyltrimethylammonium hydroxide, dimethylbis(2-hydroxyethyl)ammonium hydroxide, choline, pyrrole, piperidine, and 1,8-diazabicyclo[5.4.0]-7-undecene, and inorganic alkaline compounds such as sodium hydroxide, potassium hydroxide, sodium carbonate, sodium hydrogen carbonate, sodium silicate, and sodium metasilicate. As the developer, an aqueous alkaline solution obtained by diluting these alkali agents with pure water is preferably used. The concentration of the alkali agent in the aqueous alkaline solution is preferably 0.001 mass% to 10 mass% and more preferably 0.01 mass% to 1 mass%. In addition, a surfactant may be used as the developer. Examples of the surfactant include known surfactants in the related art, used in a developer, and a nonionic surfactant is preferable. From the viewpoint of transportation, storage, and the like, the developer may be first produced as a concentrated liquid and then diluted to a concentration required upon the use. The dilution ratio is not particularly limited, and can be set to, for example, a range of 1.5 times to 100 times. In addition, in a case where a developer consisting of such an aqueous alkaline solution is used, it is preferable to perform washing (rinsing) with pure water after development.

After the development, the film can also be dried and then heat-treated (post-baking). Post-baking is a heating treatment which is performed after development to completely cure the film. In a case where post-baking is performed, for example, the post-baking temperature is preferably 100°C to 240°C. From the viewpoint of curing the film, the post-baking temperature is more preferably 200°C to 230°C. In addition, in a case where an organic electroluminescence (organic EL) element is used as a light-emitting light source, or in a case where a photoelectric conversion film of an image sensor is formed of an organic material, the post-baking temperature is preferably 150°C or lower, more preferably 120°C or lower, still more preferably 100°C or lower, and particularly preferably 90°C or lower. The lower limit is, for example, 50°C or higher. The post-baking can be performed continuously or batchwise by using a heating unit such as a hot plate, a convection oven (hot-air circulation dryer), and a high-frequency heater so that the film after development satisfies the conditions. In addition, in a case of forming a pattern by a low-temperature process, the post-baking may not be performed, or a step of re-exposure (post-exposing step) may be added.

-Case where pattern is formed using dry etching method-

The formation of a pattern using a dry etching method can be performed using a method including: applying the composition to a support or the like to form a composition layer; curing the formed composition layer to form a cured composition layer; forming a patterned photoresist layer on the cured composition layer; and dry-etching the cured composition layer with etching gas by using the patterned photoresist layer as a mask. It is preferable that pre-baking treatment is further performed in order to form the photoresist layer. In particular, as the forming process of the photoresist, it is desirable that a heat treatment after exposure and a heating treatment after development (post-baking treatment) are performed. The details of the pattern formation by the dry etching method can be found in paragraphs 0010 to 0067 of JP2013-64993A, the content of which is incorporated herein by reference.

<Optical filter>

The optical filter according to an embodiment of the present disclosure includes the film according to the embodiment of the present disclosure.

The optical filter according to the embodiment of the present disclosure can be preferably used as an infrared cut filter or an infrared transmitting filter, and more preferably used as an infrared cut filter.

In addition, a preferred aspect of the optical filter according to the embodiment of the present disclosure is also an aspect of including the film according to the embodiment of the present disclosure and a pixel selected from the group consisting of red, green, blue, magenta, yellow, cyan, black, and colorless.

The infrared cut filter according to an embodiment of the present disclosure includes the film according to the embodiment of the present disclosure.

The infrared cut filter according to the embodiment of the present disclosure may be a filter which cuts only infrared rays having a wavelength of a part of the infrared range, or a filter which cuts the entire infrared range. Examples of the filter which cuts only infrared rays having a wavelength of a part of the infrared range include a near-infrared cut filter. Examples of the near-infrared rays include infrared rays having a wavelength of 750 nm to 2,500 nm.

In addition, the infrared cut filter according to the embodiment of the present disclosure is preferably a filter which cuts infrared rays in a wavelength range of 750 nm to 1,000 nm, more preferably a filter which cuts infrared rays in a wavelength range of 750 nm to 1,200 nm, and still more preferably a filter which cuts infrared rays in a wavelength range of 750 nm to 1,500 nm.

The infrared cut filter according to the embodiment of the present disclosure may further include a layer containing copper, a dielectric multi-layer film, an ultraviolet absorbing layer, or the like, in addition to the above-described film. In a case where the infrared cut filter according to the embodiment of the present disclosure further includes at least a layer containing copper or a dielectric multi-layer film, it is easy to obtain an infrared cut filter having a wide viewing angle and excellent infrared shielding properties. In addition, in a case where the infrared cut filter according to the embodiment of the present disclosure further includes an ultraviolet absorbing layer, an infrared cut filter having excellent ultraviolet shielding properties can be obtained. The details of the ultraviolet absorbing layer can be found in

the description of an absorbing layer described in paragraphs 0040 to 0070 and 0119 to 0145 of WO2015/099060A, the content of which is incorporated herein by reference. The details of the dielectric multi-layer film can be found in paragraphs 0255 to 0259 of JP2014-41318A, the content of which is incorporated herein by reference. As the layer containing copper, a glass base material (copper-containing glass base material) formed of glass containing copper, or a layer (copper complex-containing layer) containing a copper complex may also be used. Examples of the copper-containing glass base material include a phosphate glass including copper and a fluorophosphate glass including copper. Examples of a commercially available product of the copper-containing glass include NF-50 (manufactured by AGC Techno Glass Co., Ltd.), BG-60 and BG-61 (both of which are manufactured by Schott AG), and CD5000 (manufactured by Hoya Corporation).

The infrared cut filter according to the embodiment of the present disclosure can be used in various devices including a solid-state imaging element such as a charge coupled device (CCD) or a complementary metal-oxide semiconductor (CMOS), an infrared sensor, or an image display device.

It is also preferable that the infrared cut filter according to the embodiment of the present disclosure has a pixel (pattern) of the film obtained using the composition according to the embodiment of the present disclosure, and at least one pixel (pattern) selected from the group consisting of red, green, blue, magenta, yellow, cyan, black, and colorless.

A method for manufacturing the optical filter according to the embodiment of the present disclosure is not particularly limited, but a method including a step of applying the composition according to the embodiment of the present disclosure on a support to form a composition layer, a step of exposing the composition layer in a patterned manner, and a step of removing a non-exposed portion by development to form a pattern is preferable.

In addition, as the method for manufacturing the optical filter according to the embodiment of the present disclosure, a method including a step of applying the composition according to the embodiment of the present disclosure on a support to form a composition layer, curing the composition to form a layer, a step of forming a photoresist layer on the layer, a step of obtaining a resist pattern by patterning the photoresist layer by exposure and development, and a step of dry-etching the layer using the resist pattern as an etching mask is also preferable.

As each step in the method for manufacturing the optical filter according to embodiment of the present disclosure, the each step in the method for manufacturing the film according to the embodiment of the present disclosure can be referred to.

<Solid-state imaging element>

The solid-state imaging element according to an embodiment of the present disclosure includes the film according to the embodiment of the present disclosure. The configuration of the solid-state imaging element is not particularly limited as long as it includes the film according to the embodiment of the present disclosure and functions as a solid-state imaging element. For example, the following configuration can be adopted.

The solid-state imaging element includes a plurality of photodiodes and transfer electrodes on the support, the photodiodes constituting a light receiving area of the solid-state imaging element, and the transfer electrode including polysilicon or the like. In the solid-state imaging element, a light-shielding film including tungsten or the like which has openings through only light receiving sections of the photodiodes is provided on the photodiodes and the transfer electrodes, a device protective film including silicon nitride or the like is formed on the light-shielding film so as to cover the entire surface of the light-shielding film and the light receiving sections of the photodiodes, and the film according to the embodiment of the present disclosure is formed on the device protective film. Further, the solid-state imaging element may also be configured, for example, such that it has a light collecting unit (for example, a microlens, which is the same hereinafter) on the device protective film under the film according to the embodiment of the present disclosure (a side closer to the support), or has a light collecting unit on the film according to the embodiment of the present disclosure. In addition, the color filter used in the solid-state imaging element may have a structure in which a film which forms each pixel is embedded in a space which is partitioned in, for example, a lattice form by a partition wall. In this case, it is preferable that the partition wall has a lower refractive index than each pixel. Examples of an imaging apparatus having such a structure include devices described in JP2012-227478A and JP2014-179577A.

<Image display device>

The image display device according to an embodiment of the present disclosure includes the film according to the embodiment of the present disclosure. Examples of the image display device include a liquid crystal display device or an organic electroluminescence (organic EL) display device. The definition and details of the image display device can be found in, for example, "Electronic Display Device (written by Akio Sasaki, Kogyo Chosakai Publishing Co., Ltd., published in 1990)" or "Display Device (written by Sumiaki Ibuki, Sangyo Tosho Co., Ltd., published in 1989). In addition, the liquid crystal display device is described in, for example, "Liquid Crystal Display Technology for Next Generation (edited by Tatsuo Uchida, Kogyo Chosakai Publishing Co., Ltd., published in 1994)". The liquid crystal display device

to which the present disclosure can be applied is not particularly limited, and can be applied to, for example, liquid crystal display devices employing various systems described in the "Liquid Crystal Display Technology for Next Generation". The image display device may be an image display device having a white organic EL element. It is preferable that the white organic EL element has a tandem structure. The tandem structure of the organic EL element is described in, for example, JP2003-45676A, or pp. 326 to 328 of "Forefront of Organic EL Technology Development -Know-How Collection of High Brightness, High Precision, and Long Life" (Technical Information Institute, 2008). It is preferable that a spectrum of white light emitted from the organic EL element has high maximum emission peaks in a blue range (430 nm to 485 nm), a green range (530 nm to 580 nm), and a yellow range (580 nm to 620 nm). It is more preferable that the spectrum has a maximum emission peak in a red range (650 nm to 700 nm) in addition to the above-described emission peaks.

<Infrared sensor>

The infrared sensor according to an embodiment of the present disclosure includes the film according to the embodiment of the present disclosure. The configuration of the infrared sensor is not particularly limited as long as it functions as an infrared sensor. Hereinafter, the embodiment of the infrared sensor according to the present disclosure will be described using the drawing.

In Fig. 1, reference numeral 110 represents a solid-state imaging element. In an imaging region provided on the solid-state imaging element 110, infrared cut filters 111 and infrared transmitting filters 114 are provided. In addition, color filters 112 are laminated on the infrared cut filters 111. Microlenses 115 are disposed on an incidence ray hν side of the color filters 112 and the infrared transmitting filters 114. A planarizing layer 116 is formed so as to cover the microlenses 115.

The infrared cut filter 111 can be formed of the composition according to the embodiment of the present disclosure. Spectral characteristics of the infrared cut filters 111 can be selected according to a luminescence wavelength of an infrared light emitting diode (infrared LED) to be used.

The color filter 112 is not particularly limited as long as pixels which allow transmission of light having a specific wavelength in a visible range and absorbs the light are formed therein, and known color filters in the related art for forming a pixel can be used. For example, pixels of red (R), green (G), and blue (B) are formed in the color filters. For example, the details of the color filters can be found in paragraphs 0214 to 0263 of JP2014-43556A, the content of which is incorporated herein by reference.

Characteristics of the infrared transmitting filters 114 can be selected according to the luminescence wavelength of the infrared LED to be used. For example, in a case where the luminescence wavelength of the infrared LED is 850 nm, the infrared transmitting filter 114 preferably has 30% or less of a maximum value of the light transmittance in the film thickness direction in a wavelength range of 400 nm to 650 nm, more preferably has 20% or less thereof, still more preferably has 10% or less thereof, and particularly preferably has 0.1% or less thereof. It is preferable that the transmittance satisfies the above-described conditions in the entire range of the wavelength range of 400 nm to 650 nm.

In addition, the infrared transmitting filter 114 preferably has 70% or more of a minimum value of the light transmittance in the film thickness direction in a wavelength range of 800 nm or more (preferably 800 nm to 1,300 nm), more preferably 80% or more thereof, and still more preferably 90% or more thereof. The above-described transmittance preferably satisfies the above-described conditions in a part of the wavelength range of 800 nm or more, and more preferably satisfies the above-described conditions at a wavelength corresponding to the luminescence wavelength of the infrared LED.

The film thickness of the infrared transmitting filter 114 is preferably 100 μm or less, more preferably 15 μm or less, still more preferably 5 μm or less, and particularly preferably 1 μm or less. The lower limit value is preferably 0.1 μm. In a case where the film thickness is within the above-described range, a film satisfying the above-described spectral characteristics can be obtained.

A method for measuring the spectral characteristics, film thickness, and the like of the infrared transmitting filter 114 are as follows.

The film thickness is measured by using a stylus type surface shape measuring device (DEKTAK150 manufactured by ULVAC, Inc.) on a dried substrate having the film.

The spectral characteristics of the film are values obtained by measuring the transmittance in a wavelength range of 300 nm to 1,300 nm using an ultraviolet-visible-near infrared spectrophotometer (U-4100 manufactured by Hitachi High-Tech Corporation).

In addition, for example, in a case where the luminescence wavelength of the infrared LED is 940 nm, the infrared transmitting filter 114 preferably has 20% or less of a maximum value of the light transmittance in the film thickness direction in a wavelength range of 450 nm to 650 nm, and it is preferable that the light transmittance in the film thickness direction at a wavelength of 835 nm is 20% or less and the minimum value of the light transmittance in the film thickness direction in a wavelength of 1,000 nm to 1,300 nm is 70% or more.

In the infrared sensor shown in Fig. 1, an infrared cut filter (other infrared cut filters) other than the infrared cut

filter 111 may be further disposed on the planarizing layer 116. Examples of the other infrared cut filters include an infrared cut filter including at least a layer containing copper or a dielectric multi-layer film. The details of the examples are as described above. In addition, as the other infrared cut filters, a dual band pass filter may be used.

In addition, the absorption wavelengths of the infrared transmitting filter and infrared cut filter used in the present disclosure are appropriately used in combination according to a light source and the like to be used.

<Sensor module>

The sensor module according to an embodiment of the present disclosure includes a photoelectric conversion element and the optical filter according to the embodiment of the present disclosure.

The sensor module according to the embodiment of the present disclosure is not particularly limited as long as it includes a photoelectric conversion element and the optical filter according to the embodiment of the present disclosure, and has a configuration which functions as a sensor module. For example, it is preferable that the sensor module according to the embodiment of the present disclosure further includes a lens, a circuit for processing information obtained from the photoelectric conversion element, and the like, in addition to the photoelectric conversion element and the optical filter.

Examples of use of the sensor module according to the embodiment of the present disclosure include biometric authentication, surveillance, mobile, automobile, agriculture, medical care, distance measurement, gesture recognition, augmented reality, and virtual reality.

The sensor module according to the embodiment of the present disclosure may be a camera module which includes a solid-state imaging element and the optical filter according to the embodiment of the present disclosure.

In addition, it is preferable that the camera module further includes a lens and a circuit for processing an image obtained from the above-described solid-state imaging element, in addition to the solid-state imaging element and the optical filter.

The solid-state imaging element used in the camera module in the present disclosure may be the above-described solid-state imaging element according to the embodiment of the present disclosure, or a known solid-state imaging element.

In addition, as the lens and the circuit for processing an image obtained from the above-described solid-state imaging element used in the camera module in the present disclosure, known ones can be used.

Examples of the camera module include camera modules described in JP2016-6476A or JP2014-197190A, the contents of which are incorporated herein by reference.

<Other uses>

In addition, the curable composition in the present disclosure can also be used for paints, inkjet inks, security inks, and the like.

Further, the curable composition in the present disclosure can also be used as a heat shield material, a heat storage material, or a photothermal conversion material.

Examples

Hereinafter, the present disclosure will be described in detail with reference to examples, but the present disclosure is not limited thereto.

In the examples, "%" and "parts" respectively indicate "mass%" and "parts by mass" unless otherwise specified. In a polymer compound, the molecular weight indicates the weight-average molecular weight (Mw) and the proportion of constitutional units indicates mole percentage unless otherwise specified.

The weight-average molecular weight (Mw) is a value in terms of polystyrene obtained by performing measurement using a gel permeation chromatography (GPC) method.

<Preparation of pigment dispersion liquid>

A pigment, a pigment derivative, a dispersant, and a solvent of the types shown in Table 1 below were mixed with each other in the amounts (part by mass) shown in Table 1 below, 230 parts by mass of zirconia beads having a diameter of 0.3 mm was further added thereto, the mixture was dispersed using a paint shaker for 5 hours, and the beads were separated by filtration, thereby producing each pigment dispersion liquid.

[Table 1]

| | Pigment | | Pigment derivative | | Dispersant | | Solvent | |
|---|---|---|---|---|---|---|---|---|
| | Type | Part by mass | Type | Part by mass | Name | Part by mass | Name | Part by mass |
| Dispersion liquid 001 | P-1 | 12 | Syn-1 | 3 | D-1 | 6 | S-1 | 79 |
| Dispersion liquid 002 | P-1 | 12 | Syn-2 | 3 | D-1 | 6 | S-1 | 79 |
| Dispersion liquid 003 | P-1 | 12 | Syn-3 | 3 | D-1 | 6 | S-1 | 79 |
| Dispersion liquid 004 | P-1 | 12 | Syn-4 | 3 | D-1 | 6 | S-1 | 79 |
| Dispersion liquid 005 | P-1 | 12 | Syn-5 | 3 | D-4 | 6 | S-1 | 79 |
| Dispersion liquid 006 | P-2 | 12 | Syn-6 | 3 | D-1 | 6 | S-1 | 79 |
| Dispersion liquid 007 | P-2 | 12 | Syn-6 | 3 | D-2 | 6 | S-1 | 79 |
| Dispersion liquid 008 | P-2 | 12 | Syn-6 | 3 | D-3 | 6 | S-1 | 79 |
| Dispersion liquid 009 | P-5 | 8 | Syn-7 | 3 | D-1 | 6 | S-1 | 79 |
| | P-8 | 4 | | | | | | |
| Dispersion liquid 010 | P-6 | 8 | Syn-8 | 3 | D-1 | 6 | S-1 | 79 |
| | P-7 | 4 | | | | | | |
| Dispersion liquid 011 | P-8 | 12 | Syn-7 | 3 | D-1 | 6 | S-1 | 79 |
| Dispersion liquid 012 | P-9 | 12 | Syn-7 | 3 | D-1 | 6 | S-1 | 79 |
| Dispersion liquid 013 | P-1 | 24 | Syn-1 | 6 | D-1 | 12 | S-1 | 58 |
| Dispersion liquid 014 | P-1 | 4 | Syn-1 | 1 | D-1 | 2 | S-1 | 93 |
| Dispersion liquid 015 | P-1 | 9 | Syn-1 | 6 | D-1 | 6 | S-1 | 79 |
| Dispersion liquid 016 | P-1 | 13.5 | Syn-1 | 1.5 | D-1 | 6 | S-1 | 79 |
| Dispersion liquid 017 | P-1 | 12 | Syn-1 | 3 | D-1 | 15 | S-1 | 70 |
| Dispersion liquid 018 | P-1 | 12 | Syn-1 | 3 | D-1 | 3 | S-1 | 82 |
| Dispersion liquid 019 | P-1 | 6 | Syn-1 | 1.5 | D-1 | 6 | S-1 | 79 |
| | P-2 | 6 | Syn-3 | 1.5 | | | | |
| Dispersion liquid 020 | P-1 | 12 | Syn-1 | 1.5 | D-1 | 6 | S-1 | 79 |
| | | | Syn-2 | 1.5 | | | | |
| Dispersion liquid 021 | P-1 | 12 | Syn-1 | 3 | D-1 | 3 | S-1 | 79 |
| | | | | | D-2 | 3 | | |
| Dispersion liquid 022 | P-1 | 12 | Syn-1 | 3 | D-1 | 6 | S-1 | 39.5 |
| | | | | | | | S-2 | 39.5 |
| Dispersion liquid 023 | P-3 | 12 | Syn-11 | 3 | D-1 | 6 | S-1 | 79 |
| Dispersion liquid 024 | P-3 | 12 | Syn-9 | 3 | D-1 | 6 | S-1 | 79 |
| Dispersion liquid 025 | P-3 | 12 | Syn-12 | 3 | D-5 | 6 | S-1 | 79 |
| Dispersion liquid 026 | P-3 | 12 | Syn-11 | 3 | D-6 | 6 | S-1 | 79 |
| Dispersion liquid 027 | P-3 | 12 | Syn-11 | 3 | D-7 | 6 | S-1 | 79 |
| Dispersion liquid 028 | P-3 | 12 | Syn-10 | 3 | D-4 | 6 | S-1 | 79 |

Raw materials shown in Tables 2 to 8 shown below, including the obtained pigment dispersion liquid, were mixed in the amounts (part by mass) shown in Tables 2 to 8 below, and the obtained mixture was filtered using a nylon filter (manufactured by Nihon Pall Corporation) having a pore size of 0.45 μm to prepare a curable composition.

[Table 2]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 1 | Dispersion liquid 001 | 13 | M-1 | 4.2 | B-1 | 0.2 | 1-2 | 1 | A-2 | 0.6 | Su-1 | 0.0005 | In-1 | 0.02 | S-1 | 27.3 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |
| Example 2 | Dispersion liquid 002 | 13 | M-1 | 4.2 | B-1 | 0.2 | 1-2 | 1 | A-2 | 0.6 | Su-1 | 0.0005 | In-1 | 0.02 | S-1 | 27.3 | 4 | 4 | 4 | Visible to IR region |
| | Dispersion liquid 009 | 40 | | | | | | | | | | | | | | | | | | |
| | Dispersion liquid 010 | 13 | | | | | | | | | | | | | | | | | | |
| Example 3 | 003 | 13 | M-1 | 4.2 | B-1 | 23 | 1-2 | 1 | A-2 | 0.6 | Su-1 | 0.0005 | In-1 | 0.02 | S-1 | 27.3 | 5 | 3 | 3 | Visible to IR region |
| | Dispersion liquid Dispersion liquid 009 | 13 | | | | | | | | | | | | | | | | | | |
| | Dispersion liquid 010 | 40 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 4 | Dispersion liquid 002 | 13 | M-1 | 4.2 | B-1 | 0.2 | 1-2 | 1 | A-2 | 0.6 | Su-1 | 0.0005 | In-1 | 0.02 | S-1 | 27.3 | 5 | 3 | 4 | Visible to IR region |
| | Dispersion liquid 009 | 27 | | | | | | | | | | | | | | | | | | |
| | Dispersion liquid 010 | 27 | | | | | | | | | | | | | | | | | | |
| Example 5 | Dispersion liquid 003 | 13 | M-1 | 4.2 | B-1 | | 1-2 | 1 | A-2 | 0.6 | Su-1 | 0.0005 | In-1 | 0.02 | S-1 | 27.3 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |
| Example 6 | Dispersion liquid 004 | 13 | M-1 | 4.2 | B-1 | 0.2 | 1-2 | 1 | A-2 | 0.6 | Su-1 | 0.0005 | In-1 | 0.02 | S-1 | 27.3 | 4 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 7 | Dispersion liquid 005 | 13 | M-1 | 4.2 | B-1 | 0.2 | 1-2 | 1 | A-2 | 0.6 | Su-1 | 0.0005 | In-1 | 0.02 | S-1 | 27.3 | 4 | 4 | 4 | Visible to IR region |
| | Dispersion liquid 009 | 27 | | | | | | | | | | | | | | | | | | |
| | Dispersion liquid 010 | 27 | | | | | | | | | | | | | | | | | | |
| Example 8 | Dispersion liquid 006 | 13 | M-1 | 4.2 | B-1 | 0.2 | 1-2 | 1 | A-2 | 0.6 | Su-1 | 0.0005 | In-1 | 0.02 | S-1 | 27.3 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |
| Example 9 | Dispersion liquid 007 | 13 | M-1 | 4.2 | B-1 | 0.2 | 1-2 | 1 | A-2 | 0.6 | Su-1 | 0.0005 | In-1 | 0.02 | S-1 | 27.3 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 10 | Dispersion liquid 008 | 13 | M-1 | 4.2 | B-1 | 0.2 | 1-2 | 1 | A-2 | 0.6 | Su-1 | 0.0005 | In-1 | 0.02 | S-1 | 27.3 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |

[Table 3]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 11 | Dispersion liquid 009 | 27 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible region |
| Example 12 | Dispersion liquid 010 | 27 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible region |
| Example 13 | Dispersion liquid 011 | 27 | M-1 | 7.2 | B-1 | 5.6 | 1-2 | 1 | A-2 | 0.6 | Su-1 | 0.0005 | In-1 | 0.02 | S-1 | 58.9 | 5 | 4 | 4 | Visible region |
| Example 14 | Dispersion liquid 012 | 27 | M-1 | 7.2 | B-1 | 5.6 | 1-2 | 1 | A-2 | 0.6 | Su-1 | 0.0005 | In-1 | 0.02 | S-1 | 58.9 | 5 | 4 | 4 | Visible region |
| Example 15 | Dispersion liquid 013 | 7 | M-1 | 4.2 | B-1 | 0.2 | 1-2 | 1 | A-2 | 0.6 | Su-1 | 0.0005 | In-1 | 0.02 | S-1 | 34 | 5 | 5 | 5 | Visible to IR region |
| | Dispersion liquid 009 | 27 | | | | | | | | | | | | | | | | | | |
| | Dispersion liquid 010 | 27 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 16 | Dispersion liquid 014 | 16 | M-1 | 7.2 | B-1 | 5.6 | 1-2 | 1 | A-2 | 0.6 | Su-1 | 0.0005 | In-1 | 0.02 | S-1 | 48.2 | 5 | 5 | 5 | Visible to IR region |
| | Dispersion liquid 009 Dispersion liquid 010 | 11 11 | | | | | | | | | | | | | | | | | | |
| Example 17 | Dispersion liquid 016 | 5 | M-1 | 7.2 | B-1 | 5.6 | 1-2 | 1 | A-2 | 0.6 | Su-1 | 0.0005 | In-1 | 0.02 | S-1 | 58.9 | 3 | 5 | 4 | Visible to IR region |
| | Dispersion liquid 009 Dispersion liquid 010 | 11 11 | | | | | | | | | | | | | | | | | | |
| Example 18 | Dispersion liquid 017 | 5 | M-1 | 7.2 | B-1 | 5.1 | 1-2 | 1 | A-2 | 0.6 | Su-1 | 0.0005 | In-1 | 0.02 | S-1 | 59.4 | 5 | 3 | 4 | Visible to IR region |
| | Dispersion liquid 009 Dispersion liquid 010 | 11 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 19 | Dispersion liquid 018 | 5 | M-1 | 7.2 | B-1 | 5.7 | 1-2 | 1 | A-2 | 0.6 | Su-1 | 0.0005 | In-1 | 0.02 | S-1 | 58.8 | 5 | 5 | 5 | Visible to IR region |
| | Dispersion liquid 009 Dispersion liquid 010 | 11 11 | | | | | | | | | | | | | | | | | | |
| Example 20 | Dispersion liquid 019 | 5 | M-1 | 7.2 | B-1 | 5.6 | 1-2 | 1 | A-2 | 0.6 | Su-1 | 0.0005 | In-1 | 0.02 | S-1 | 58.9 | 5 | 4 | 4 | Visible to IR region |
| | Dispersion liquid 009 Dispersion liquid 010 | 11 11 | | | | | | | | | | | | | | | | | | |
| Example 21 | Dispersion liquid 011 | 5 | M-1 | 7.2 | B-1 | 5.6 | 1-2 | 1 | A-2 | 0.6 | Su-1 | 0.0005 | In-1 | 0.02 | S-1 | 58.3 | 5 | 4 | 4 | Visible to IR region |
| | Dispersion liquid 009 Dispersion liquid 010 | 11 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 22 | Dispersion liquid 020 | 5 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 Dispersion liquid 010 | 11 11 | | | | | | | | | | | | | | | | | | |

[Table 4]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 23 | Dispersion liquid 021 | 5 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 24 | Dispersion liquid 022 | 5 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 25 | Dispersion liquid 023 | 5 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 26 | Dispersion liquid 001 | 11 | M-1 | 14.4 | B-1 | 11.2 | I-2 | 2 | A-2 | 1.2 | Su-1 | 0.0005 | In-1 | 0.04 | S-1 | 17.8 | 5 | 4 | 5 | Visible to IR region |
| | Dispersion liquid 009 | 21 | | | | | | | | | | | | | | | | | | |
| | Dispersion liquid 010 | 21 | | | | | | | | | | | | | | | | | | |
| Example 27 | Dispersion liquid 001 | 1 | M-1 | 1.8 | B-1 | 1.4 | I-2 | 0.25 | A-2 | 0.15 | Su-1 | 0.0005 | In-1 | 0.005 | S-1 | 89.7 | 5 | 4 | 5 | Visible to IR region |
| | Dispersion liquid 009 | 3 | | | | | | | | | | | | | | | | | | |
| | Dispersion liquid 010 | 3 | | | | | | | | | | | | | | | | | | |
| Example 28 | Dispersion liquid 001 | 11 | M-1 | 5.2 | B-1 | 2 | I-2 | 1 | A-2 | 0.6 | Su-1 | 0.0005 | In-1 | 0.02 | S-1 | 37.8 | 5 | 4 | 4 | Visible to IR region |
| | Dispersion liquid 009 | 21 | | | | | | | | | | | | | | | | | | |
| | Dispersion liquid 010 | 21 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 29 | Dispersion liquid 001 | 1 | M-1 | 8.7 | B-1 | 8.3 | 1-2 | 1 | A-2 | 0.6 | Su-1 | 0.0005 | In-1 | 0.02 | S-1 | 74.7 | 5 | 4 | 5 | Visible to IR region |
| | Dispersion liquid 009 | 3 | | | | | | | | | | | | | | | | | | |
| | Dispersion liquid 010 | 3 | | | | | | | | | | | | | | | | | | |
| Example 30 | Dispersion liquid 001 | 5 | M-1 | 8.6 | B-1 | 4.2 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 31 | Dispersion liquid 001 | 5 | M-1 | 4.8 | B-1 | 8 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

[Table 5]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 32 | Dispersion liquid 001 | 5 | M-1 | 6.7 | B-1 | 5.1 | 1-2 | 2 | A-2 | 0.6 | Su-1 | 0.0005 | In-1 | 0.02 | S-1 | 58.9 | 5 | 4 | 4 | Visible to IR region |
| | Dispersion liquid 009 | 11 | | | | | | | | | | | | | | | | | | |
| | Dispersion liquid 010 | 11 | | | | | | | | | | | | | | | | | | |
| Example 33 | Dispersion liquid 001 | 5 | M-1 | 7.4 | B-1 | 5.8 | 1-2 | 0.5 | A-2 | 0.6 | Su-1 | 0.0005 | In-1 | 0.02 | S-1 | 59 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 34 | Dispersion liquid 001 | 5 | M-1 | 7.2 | B-1 | 5.6 | 1-2 | 1 | A-2 | 0.6 | Su-1 | 0.001 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 35 | Dispersion liquid 001 | 5 | M-1 | 7.2 | B-1 | 5.6 | 1-2 | 1 | A-2 | 0.6 | Su-1 | 0.0001 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 36 | Dispersion liquid 001 | 5 | M-1 | 7.1 | B-1 | 5.5 | 1-2 | 1 | A-2 | 0.6 | Su-1 | 0.0005 | In-1 | 0.2 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 37 | Dispersion liquid 001 | 5 | M-1 | 7.2 | B-1 | 5.6 | 1-2 | 1 | A-2 | 0.6 | Su-1 | 0.0005 | In-1 | 0.002 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 38 | Dispersion liquid 001 | 13 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | IR region |
| | Dispersion liquid 002 | 13 | | | | | | | | | | | | | | | | | | |
| Example 39 | Dispersion liquid 001 | 27 | M-1 | 7.2 | B-1 | 5.6 | 1-2 | 1 | A-2 | 0.6 | Su-1 | 0.0005 | In-1 | 0.02 | S-1 | 58.9 | 5 | 5 | 5 | IR region |
| Example 40 | Dispersion liquid 001 | 13 | M-1 | 4.2 | B-1 | 0.2 | 1-2 | 1 | A-2 | 0.6 | Su-1 | 0.0005 | In-1 | 0.02 | S-1 | 27.3 | 5 | 4 | 4 | Visible to IR region |
| | Dispersion liquid 011 | 53 | | | | | | | | | | | | | | | | | | |
| Example 41 | Dispersion liquid 001 | 13 | M-1 | 4.2 | B-1 | 0.2 | 1-2 | 1 | A-2 | 0.6 | Su-1 | 0.0005 | In-1 | 0.02 | S-1 | 27.3 | 5 | 4 | 4 | Visible to IR region |
| | Dispersion liquid 012 | 53 | | | | | | | | | | | | | | | | | | |

[Table 6]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 42 | Dispersion liquid 001 | 5 | M-2 | 7.2 | B-2 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 43 | Dispersion liquid 001 | 5 | M-2 | 7.2 | B-3 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 44 | Dispersion liquid 001 | 5 | M-2 | 7.2 | B-2 | 2.8 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | B-3 | 2.8 | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 45 | Dispersion liquid 001 | 5 | M-2 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 46 | Dispersion liquid 001 | 5 | M-3 | 7.2 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 47 | Dispersion liquid 001 | 5 | M-4 | 3.6 | B-1 | 5.6 | 1-2 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | M-5 | 3.6 | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 48 | Dispersion liquid 001 | 5 | M-1 | 7.2 | B-1 | 5.6 | 1-3 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 49 | Dispersion liquid 001 | 5 | M-1 | 7.2 | B-1 | 5.6 | 1-4 | 1 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 50 | Dispersion liquid 001 | 5 | M-1 | 7.2 | B-1 | 5.6 | I-I | 0.5 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | I-5 | 0.5 | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisturc resistance reliability | Dispersion stability | Development residue | Absorption band |
| Example 51 | Dispersion liquid 001 | 5 | M-1 | 7.2 | B-1 | 5.6 | I-1 | 0.5 | A-2 | 0.6 | Su-1 | 0.0005 | In-1 | 0.02 | S-1 | 58.9 | 5 | 5 | 5 | Visible to IR region |
| | Dispersion liquid 009 | 11 | | | | | 1-6 | 0.5 | | | | | | | | | | | | |
| | Dispersion liquid 010 | 11 | | | | | | | | | | | | | | | | | | |

[Table 7]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 52 | Dispersion liquid 001 | 5 | M-1 | 7.0 | B-1 | 5.4 | 1-2 | 1 | A-1 | 1 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 53 | Dispersion liquid 001 | 5 | M-1 | 7.0 | B-1 | 5.4 | 1-2 | 1 | A-3 | 1 | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 54 | Dispersion liquid 001 | 5 | M-1 | 7.2 | B-1 | 5.6 | 1-2 | 1 | A-4 | 0.6 | Su-1 | 0.0005 | In-1 | 0.02 | S-1 | 58.9 | 5 | 4 | 4 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 55 | Dispersion liquid 001 | 5 | M-1 | 7.5 | B-1 | 5.9 | 1-2 | 1 | - | - | Su-1 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 56 | Dispersion liquid 001 | 5 | M-1 | 6.6 | B-1 | 5 | 1-2 | 1 | A-1 | 1 | Su-1 | 0.0005 | In-1 | 0.02 | S-1 | 58.9 | 5 | 5 | 4 | Visible to IR region |
| | Dispersion liquid 009 | 11 | | | | | | | A-2 | 0.2 | | | | | | | | | | |
| | Dispersion liquid 010 | 11 | | | | | | | A-4 | 0.6 | | | | | | | | | | |
| Example 57 | Dispersion liquid 001 | 5 | M-1 | 7.2 | B-1 | 5.6 | 1-2 | 1 | A-2 | 0.6 | Su-2 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 58 | Dispersion liquid 001 | 5 | M-1 | 7.2 | B-1 | 5.6 | 1-2 | 1 | A-2 | 0.6 | Su-3 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 59 | Dispersion liquid 001 | 5 | M-1 | 7.2 | B-1 | 5.6 | 1-2 | 1 | A-2 | 0.6 | Su-4 | 0.0005 | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 60 | Dispersion liquid 001 | 5 | M-1 | 7.2 | B-1 | 5.6 | 1-2 | 1 | A-2 | 0.6 | Su-2 | 0.0003 | In-1 | 0.02 | S-1 | 58.9 | 5 | 5 | 5 | Visible to IR region |
| | Dispersion liquid 009 | 11 | | | | | | | | | Su-3 | 0.0003 | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 61 | Dispersion liquid 001 | 5 | M-1 | 7.2 | B-1 | 5.6 | 1-2 | 1 | A-2 | 0.6 | | | In-1 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |

[Table 8]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 62 | Dispersion liquid 001 | 5 | M-1 | 7.2 | B-1 | 5.6 | I-2 | 1 | A-2 | 0.6 | Su-1 | 0.0005 | In-2 | 0.02 | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 63 | Dispersion liquid 001 | 5 | M-1 | 7.2 | B-1 | 5.6 | I-2 | 1 | A-2 | 0.6 | Su-1 | 0.0005 | - | - | S-1 | 58.9 | 5 | 5 | 5 | Visible to IR region |
| | Dispersion liquid 009 | 11 | | | | | | | | | | | | | | | | | | |
| | Dispersion liquid 010 | 11 | | | | | | | | | | | | | | | | | | |
| Example 64 | Dispersion liquid 001 | 5 | M-1 | 7.2 | B-1 | 5.6 | I-2 | 1 | A-2 | 0.6 | Su-1 | 0.0005 | In-1 | 0.02 | S-2 | 58.9 | 5 | 5 | 4 | Visible to IR region |
| | Dispersion liquid 009 | 11 | | | | | | | | | | | | | | | | | | |
| | Dispersion liquid 010 | 11 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 65 | Dispersion liquid 001 | 5 | M-1 | 7.2 | B-1 | 5.6 | 1-2 | 1 | A-2 | 0.6 | Su-1 | 0.0005 | In-1 | 0.02 | S-1 | 29.5 | 5 | 5 | 5 | Visible to IR region |
| | Dispersion liquid 009 | 11 | | | | | | | | | | | | | S-3 | 29.5 | | | | |
| | Dispersion liquid 010 | 11 | | | | | | | | | | | | | | | | | | |
| Comparative example 1 | Dispersion liquid 024 | 27 | M-1 | 7.2 | B-1 | 5.6 | I-2 | 1 | A-2 | 0.6 | Su-1 | 0.0005 | In-1 | 0.02 | S-1 | 58.9 | 1 | 3 | 3 | IR region |
| Comparative example 2 | Dispersion liquid 025 | 27 | M-1 | 7.2 | B-1 | 5.6 | I-2 | 1 | A-2 | 0.6 | Su-1 | 0.0005 | In-1 | 0.02 | S-1 | 58.9 | 3 | 3 | 1 | IR region |
| Comparative example 3 | Dispersion liquid 026 | 27 | M-1 | 7.2 | B-1 | 5.6 | 1-2 | 1 | A-2 | 0.6 | Su-1 | 0.0005 | In-1 | 0.02 | S-1 | 58.9 | 3 | 3 | 1 | IR region |
| Comparative example 4 | Dispersion liquid 027 | 27 | M-1 | 7.2 | B-1 | 5.6 | I-2 | 1 | A-2 | 0.6 | Su-1 | 0.0005 | In-1 | 0.02 | S-1 | 58.9 | 3 | 3 | 2 | IR region |
| Comparative example 5 | Dispersion liquid 028 | 27 | M-1 | 7.2 | B-1 | 5.6 | I-2 | 1 | A-2 | 0.6 | Su-1 | 0.0005 | In-1 | 0.02 | S-1 | 58.9 | 1 | 3 | 3 | IR region |

<Preparation of pigment dispersion liquid>

A pigment, a pigment derivative, a dispersant, and a solvent of the types shown in Table 9 below were mixed with each other in the amounts (part by mass) shown in Table 9 below, 230 parts by mass of zirconia beads having a diameter of 0.3 mm was further added thereto, the mixture was dispersed using a paint shaker for 5 hours, and the beads were separated by filtration, thereby producing each pigment dispersion liquid.

[Table 9]

| | Pigment | | Pigment derivative | | Dispersant | | Solvent | |
|---|---|---|---|---|---|---|---|---|
| | Type | Part by mass | Type | Part by mass | Name | Part by mass | Name | Part by mass |
| Dispersion liquid 029 | P-2 | 6.3 | Syn-6 | 1.3 | D-1 | 3 | S-1 | 84 |
| | | | | | D-6 | 3 | S-2 | 2.4 |
| Dispersion liquid 030 | P-10 | 6.3 | Syn-6 | 1.3 | D-1 | 3 | S-1 | 84 |
| | | | | | D-6 | 3 | S-2 | 2.4 |
| Dispersion liquid 031 | P-11 | 6.3 | Syn-6 | 1.3 | D-1 | 3 | S-1 | 84 |
| | | | | | D-6 | 3 | S-2 | 2.4 |
| Dispersion liquid 032 | P-12 | 6.3 | Syn-6 | 1.3 | D-1 | 3 | S-1 | 84 |
| | | | | | D-6 | 3 | S-2 | 2.4 |
| Dispersion liquid 033 | P-13 | 6.3 | Syn-6 | 1.3 | D-1 | 3 | S-1 | 84 |
| | | | | | D-6 | 3 | S-2 | 2.4 |
| Dispersion liquid 034 | P-14 | 6.3 | Syn-6 | 1.3 | D-1 | 3 | S-1 | 84 |
| | | | | | D-6 | 3 | S-2 | 2.4 |
| Dispersion liquid 035 | P-15 | 6.3 | Syn-6 | 1.3 | D-2 | 3 | S-1 | 84 |
| | | | | | D-6 | 3 | S-2 | 2.4 |
| Dispersion liquid 036 | P-16 | 6.3 | Syn-6 | 1.3 | D-2 | 3 | S-1 | 84 |
| | | | | | D-6 | 3 | S-2 | 2.4 |
| Dispersion liquid 037 | P-2 | 6.3 | Syn-1 3 | 1.3 | D-2 | 3 | S-1 | 84 |
| | | | | | D-6 | 3 | S-2 | 2.4 |
| Dispersion liquid 038 | P-10 | 6.3 | Syn-1 3 | 1.3 | D-2 | 3 | S-1 | 84 |
| | | | | | D-6 | 3 | S-2 | 2.4 |
| Dispersion liquid 039 | P-11 | 6.3 | Syn-1 3 | 1.3 | D-2 | 3 | S-1 | 84 |
| | | | | | D-6 | 3 | S-2 | 2.4 |
| Dispersion liquid 040 | P-12 | 6.3 | Syn-1 3 | 1.3 | D-3 | 3 | S-1 | 84 |
| | | | | | D-6 | 3 | S-2 | 2.4 |
| Dispersion liquid 041 | P-13 | 6.3 | Syn-1 3 | 1.3 | D-3 | 3 | S-1 | 84 |
| | | | | | D-6 | 3 | S-2 | 2.4 |
| Dispersion liquid 042 | P-14 | 6.3 | Syn-1 3 | 1.3 | D-3 | 3 | S-1 | 84 |
| | | | | | D-6 | 3 | S-2 | 2.4 |
| Dispersion liquid 043 | P-15 | 6.3 | Syn-1 3 | 1.3 | D-3 | 3 | S-1 | 84 |
| | | | | | D-6 | 3 | S-2 | 2.4 |
| Dispersion liquid 044 | P-16 | 6.3 | Syn-1 3 | 1.3 | D-3 | 3 | S-1 | 84 |
| | | | | | D-6 | 3 | S-2 | 2.4 |

(continued)

| | Pigment | | Pigment derivative | | Dispersant | | Solvent | |
|---|---|---|---|---|---|---|---|---|
| | Type | Part by mass | Type | Part by mass | Name | Part by mass | Name | Part by mass |
| Dispersion liquid 045 | P-4 | 6.9 | Syn-7 | 0.8 | D-3 | 3.8 | S-1 | 66 |
| | P-5 | 6.5 | Syn-8 | 0.9 | D-6 | 3.8 | S-2 | 7.8 |
| | P-6 | 3.5 | | | | | | |

Raw materials shown in Table 10 shown below, including the obtained pigment dispersion liquid, were mixed in the amounts (part by mass) shown in Table 10 below, and the obtained mixture was filtered using a nylon filter (manufactured by Nihon Pall Corporation) having a pore size of 0.45 μm to prepare a curable composition.

[Table 10]

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 66 | Dispersion liquid 029 | 28.5 | M-1 | 5.4 | B-2 | 1.3 | I-2 | 1.2 | A-3 | 0.6 | Su-1 | 0.05 | In-1 | 0.001 | S-1 | 11.1 | 5 | 5 | 5 | Visible to IR region |
| | Dispersion liquid 045 | 51.8 | | | | | | | | | | | | | | | | | | |
| Example 67 | Dispersion liquid 030 | 28.5 | M-2 | 5.4 | B-2 | 1.3 | 1-3 | 1.2 | A-3 | 0.6 | Su-1 | 0.05 | In-1 | 0.001 | S-1 | 11.1 | 5 | 4 | 4 | Visible to IR region |
| | Dispersion liquid 045 | 51.8 | | | | | | | | | | | | | | | | | | |
| Example 68 | Dispersion liquid 031 | 28.5 | M-3 | 5.4 | B-2 | 1.3 | I-4 | 1.2 | A-3 | 0.6 | Su-1 | 0.05 | In-1 | 0.001 | S-1 | 11.1 | 5 | 4 | 4 | Visible to IR region |
| | Dispersion liquid 045 | 51.8 | | | | | | | | | | | | | | | | | | |
| Example 69 | Dispersion liquid 032 | 28.5 | M-1 | 5.4 | B-2 | 1.3 | I-5 | 1.2 | - | - | Su-1 | 0.05 | In-1 | 0.001 | S-1 | 11.1 | 5 | 5 | 5 | Visible to IR region |
| | Dispersion liquid 045 | 51.8 | | | B-5 | 0.6 | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 70 | Dispersion liquid 033 | 28.5 | M-3 | 5.4 | B-4 | 1.3 | I-2 | 1.2 | - | - | Su-1 | 0.05 | In-1 | 0.001 | S-1 | 11.1 | 5 | 4 | 4 | Visible to IR region |
| | Dispersion liquid 045 | 51.8 | | | B-5 | 0.6 | | | | | | | | | | | | | | |
| Example 71 | Dispersion liquid 034 | 28.5 | M-1 | 5.4 | B-4 | 1.3 | I-3 | 1.2 | - | - | Su-1 | 0.05 | In-1 | 0.001 | S-1 | 11.1 | 5 | 4 | 4 | Visible to IR region |
| | Dispersion liquid 045 | 51.8 | | | B-5 | 0.6 | | | | | | | | | | | | | | |
| Example 72 | Dispersion liquid 035 | 28.5 | M-3 | 5.4 | B-4 | 1.3 | I-4 | 1.2 | - | - | Su-1 | 0.05 | In-1 | 0.001 | S-1 | 11.1 | 5 | 4 | 4 | Visible to IR region |
| | Dispersion liquid 045 | 51.8 | | | B-6 | 0.6 | | | | | | | | | | | | | | |
| Example 73 | Dispersion liquid 036 | 28.5 | M-2 | 5.4 | B-4 | 1.3 | I-5 | 1.2 | - | - | Su-1 | 0.05 | In-1 | 0.001 | S-1 | 11.1 | 5 | 4 | 4 | Visible to IR reeion |
| | Dispersion liquid 045 | 51.8 | | | B-6 | 0.6 | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 74 | Dispersion liquid 037 | 28.5 | M-3 | 5.4 | B-2 | 1.3 | 1-2 | 1.2 | - | - | Su-1 | 0.05 | In-1 | 0.001 | S-1 | 11.1 | 5 | 5 | 5 | Visible to IR region |
| | Dispersion liquid 045 | 51.8 | | | B-6 | 0.6 | | | | | | | | | | | | | | |
| Example 75 | Dispersion liquid 038 | 28.5 | M-1 | 5.4 | B-2 | 1.3 | 1-3 | 1.2 | A-3 | 0.6 | Su-1 | 0.05 | In-1 | 0.001 | S-1 | 11.1 | 5 | 5 | 5 | Visible to IR region |
| | Dispersion liquid 045 | 51.8 | | | | | | | | | | | | | | | | | | |
| Example 76 | Dispersion liquid 039 | 28.5 | M-3 | 5.4 | B-2 | 1.3 | 1-4 | 1.2 | A-3 | 0.6 | Su-1 | 0.05 | In-1 | 0.001 | S-1 | 11.1 | 5 | 5 | 5 | Visible to IR region |
| | Dispersion liquid 045 | 51.8 | | | | | | | | | | | | | | | | | | |
| Example 77 | Dispersion liquid 040 | 28.5 | M-2 | 5.4 | B-2 | 1.3 | I-5 | 1.2 | A-3 | 0.6 | Su-1 | 0.05 | In-1 | 0.001 | S-1 | 11.1 | 5 | 5 | 5 | Visible to IR region |
| | Dispersion liquid 045 | 51.8 | | | | | | | | | | | | | | | | | | |

(continued)

| | Pigment dispersion liquid | | Polymerizable compound | | Binder resin | | Polymerization initiator | | Additive | | Surfactant | | Polymerization inhibitor | | Solvent | | Evaluation result | | | |
|---|---|---|---|---|---|---|---|---|---|---|---|---|---|---|---|---|---|---|---|---|
| | Type | Part by mass | Type | Part by mass | Type | Part by mass | Type | Part by mass | Type | Part by mass | Type | Part by mass | Type | Part by mass | Type | Part by mass | Moisture resistance reliability | Dispersion stability | Development residue | Absorption band |
| Example 78 | Dispersion liquid 041 | 28.5 | M-1 | 5.4 | B-4 | 1.3 | I-2 | 1.2 | - | - | Su-1 | 0.05 | In-1 | 0.001 | S-1 | 11.1 | 5 | 5 | 5 | Visible to IR region |
| | Dispersion liquid 045 | 51.8 | | | B-5 | 0.6 | | | | | | | | | | | | | | |
| Example 79 | Dispersion liquid 042 | 28.5 | M-3 | 5.4 | B-4 | 1.3 | I-3 | 1.2 | - | - | Su-1 | 0.05 | In-1 | 0.001 | S-1 | 11.1 | 5 | 5 | 5 | Visible to IR region |
| | Dispersion liquid 045 | 51.8 | | | B-5 | 0.6 | | | | | | | | | | | | | | |
| Example 80 | Dispersion liquid 043 | 28.5 | M-2 | 5.4 | B-4 | 1.3 | I-4 | 1.2 | - | - | Su-1 | 0.05 | In-1 | 0.001 | S-1 | 11.1 | 5 | 4 | 4 | Visible to IR region |
| | Dispersion liquid 045 | 51.8 | | | B-5 | 0.6 | | | | | | | | | | | | | | |
| Example 81 | Dispersion liquid 044 | 28.5 | M-1 | 5.4 | B-4 | 1.3 | I-5 | 1.2 | - | - | Su-1 | 0.05 | In-1 | 0.001 | S-1 | 11.1 | 5 | 5 | 5 | Visible to IR region |
| | Dispersion liquid 045 | 51.8 | | | B-6 | 0.6 | | | | | | | | | | | | | | |

Raw materials used for each curable composition are as follows.

-Pigment-

Pigments P-1 to P-3: compounds having the following structures
Pigment P-4: C. I. Pigment Red 254
Pigment P-5: C. I. Pigment Blue 15:6
Pigment P-6: C. I. Pigment Yellow 139
Pigment P-7: C. I. Pigment Violet 23
Pigment P-8: Irgafor BLACK (manufactured by BASF)
Pigment P-9: Lumogen Black (manufactured by BASF)

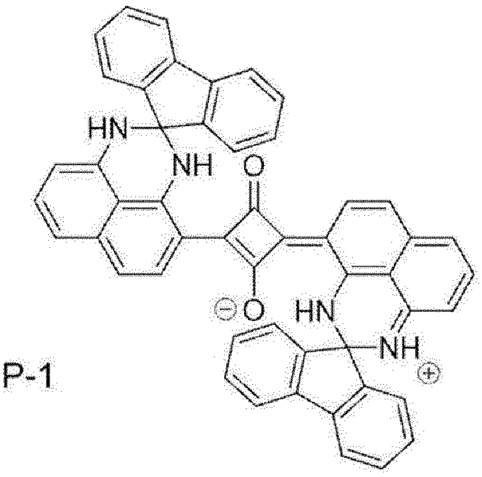

P-1

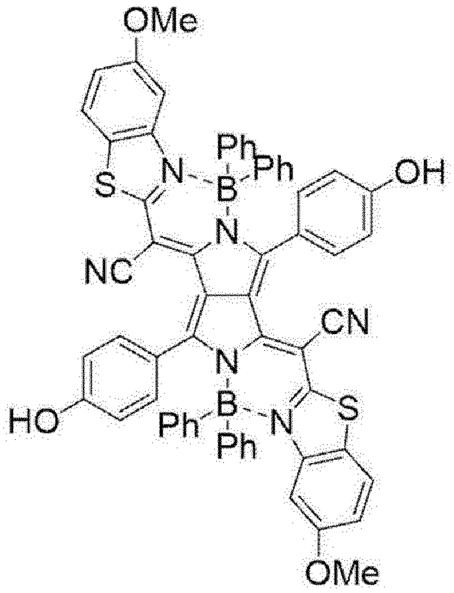

P-2

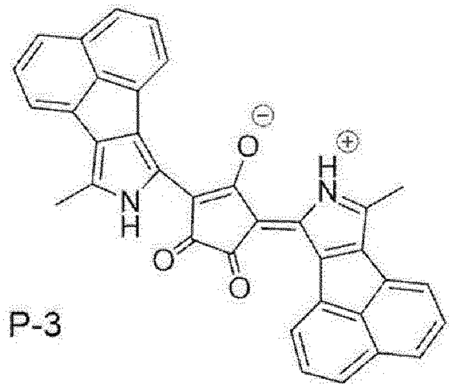

P-3

Pigments P-10 to P-16: compounds having the following structures

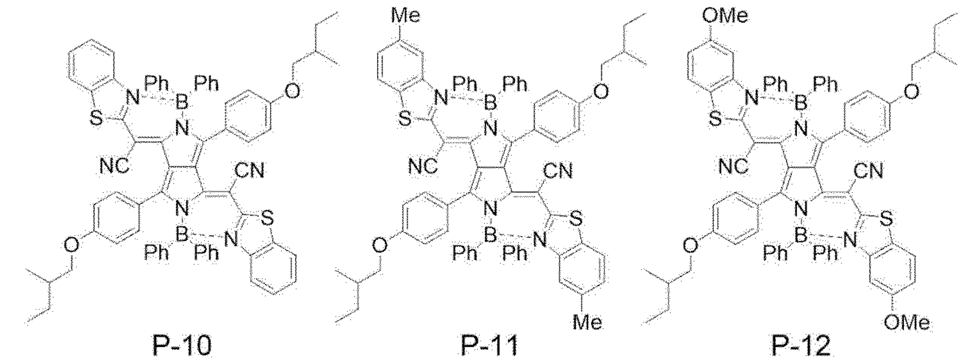

P-10 P-11 P-12

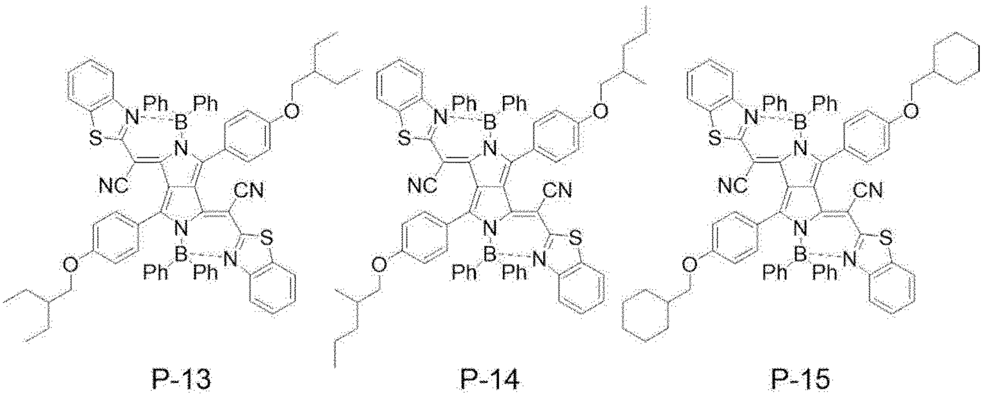

P-13 P-14 P-15

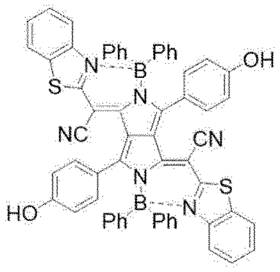

P-16

Here, the pigments P-2, P-10, P-11, P-12, and P-16 described above were synthesized according to the synthesis method described in WO2017/146092A.

In addition, the pigments P-13, P-14, and P-15 described above were synthesized according to the following synthesis method.

<Synthesis of pigment P-14>

The pigment P-14 was synthesized according to the following scheme.

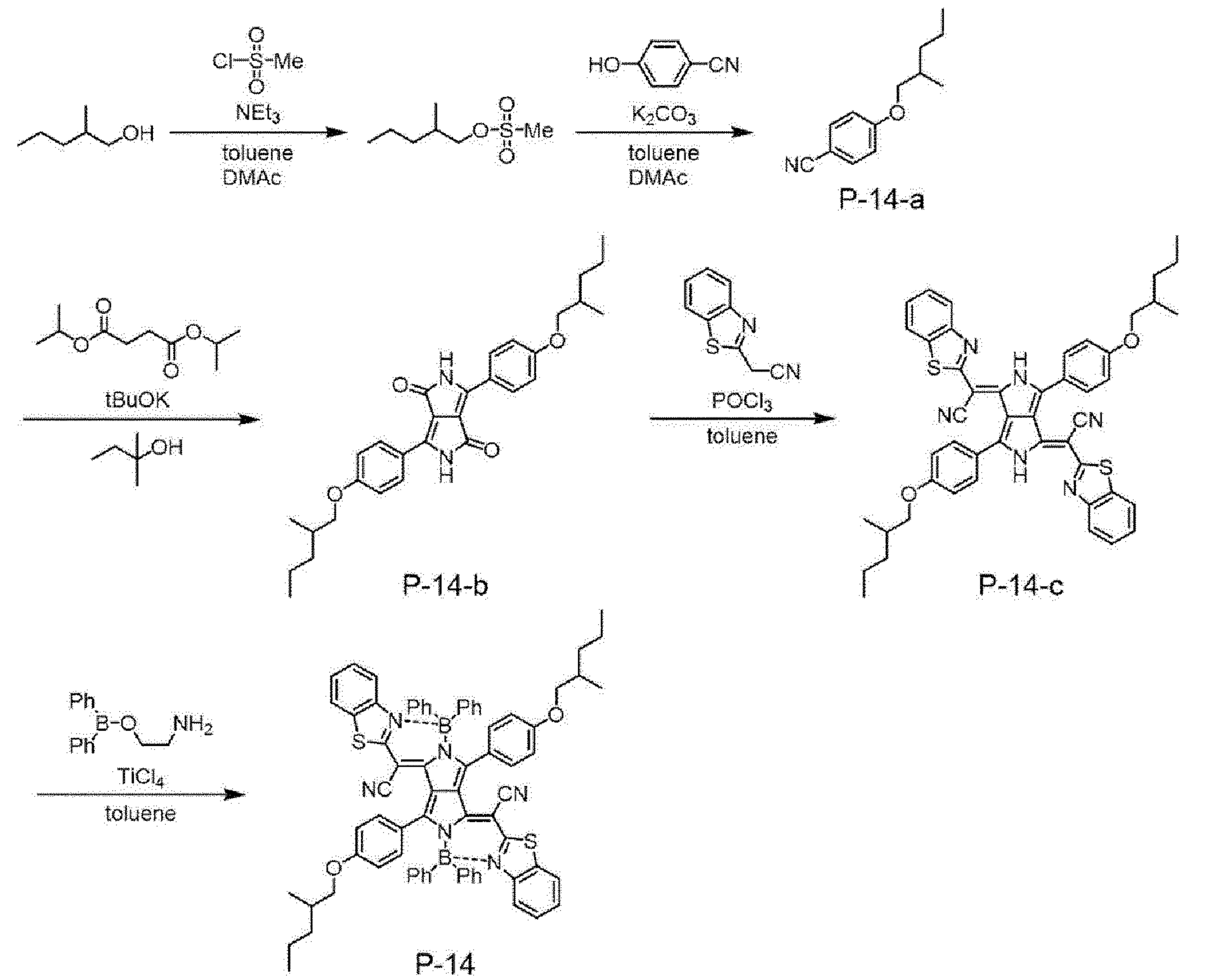


P-14-a

P-14-b

P-14-c

P-14

100 parts by mass of 2-methyl-1-pentanol and 129 parts by mass of triethylamine were stirred in a mixed solution of 789 parts by mass of toluene and 169 parts by mass of dimethylacetamide (DMAc), and 135 parts by mass of methanesulfonyl chloride was added dropwise thereto over 30 minutes while maintaining an internal temperature of 30°C or lower. After completion of the dropwise addition, the mixture was stirred at room temperature for 60 minutes. 1027 parts by mass of a 9 mass% saline solution was added to the reaction solution, the mixture was stirred for 45 minutes, and then the organic phase was taken out by a liquid separation operation. 70 parts by mass of magnesium sulfate was added to the organic layer, and the mixture was allowed to stand for 30 minutes and then filtered off to remove the magnesium sulfate.

134 parts by mass of 4-hydroxybenzonitrile, 254 parts by mass of DMAc, and 162 parts by mass of potassium carbonate were added to the dried organic layer, and the mixture was stirred at an external temperature of 120°C for 9 hours. After completion of the reaction, the reaction solution was cooled to an internal temperature of 25°C, and 800 parts by mass of a 10 mass% sodium hydroxide aqueous solution was added thereto while maintaining the internal temperature of 25°C or lower. After completion of the addition, the mixture was stirred at room temperature for 15 minutes, and then the organic phase was taken out by a liquid separation operation. The organic layer was washed with 455 parts by mass of water and subsequently 500 parts by mass of a 9 mass% saline solution, and the solvent was distilled off under reduced pressure to obtain 184 parts by mass of a compound P-14-a.

$^1$H-NMR ($CDCl_3$): δ 0.93 (t, 3H), 1.02 (d, 3H), 1.15 to 1.55 (m, 4H), 1.97 (m, 1H), 3.81 (m, 2H), 6.63 (d, 2H), 7.56 (d, 2H)

184 parts by mass of the compound P-14-a and 192 parts by mass of potassium tert-butoxide were stirred in 392 parts by mass of tert-amyl alcohol, and 105 parts by mass of diisopropyl succinate was added dropwise thereto over 1.5 hours while maintaining an internal temperature of 100°C or higher. After the dropwise addition, the reaction solution was stirred for 4 hours at an external temperature of 125°C. After completion of the reaction, the reaction solution was cooled to an internal temperature of 80°C, and a mixed solution of 178 parts by mass of methanol and 225 parts by mass of water was added dropwise thereto over 10 minutes. After completion of the dropwise addition, the mixture was stirred at room temperature for 30 minutes. The precipitated crystals were filtered off and washed with 251 parts

by mass of methanol. 1021 parts by mass of methanol was added to the obtained crystals, the mixture was heated under reflux for 30 minutes and allowed to cool to 30°C, and operation of filtering off the crystals was performed twice. The obtained crystals were blast-dried at 50°C for 12 hours to obtain 101 parts by mass of a compound P-14-b.

$^1$H-NMR (dimethyl sulfoxide (DMSO) -$d_6$: mixed solution of 28 mass% methanol solution of sodium methoxide = 95:5 (mass ratio)): δ 0.90 (t, 6H), 0.98 (d, 6H), 1.10 to 1.55 (m, 8H), 1.90 (m, 2H), 3.80 (m, 4H), 6.82 (d, 4H), 8.57 (d, 4H)

15 parts by mass of the compound P-14-b and 12.8 parts by mass of 2-(2-benzothiazolyl) acetonitrile were stirred in 153 parts by mass of toluene, 37.7 parts by mass of phosphorus oxychloride was added dropwise thereto, and the mixture was heated under reflux for 3 hours. After completion of the reaction, the reaction solution was cooled to an internal temperature of 15°C, 119 parts by mass of methanol was added dropwise thereto over 1 hour while maintaining the internal temperature of 30°C or lower, and the reaction solution was stirred at room temperature for 30 minutes. 68 parts by mass of triethylamine was added dropwise to the reaction solution over 1 hour while maintaining the internal temperature of 30°C or lower, and then the mixture was stirred at room temperature for 30 minutes. The precipitated crystals were filtered off and washed with 88 parts by mass of methanol. A mixed solution of 119 parts by mass of methanol and 150 parts by mass of water was added to the obtained crystals, the mixture was heated under reflux for 30 minutes and allowed to cool to 30°C, and the crystals were filtered off. 143 parts by mass of methanol was added to the obtained crystals, the mixture was heated under reflux for 1 hour and allowed to cool to 30°C, and the crystals were filtered off. The obtained crystals were blast-dried at 50°C for 12 hours to obtain 16 parts by mass of a compound P-14-c.

$^1$H-NMR ($CDCl_3$): δ 0.90 (t, 6H), 1.08 (d, 6H), 1.20 to 1.68 (m, 8H), 2.02 (m, 2H), 3.92 (m, 4H), 7.16 (d, 4H), 7.31 (t, 2H), 7.45 (t, 2H), 7.76 (d, 4H), 7.82 (dd, 4H), 13.2 (s, 2H)

11.2 parts by mass of 2-aminoethyl ester diphenylboric acid and 16 parts by mass of the compound P-14-c were stirred in 139 parts by mass of toluene, 9.2 parts by mass of titanium tetrachloride was added dropwise thereto over 15 minutes at an external temperature of 45°C, and the mixture was stirred for 30 minutes. The external temperature was raised to 125°C, and the mixture was heated under reflux for 3.5 hours. The reaction solution was cooled to an internal temperature of 30°C, and 72 parts by mass of methanol was added dropwise thereto while maintaining the internal temperature of 30°C or lower. After the dropwise addition, the mixture was stirred for 30 minutes, and the precipitated crystals were filtered off and washed with 55 parts by mass of methanol. 112 parts by mass of methanol was added to the obtained crystals, the mixture was heated under reflux for 30 minutes and allowed to cool to 30°C, and operation of filtering off the crystals was performed twice. The obtained crystals were blast-dried at 50°C for 12 hours to obtain 20.9 parts by mass of the pigment P-14.

$^1$H-NMR ($CDCl_3$): δ 0.97 (t, 6H), 1.05 (d, 6H), 1.20 to 1.60 (m, 8H), 1.98 (m, 2H), 3.75 (m, 4H), 6.45 (s, 8H), 6.99 (d, 4H), 7.06 to 7.20 (m, 14H), 7.24 (d, 8H), 7.50 (d, 2H)

λmax of the pigment P-14 in chloroform was 780 nm, the molar absorption coefficient was 238994 L/(mol·cm), and the gram extinction coefficient was 212 L/(g·cm).

The high performance liquid chromatography (HPLC) purity of the pigment P-14 was 97.2%.

The solubility of the pigment P-14 in propylene glycol monomethyl ether acetate (PGMEA) was 0.75 mg/L.

The 5% weight loss temperature of the pigment P-14 was 385°C.

The crystal transition temperature of the pigment P-14 was 400°C or higher.

As a peak position of powder X-ray diffraction spectrum of the pigment P-14, diffraction angles 2θ were 8.0°, 9.1°, 9.5°, 10.7°, 11.1°, 12.6°, 13.5°, 13.9°, 14.3°, 16.1°, 16.9°, 17.5°, 18.2°, 19.0°, 19.5°, 19.9°, 20.5°, 20.8°, 21.7°, 22.3°, 22.8°, 23.4°, 23.9°, 24.5°, 25.1°, 25.4°, 25.7°, 26.4°, 27.5°, 27.9°, 28.4°, and 29.2°, and the full width at half maximum of the peak of 8.0°, which had the maximum peak intensity, was 0.18°.

(Measurement of λmax, molar absorption coefficient, and gram extinction coefficient)

Cary 5000 manufactured by Agilent Technologies, Inc. was used as a determination device. A measurement sample was dissolved in a solvent at 25°C and placed in a 10 mm × 10 mm quartz cell, and the absorption spectrum of 350 nm to 1000 nm was measured. From the concentration of the solution and the absorption spectrum, λmax, the molar absorption coefficient, and the gram extinction coefficient were calculated.

(Measurement of HPLC purity)

The peak surface area% was determined by a measurement under the following conditions.

- Determination device: 1260 Infinity II manufactured by Agilent Technologies, Inc.
- Column: kinetex 5 μC 18100A (250 mm × diameter 4.60 mm) manufactured by Phenomenex Inc.
- Eluent: 20 mM ion exchange water of tetrahydrofuran (THF) solution/ammonium acetate = 66/34 (volume ratio)
- Flow rate: 1.2 mL/min
- Column temperature: 45°C

- Detection wavelength: 254 nm

(Measurement of solubility)

Cary 5000 manufactured by Agilent Technologies, Inc.was used as a determination device. A measurement sample was added to a solvent at 25°C and irradiated with ultrasonic waves for 30 minutes, and then the solubility of the measurement sample in the solvent was determined.

(Measurement of 5% weight loss temperature)

STA2500 Regulus manufactured by Netzsch was used as a determination device. A measurement sample was heated from 30°C to 400°C at 10 °C/min, and the 5% weight loss temperature was measured.

(Measurement of crystal transition temperature)

DSC3500 Sirius manufactured by Netzsch was used as a determination device. A measurement sample was heated from 30°C to 400°C at 10 °C/min and cooled from 400°C to 30°C at 20 °C/min, and the crystal transition temperature was measured.

(Measurement of powder X-ray diffraction spectrum)

Using a sample horizontal type strong X-ray diffractometer RINT-TTR III manufactured by Rigaku Corporation as a determination device, the powder X-ray diffraction spectrum was measured under the conditions of diffraction angle 2θ = 5° to 55°, voltage of 50 kV, current of 300 mA, scan speed of 4 °/min, step interval of 0.1, and slit (scattering: 0.05 mm, divergence: 10 mm, light reception: 0.15 mm). In the obtained powder X-ray diffraction spectrum, a peak with the highest diffraction intensity at a diffraction angle of 2θ of 5° to 10° was fitted to the Lorentz function [y = A/(l + ((x - x0)/w)2) + h], and the full width at half maximum of the same peak was calculated. Here, y is the intensity, A is the peak height, x is 2θ, x0 is the peak position, w is the peak width (half width), and h is the baseline.

<Synthesis of pigments P-13 and P-15>

The pigments P-13 and P-15 were synthesized in the same manner as in the synthesis of the pigment P-14.
Since the molecular weights of the synthesized pigments P-13 and P-15 by matrix-assisted laser desorption/ionization mass spectrometry (MALDI-MS) were the same as the theoretical values, the reaction products were identified as the target compounds.

λmax of the pigment P-13 in chloroform was 780 nm.

The solubility of the pigment P-13 in PGMEA was 0.17 mg/L.
The 5% weight loss temperature of the pigment P-13 was 396°C.
The crystal transition temperature of the pigment P-13 was 400°C or higher.
As a peak position of powder X-ray diffraction spectrum of the pigment P-13, diffraction angles 2θ were 8.1°, 9.2°, 10.2°, 10.7°, 12.5°, 12.7°, 13.5°, 13.9°, 14.5°, 16.1°, 16.9°, 17.1°, 18.4°, 19.1°, 19.6°, 19.8°, 20.4°, 20.9°, 21.3°, 21.7°, 21.9°, 22.3°, 23.1°, 23.7°, 24.1°, 24.5°, 25.1°, 25.7°, 26.3°, 26.7°, 27.5°, 27.8°, 28.1°, and 28.6°, and the full width at half maximum of the peak of 8.1 °, which had the maximum peak intensity, was 0.18°.
All of these physical properties were measured using the same method as the pigment P-14.

λmax of the pigment P-15 in chloroform was 780 nm.

The solubility of the pigment P-15 in PGMEA was 0.75 mg/L.
The 5% weight loss temperature of the pigment P-15 was 400°C or higher.
The crystal transition temperature of the pigment P-15 was 265°C.
As a peak position of powder X-ray diffraction spectrum of the pigment P-15, diffraction angles 2θ were 5.3°, 7.5°, 9.1°, 10.8°, 11.2°, 12.5°, 12.7°, 13.8°, 15.0°, 15.3°, 16.0°, 16.3°, 16.7°, 18.0°, 18.5°, 19.2°, 19.4°, 20.5°, 20.7°, 21.0°, 21.5°, 22.1°, 22.5°, 22.9°, 23.4°, 24.1°, 24.6°, 25.0°, 25.3°, 25.9°, 27.1°, 27.5°, 27.9°, 28.6°, and 29.6°, and the full width at half maximum of the peak of 7.5°, which had the maximum peak intensity, was 0.27°.
All of these physical properties were measured using the same method as the pigment P-14.

-Pigment derivative-

Pigment derivatives Syn-1 to Syn-13: compounds having the following structures

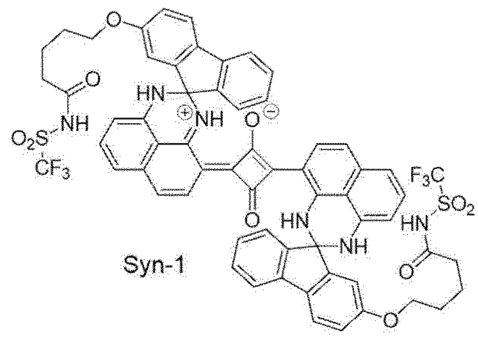
Syn-1

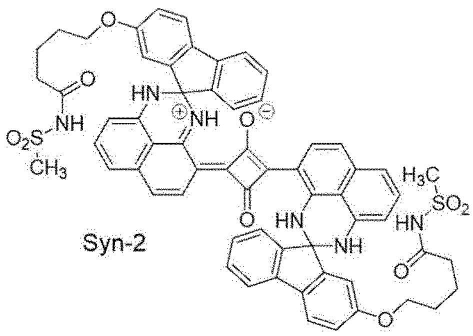
Syn-2

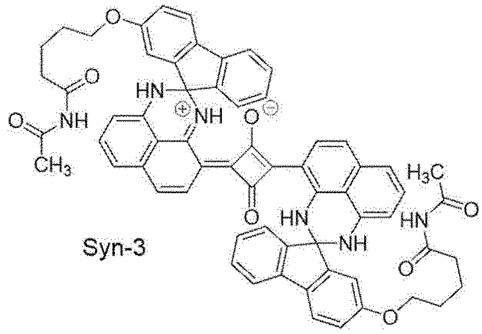
Syn-3

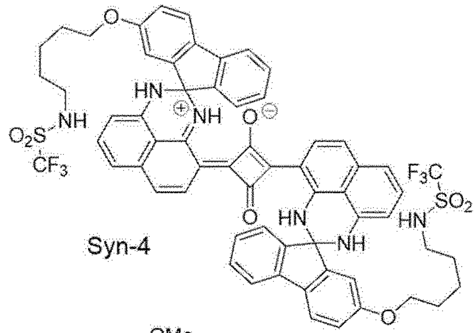
Syn-4

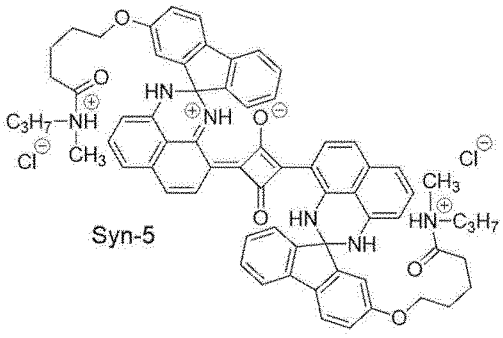
Syn-5

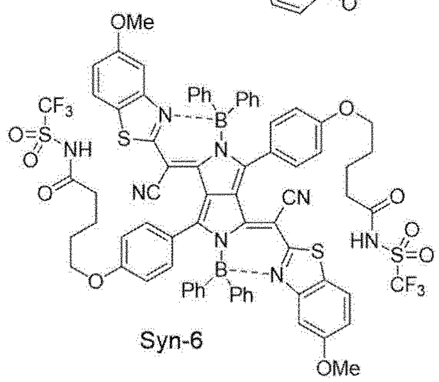
Syn-6

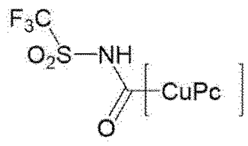
Syn-7

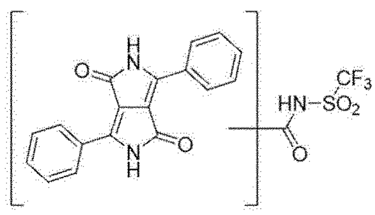
Syn-8

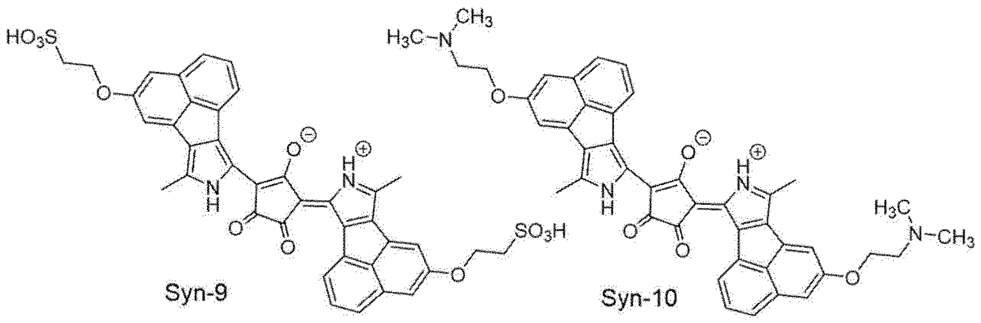

Syn-9 Syn-10

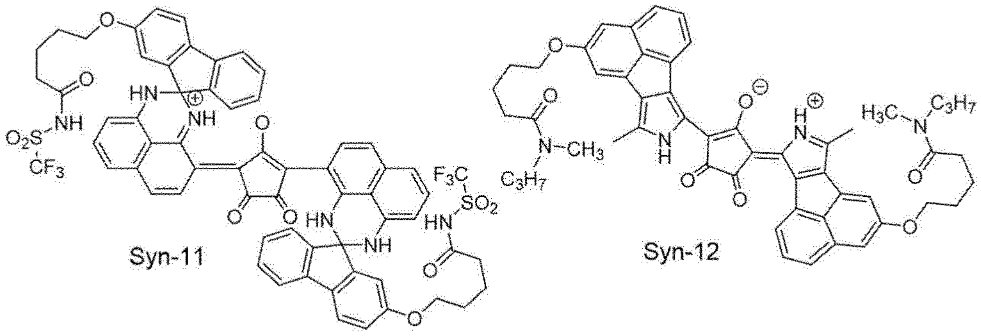

Syn-11 Syn-12

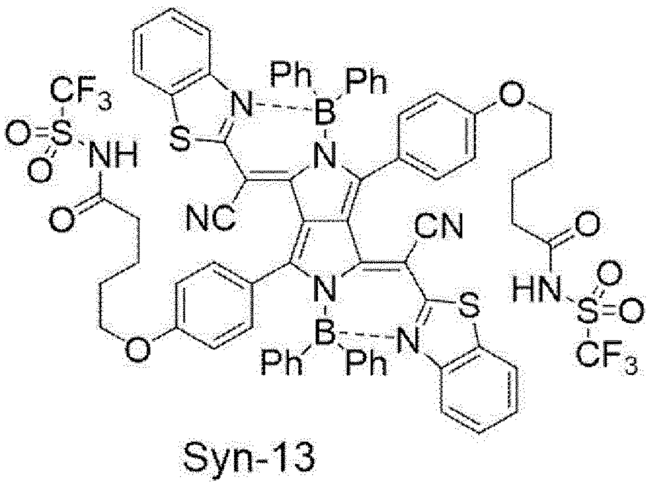

Syn-13

The pigment derivative Syn-6 shown above was synthesized according to the synthesis method described in WO2018/230387A.

In addition, the pigment derivative Syn-13 shown above was synthesized according to the following synthesis method.

<Synthesis of pigment derivative Syn-13>

The pigment derivative Syn-13 was synthesized according to the following scheme.

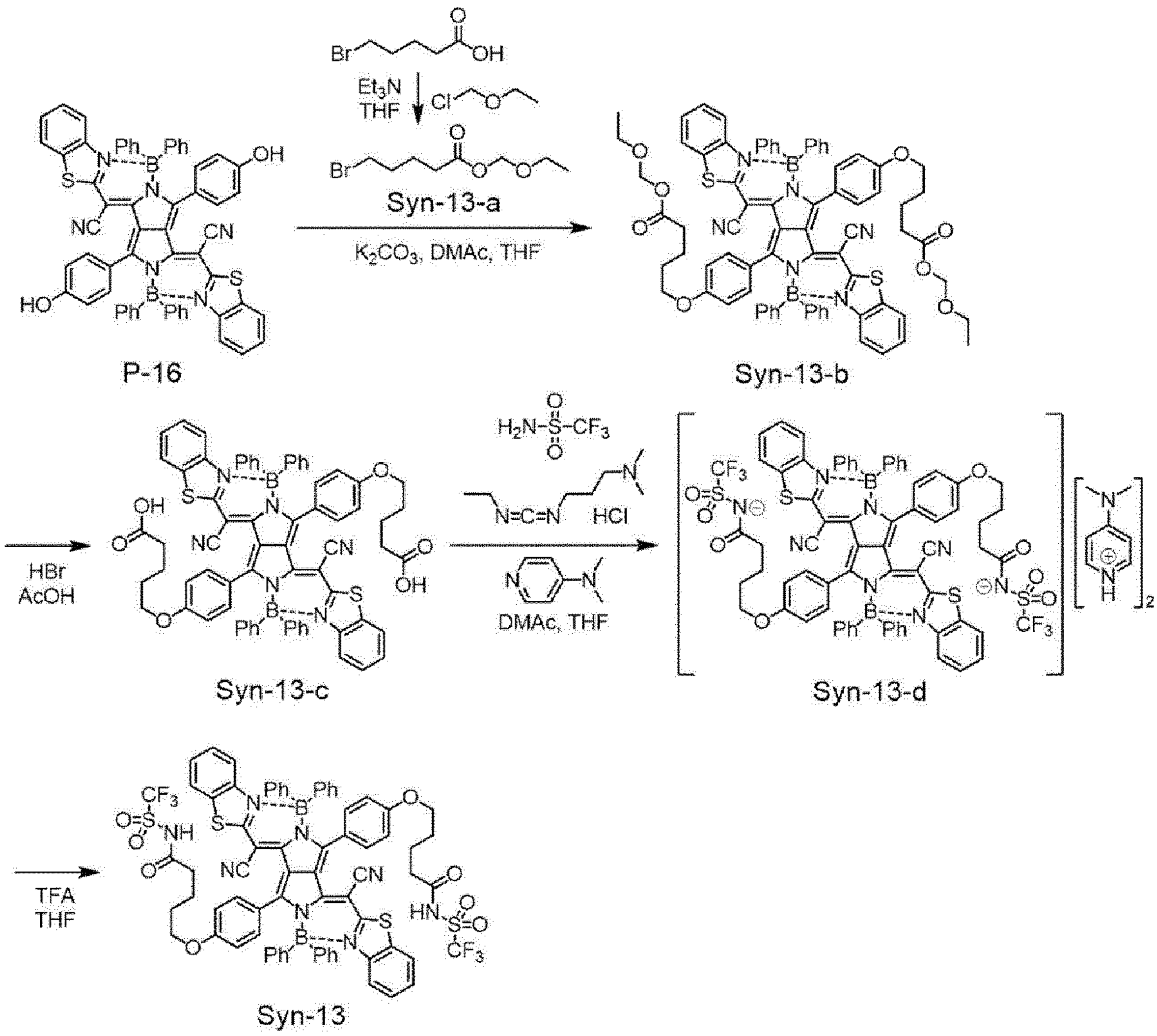


P-16

Syn-13-b

Syn-13-c

Syn-13-d

Syn-13

100 parts by mass of 5-bromovaleric acid and 72.7 parts by mass of triethylamine were stirred in 890 parts by mass of tetrahydrofuran, and 67.9 parts by mass of chloromethylethyl ether was added dropwise thereto while cooling in an ice bath and maintaining an internal temperature of 10°C or lower. After completion of the dropwise addition, the mixture was stirred at an internal temperature of 5°C to 20°C for 30 minutes. 7.5 parts by mass of ion exchange water, 740 parts by mass of tert-butyl methyl ether, and 1000 parts by mass of 0.83 mass% sodium bicarbonate water were added to the reaction solution, the mixture was stirred at room temperature for 10 minutes, and then the organic phase was taken out by a liquid separation operation. 1000 parts by mass of 0.83 mass% sodium bicarbonate water was added to the organic layer, the mixture was stirred at room temperature for 10 minutes, and then the organic phase was taken out by a liquid separation operation. 1000 parts by mass of 15 mass% salt water was added to the organic layer, the mixture was stirred at room temperature for 10 minutes, and then the organic phase was taken out by a liquid separation operation. 0.05 parts by mass of 3,5-di-tert-butyl-4-hydroxytoluene and 100 parts by mass of sodium sulfate were added to the organic layer, and the mixture was allowed to stand for 60 minutes and then filtered off to remove the sodium sulfate. The solvent was distilled off under reduced pressure at 25°C to 30°C to obtain 130 parts by mass of a compound Syn-13-a.

$^1H$-NMR(DMSO-$d_6$): δ 1.13 (t, 3H), 1.62 to 1.70 (m, 2H), 1.75 to 1.86 (m, 2H), 2.38 (t, 2H), 3.54 (t, 2H), 3.60 (q, 2H), 5.22 (s, 2H)

30 parts by mass of the pigment P-16 and 17.3 parts by mass of potassium carbonate (fine powder grade) were stirred in a mixed solution of 165 parts by mass of dimethyl sulfoxide and 134 parts by mass of tetrahydrofuran, and 59.7 parts by mass of the compound Syn-13-a was added thereto at room temperature. The reaction solution was stirred at an internal temperature of 75°C to 80°C for 7 hours, and tetrahydrofuran was distilled off at an internal temperature of 35°C to 40°C. 190 parts by mass of acetonitrile was added to the residual liquid at room temperature, and the mixture was stirred at room temperature for 30 minutes. The precipitated crystals were filtered off and washed with 474 parts by mass of acetonitrile. A mixed solution of 95 parts by mass of acetonitrile and 480 parts by mass of ion

exchange water was added to the obtained crystals, and the mixture was stirred at room temperature for 1 hour. The crystals was filtered and washed in an order of a mixed solution of 95 parts by mass of acetonitrile and 480 parts by mass of ion exchange water, and 474 parts by mass of acetonitrile. The obtained crystals were blast-dried at 80°C for 12 hours to obtain 15.7 parts by mass of a compound Syn-13-b.

All amounts of the obtained compound Syn-13-b were stirred in 403 parts by mass of acetic acid, and 42 parts by mass of a 25 mass% hydrogen bromide/acetic acid solution was added thereto at room temperature. The reaction solution was stirred at an internal temperature of 55°C to 60°C for 3 hours and then allowed to cool to an internal temperature of 25°C. The precipitated crystals were filtered off and washed with 279 parts by mass of acetonitrile. All amounts of the obtained crystals was stirred in 236 parts by mass of tetrahydrofuran at room temperature for 1 hour, and then 398 parts by mass of ion exchange water was added dropwise thereto while maintaining an internal temperature of 20°C to 30°C. After stirring at room temperature for 1 hour, the precipitated crystals were filtered off and washed with 279 parts by mass of acetonitrile. The obtained crystals were blast-dried at 80°C for 12 hours to obtain 13.8 parts by mass of a compound Syn-13-c.

13.2 parts by mass of the compound Syn-13-c, 6.8 parts by mass of trifluoromethanesulfonamide, 8.7 parts by mass of 1-ethyl-3-(3-dimethylaminopropyl) carbodiimide hydrochloride salt, and 5.6 parts by mass of N-dimethyl-4-aminopyridine were stirred in a mixed solution of 63 parts by mass of N,N-dimethylacetamide and 60 parts by mass of tetrahydrofuran at an internal temperature of 40°C to 43°C for 4 hours. After allowing to cool to an internal temperature of 25°C, the hydrochloride salt was removed by filtration. The reaction solution from which the above-described hydrochloride salt was removed was added to a mixed solution of 8.3 parts by mass of N,N-dimethyl-4-aminopyridine, 356 parts by mass of ethyl acetate, and 31 parts by mass of N,N-dimethylacetamide at room temperature. The reaction solution was stirred at an internal temperature of 40°C to 43°C for 60 minutes and then allowed to cool to 25°C. The precipitated crystals were filtered off and washed with 178 parts by mass of ethyl acetate. The obtained crystals were blast-dried at 50°C for 10 hours. All amounts of the obtained crystals were stirred in a mixed solution of 73 parts by mass of methanol and 178 parts by mass of distilled water at room temperature for 30 minutes. The crystals were filtered off and washed with 132 parts by mass of distilled water. The obtained crystals were blast-dried at 50°C for 10 hours to obtain 13.6 parts by mass of a compound Syn-13-d.

All amounts of the obtained compound Syn-13-d were stirred in 94 parts by mass of tetrahydrofuran, and the mixture was cooled to an internal temperature of 3°C. 65 parts by mass of trifluoroacetic acid was added dropwise thereto over 30 minutes while maintaining an internal temperature of 5°C or lower, and the mixture was stirred at an internal temperature of 0°C to 10°C for 30 minutes. 69 parts by mass of acetic acid was added thereto while maintaining an internal temperature of 5°C or lower, and the mixture was stirred at an internal temperature of 0°C to 10°C for 30 minutes. 143 parts by mass of diisopropyl ether was added thereto while maintaining an internal temperature of 5°C or lower, and the mixture was stirred at an internal temperature of 20°C to 30°C for 30 minutes.

The precipitated crystals were filtered off and washed with 143 parts by mass of diisopropyl ether. All amounts of the obtained crystals were stirred in a mixed solution of 138 parts by mass of acetic acid and 97 parts by mass of diisopropyl ether, 13 parts by mass of trifluoroacetic acid was added thereto at room temperature, and the mixture was stirred at an internal temperature of 20°C to 30°C for 30 minutes. The precipitated crystals were filtered off and washed in an order of a mixed solution of 69 parts by mass of acetate acid and 48 parts by mass of diisopropyl ether, and 96 parts by mass of diisopropyl ether. All amounts of the obtained crystals were stirred in a mixed solution of 59 parts by mass of tetrahydrofuran and 239 parts by mass of diisopropyl ether at room temperature for 30 minutes, and then the crystals were filtered off and washed with 96 parts by mass of diisopropyl ether. The obtained crystals were blast-dried at 80°C for 15 hours to obtain 10.9 parts by mass of the pigment derivative Syn-13.

$^1$H-NMR (DMSO-$d_6$): δ 1.61 to 1.77 (m, 8H), 2.30 (t, 4H), 3.93 (t, 4H), 6.36 (d, 4H), 6.46 (d, 4H), 6.90 (d, 2H), 7.08 to 7.25 (m, 24H), 7.94 (d, 2H)
$^{19}$F-NMR (DMSO-$d_6$): δ -76.9 (6F)

λmax of the pigment derivative Syn-13 in dimethyl sulfoxide was 783 nm, the molar absorption coefficient was 193319 L/(mol·cm), and the gram extinction coefficient was 136 L/(g·cm).

The high performance liquid chromatography (HPLC) purity of the pigment derivative Syn-13 was 91.5%.

The solubility of the pigment derivative Syn-13 in propylene glycol monomethyl ether acetate (PGMEA) was 323 mg/L.

The 5% weight loss temperature of the pigment derivative Syn-13 was 252°C.

All of these physical properties were measured using the same method as the pigment P-14, except for the measurement of HPLC purity described below.

(Measurement of HPLC purity)

The peak surface area% was determined by a measurement under the following conditions.

- Determination device: 1260 Infinity II manufactured by Agilent Technologies, Inc.
- Column: kinetex 5 μC 18100A (250 mm × diameter 4.60 mm) manufactured by Phenomenex Inc.
- Eluent: A solution: 20 mM tetrahydrofuran (THF)/ion exchange water = 80/20 (volume ratio) solution of ammonium acetate; B solution: 20 mM ion exchange aqueous solution of ammonium acetate; A solution/B solution = 32/68 to 100/0 (0 to 15 min), 100/0 (15 to 20 min), and 32/68 (20 to 30 min)
- Flow rate: 1.2 mL/min
- Column temperature: 45°C
- Detection wavelength: 254 nm

-Dispersant-

Dispersants D-1 to D-7: compound having the following structure (numerical value added to each constitutional unit of a main chain is a molar ratio, and a numerical value added to a side chain is the number of repeating units)

| Dispersant | | | |
|---|---|---|---|
| No. | Structure | Copolymer species | Weight-average molecular weight |
| D-1 | 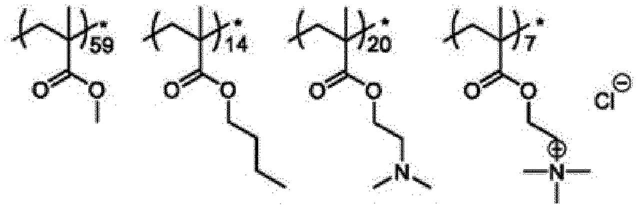 | Random copolymer | 10,000 |
| D-2 | 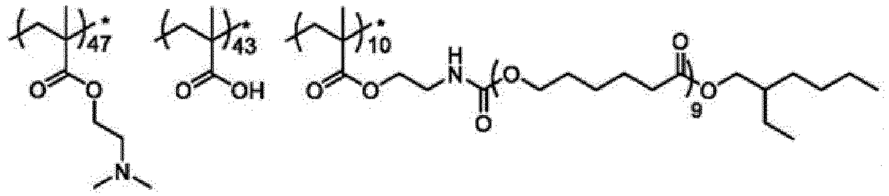 | Alternating copolymer | 10,000 |
| D-3 | 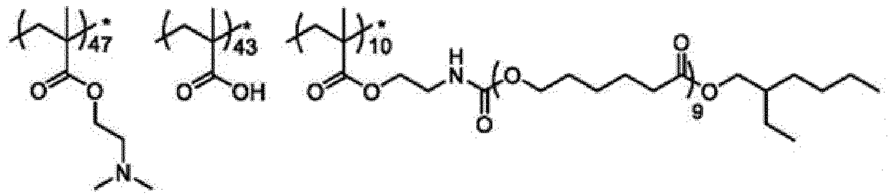 | Random copolymer | 10,000 |
| D-4 | 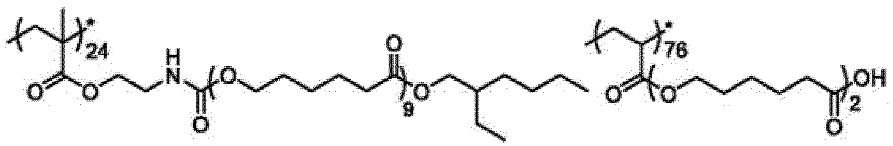 | Random copolymer | 10,000 |
| D-5 | 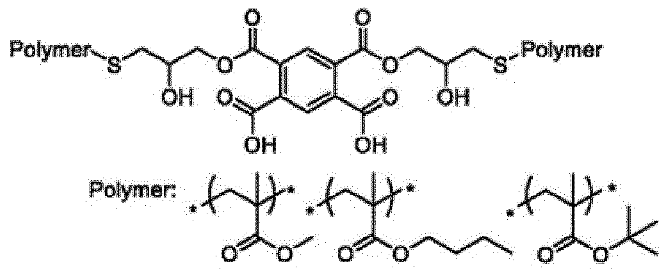 | Multipoint adsorptiontype | 10,000 |

(continued)

| Dispersant | | | |
|---|---|---|---|
| No. | Structure | Copolymer species | Weight-average molecular weight |
| D-6 | 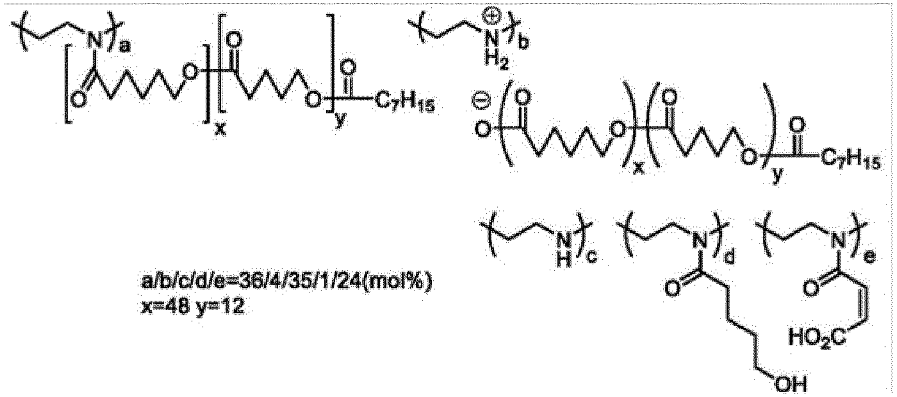 a/b/c/d/e=36/4/35/1/24(mol%) x=48 y=12 | Surface adsorptiontype | 10,000 |
| D-7 | 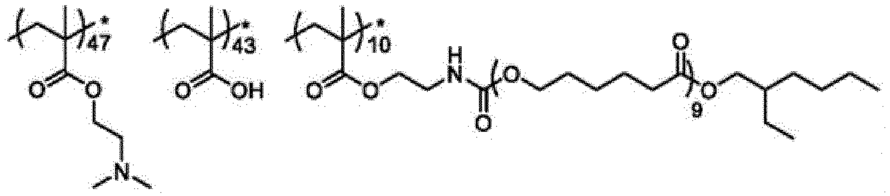 | Block copolymeri zation | 10,000 |

-Binder resin-

Resins B-1 to B-4: binder resins having the following structures (numerical value added to each constitutional unit of a main chain is a molar ratio)
Resin B-5: EPICLON N-695 (cresol novolac-type epoxy resin, weight-average molecular weight: 3,600) manufactured by DIC Corporation
Resin B-6: EHPE 3150 (epoxy resin, 1,2-epoxy-4-(2-oxiranyl)cyclohexane adduct of 2,2'-bis(hydroxymethyl)-1-butanol, weight-average molecular weight: 2,300) manufactured by Daicel Corporation

| Binder resin | | |
|---|---|---|
| No. | Structure | Weight-average molecular weight |
| B-1 | 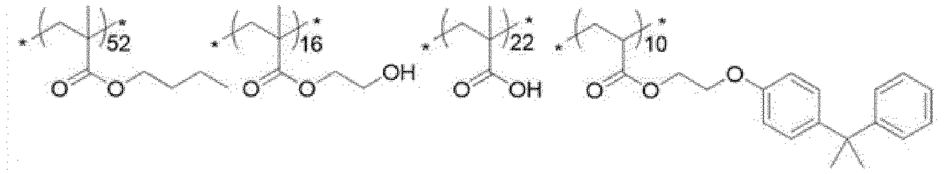 | 10,000 |
| B-2 | 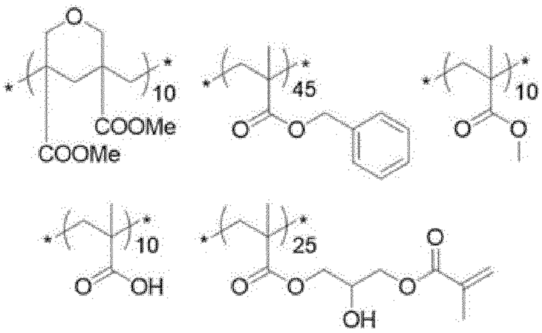 | 10,000 |
| B-3 | 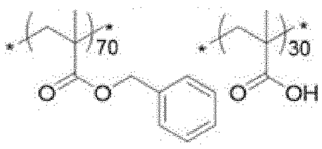 | 10,000 |
| B-4 | 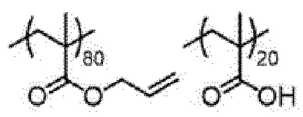 | 41,000 |

-Polymerizable compound-

M-1: NK ESTER A-TMPT (trimethylolpropane triacrylate, manufactured by Shin-Nakamura Chemical Co., Ltd.)
M-2: ARONIX (registered trademark) M-350 (trimethylolpropane EO-modified (n≈1) triacrylate, manufactured by TOAGOSEI CO., LTD.)
M-3: NK ESTER A-TMMT (pentaerythritol tetraacrylate, manufactured by Shin-Nakamura Chemical Co., Ltd.)
M-4: ARONIX (registered trademark) M-403 (dipentaerythritol penta and hexaacrylate, manufactured by TOAGOSEI CO., LTD.)

M-5: ARONIX (registered trademark) M-510 (polybasic acid-modified acrylic oligomer, manufactured by TOAGOSEI CO., LTD.)

-Polymerization initiator-

I-1 (photopolymerization initiator): Omnirad 907 (manufactured by IGM Resins B.V.)
I-2 (photopolymerization initiator): IRGACURE OXE-01 manufactured by BASF
I-3 (photopolymerization initiator): IRGACURE OXE-02 manufactured by BASF
I-4 and I-5 (photopolymerization initiator): compounds having the following structures
I-6 (photopolymerization initiator): ADEKA ARKLS NCI-930 manufactured by ADEKA Corporation

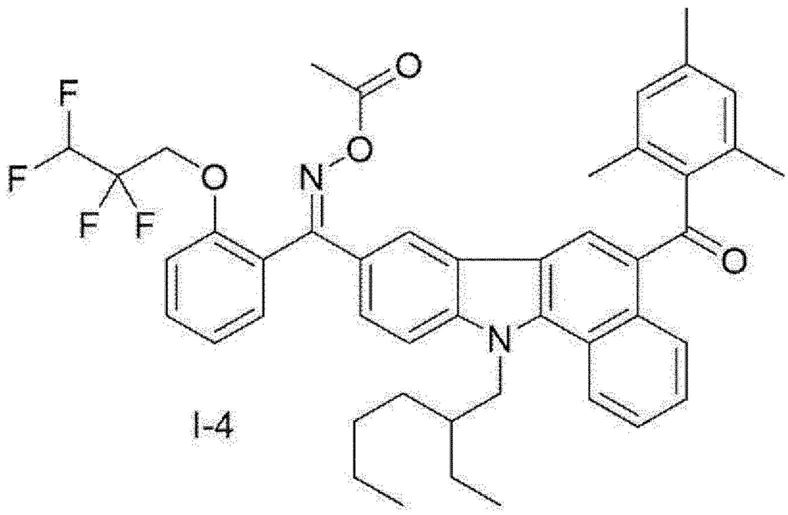

I-4

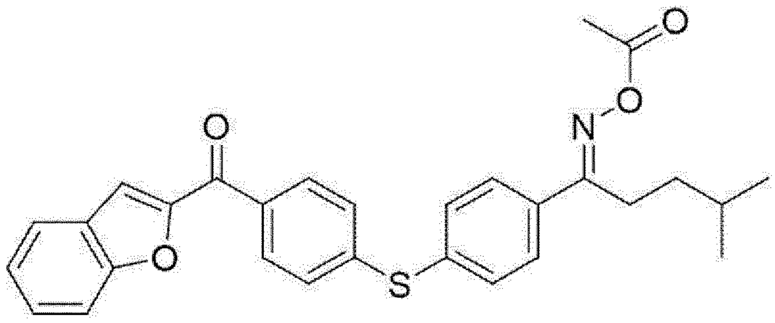

I-5

-Additive-

A-1 (ultraviolet absorber): 4,4'-Bis(diethylamino) benzophenone manufactured by Sigma-Aldrich Co. LLC
A-2 (anti-coloring agent, antioxidant): Irganox 1010 manufactured by BASF
A-3 (epoxy curing agent): DENACOL EX-611 manufactured by Nagase ChemteX Corporation
A-4 (adhesion aid, silane coupling agent): KBM-502 manufactured by Shin-Etsu Chemical Co., Ltd.

-Surfactant-

Su-1: compound having the following structure (62% and 38% are molar ratios indicating the proportions of the

constitutional units of a main chain, respectively, and a numerical value added to a side chain is the number of repeating units)

Su-2: FTERGENT FTX-218 manufactured by NEOS COMPANY LIMITED

Su-3: Megaface (registered trademark) F-554 (fluorine-containing group/lipophilic group-containing oligomer) manufactured by DIC Corporation

Su-4: KF-6001 (both-terminal carbinol-modified polydimethylsiloxane) manufactured by Shin-Etsu Chemical Co., Ltd.

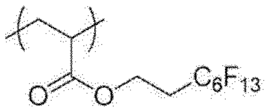

62%

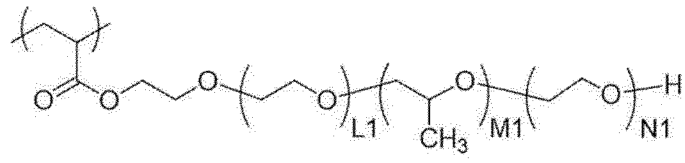

L1+N1+L2+N2=14
M1+M2=17

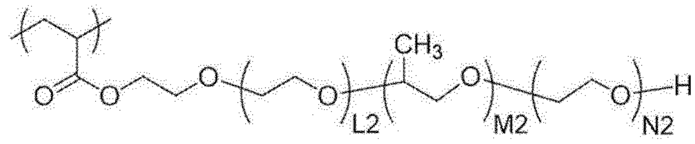

Su-1

38%

-Polymerization inhibitor-

In-1: p-methoxyphenol manufactured by Sanritsu chemy

In-2: 1,4-benzoquinone manufactured by TOKYO CHEMICAL INDUSTRY CO., LTD.

-Solvent-

S-1: propylene glycol monomethyl ether acetate (PGMEA) manufactured by TOKYO CHEMICAL INDUSTRY CO., LTD.

S-2: propylene glycol monomethyl ether manufactured by TOKYO CHEMICAL INDUSTRY CO., LTD.

S-3: cyclopentanone manufactured by TOKYO CHEMICAL INDUSTRY CO., LTD.

<Evaluation>

The following evaluations were carried out for each curable composition.

The results are shown in Tables 2 to 8 and Table 10.

[Evaluation of moisture resistance reliability]

Each curable composition was applied to a glass substrate using a spin coater (manufactured by Mikasa Co., Ltd.) such that the film thickness after pre-baking was 1.0 μm. As a result, a coating film was formed. Next, the coating film was heated (pre-baked) using a hot plate at 100°C for 120 seconds, the entire surface of the coating film was exposed using an i-ray stepper exposure device FPA-3000 i5+ (manufactured by Canon Inc.) at an exposure amount of 1000 mJ/cm$^2$, and then was heated (post-baked) again using a hot plate at 200°C for 300 seconds. As a result, a film was obtained.

With regard to the obtained film, the transmittance of light at a wavelength of 400 to 1300 nm was measured. Next, this film was placed in a thermostat at 85°C and 95% humidity, and stored for 6 months for a humidity test. With regard to the film after the humidity test, the transmittance of light at each wavelength of 400 to 1300 nm was measured. The transmittance of the film was measured using a spectrophotometer (U-4100 manufactured by Hitachi High-Tech Corporation.).

The maximum value (ΔT) of the change in transmittance in a wavelength range of 700 to 1000 nm before and after the humidity test was measured, and evaluated according to the following standard as an indicator of moisture

resistance reliability.

$$\text{Change in transmittance } (\Delta T) = |\text{Transmittance (\%) of film before humidity test} - \text{Transmittance (\%) of film after humidity test}|$$

-Standard-

5: $\Delta T\% < 5\%$
4: $5\% \leq \Delta T\% < 10\%$
3: $10\% \leq \Delta T\% < 15\%$
2: $15\% \leq \Delta T\% < 20\%$
1: $20\% \leq \Delta T\%$

[Evaluation of dispersion stability]

The viscosity of the curable composition immediately after formation was measured. The curable composition in which the viscosity had been measured was stored in a constant-temperature tank at 45°C for 72 hours, and then the viscosity thereof was measured again. The viscosity was measured by adjusting the temperature of the curable composition to 23°C.
The thickening rate was obtained based on the following expression, and evaluated according to the following standard as an indicator of dispersion stability.

$$\text{Thickening Rate (\%)} = ((\text{Viscosity of Curable Composition stored in Constant-Temperature Tank at 45°C for 72 hours} / \text{Viscosity of Curable Composition immediately after Formation}) - 1) \times 100$$

-Standard-

5: thickening rate of the curable composition was 5% or less.
4: thickening rate of the curable composition was more than 5% and 7.5% or less.
3: thickening rate of the curable composition was more than 7.5% and 10% or less.
2: thickening rate of the curable composition was more than 10% and 20% or less.
1: thickening rate of the curable composition was more than 20%.

[Evaluation of development residue]

The curable composition was applied to a silicon wafer using a spin coater (manufactured by Mikasa Co., Ltd.) such that the film thickness after post-baking was 1.0 μm. As a result, a coating film was formed. Next, the silicon wafer was heated using a hot plate at 100°C for 2 minutes. Next, using an i-ray stepper exposure device FPA-3000 i5+ (manufactured by Canon Inc.), the coating film was exposed through a mask having a 1 μm × 1 μm Bayer pattern at an exposure amount of 1000 mJ/$cm^2$. Next, puddle development was performed at 23°C for 60 seconds using a 0.3 mass% of tetramethylammonium hydroxide (TMAH) aqueous solution. Next, the coating film was rinsed by spin showering and was cleaned with pure water. Next, a pattern was formed by heating (post-baking) at 200°C for 5 minutes using a hot plate.
Residues were confirmed and observed using a scanning electron microscope at any 10 locations between patterns (non-exposed portion), and the development residue was evaluated according to the following standard. The results are shown in Table 5.

-Standard-

5: no residue was confirmed at 10 locations of the non-exposed portion.
4: average value of the number of residues having a diameter of 50 nm to 200 nm at 10 locations of the non-exposed portion was more than 0 and 1 or less.
3: average value of the number of residues having a diameter of 50 nm to 200 nm at 10 locations of the non-exposed portion was more than 1 and 5 or less.
2: average value of the number of residues having a diameter of 50 nm to 200 nm at 10 locations of the non-exposed portion was more than 5.
1: at 10 locations of the non-exposed portion, a residue having a diameter of more than 200 nm was present, or the non-exposed portion was hardly dissolved.

[Absorption band]

Each curable composition was applied to a glass substrate using a spin coater (manufactured by Mikasa Co., Ltd.) such that the film thickness after pre-baking was 2.0 μm. As a result, a coating film was formed. Next, the coating film was heated (pre-baked) using a hot plate at 100°C for 120 seconds, the entire surface of the coating film was exposed using an i-ray stepper exposure device FPA-3000 i5+ (manufactured by Canon Inc.) at an exposure amount of 1000 $mJ/cm^2$, and then was heated (post-baked) again using a hot plate at 200°C for 300 seconds. As a result, a film was obtained.

With regard to the obtained film, using a spectrophotometer (U-4100 manufactured by Hitachi High-Tech Corporation.), the transmittance of light having a wavelength of 400 to 1300 nm was measured, and an average value T1% of the transmittance of 400 to 700 nm and a maximal absorption wavelength W1 existing in the longest wave were determined.

From the determined values, the absorption band of the film was evaluated according to the following standard.

-Standard-

"Visible to IR region": refers to having absorption in the visible to IR region, and W1 > 700 nm and T1% < 50%.
"IR region": refers to having absorption only in the IR region, and W1 > 700 nm and T1% > 50%.
"Visible region": refers to having absorption in the visible region, and W1 < 700 nm.

From the results shown in Tables 2 to 8 and Table 10, it was found that the curable compositions of Examples 1 to 81, which were the compositions according to the embodiment of the present disclosure, were superior in dispersion stability of the pigment and moisture resistance of the film to be formed, and further, the development residue was also reduced, as compared with the compositions of Comparative Examples 1 to 5.

(Example A)

Using the composition of Example 38 or 39, a dot removal pattern (infrared cut filter) of 2 μm square was formed by the following method, and using any one of the compositions of Examples 1 to 10, 15 to 37, and 40 to 81, a pattern (infrared transmitting filter) of 2 μm square was formed by the following method.

Using the curable composition of Example 38 or 39, a pattern was produced by the following method.

A silicon wafer was coated with the above-described curable composition by a spin coating method so that the thickness of a film after film formation was 1.0 μm. Next, the silicon wafer was heated using a hot plate at 100°C for 2 minutes. Next, using an i-ray stepper exposure device FPA-3000 i5+ (manufactured by Canon Inc.), exposure was performed at 1,000 $mJ/cm^2$ through a mask having a dot removal pattern of 2 μm square. Next, puddle development was performed at 23°C for 60 seconds using a 0.3 mass% of tetramethylammonium hydroxide (TMAH) aqueous solution. Next, the coating film was rinsed by spin showering and was cleaned with pure water. Next, the coating film was heated using a hot plate at 200°C for 5 minutes. As a result, a dot removal pattern (infrared cut filter) of 2 μm square was formed.

Next, a Red composition was applied to the pattern of the infrared cut filter by a spin coating method so that the thickness of a film after film formation was 1.0 μm. Next, the Red composition was heated using a hot plate at 100°C for 2 minutes. Next, using an i-ray stepper exposure device FPA-3000 i5+ (manufactured by Canon Inc.), exposure was performed at 1,000 $mJ/cm^2$ through a mask having a dot pattern of 2 μm square. Next, puddle development was

performed at 23°C for 60 seconds using a 0.3 mass% of tetramethylammonium hydroxide (TMAH) aqueous solution. Next, the coating film was rinsed by spin showering and was cleaned with pure water. Next, the coating film was heated using a hot plate at 200°C for 5 minutes. As a result, the Red composition was patterned on the pattern of the infrared cut filter. Likewise, a Green composition and a Blue composition were sequentially patterned to form red, green, and blue colored patterns (Bayer pattern).

The Bayer pattern refers to a pattern, as disclosed in the specification of US3971065A, in which a 2 × 2 array of color filter element having one Red element, two Green elements, and one Blue element is repeated. However, in this example, a 2 × 2 array of a filter element having one red element, one green element, one blue element, and one infrared transmitting filter element was repeated to form a Bayer pattern.

Next, a composition for forming an infrared transmitting filter (any one of the compositions of Examples 1 to 10, 15 to 37, and 40 to 81) was applied to the pattern-formed film by a spin coating method such that the thickness of a film after film formation was 2.0 μm. Next, the composition was heated using a hot plate at 100°C for 2 minutes. Next, using an i-ray stepper exposure device FPA-3000 i5+ (manufactured by Canon Inc.), exposure was performed at 1,000 $mJ/cm^2$ through a mask having a dot pattern of 2 μm square. Next, puddle development was performed at 23°C for 60 seconds using a 0.3 mass% of tetramethylammonium hydroxide (TMAH) aqueous solution. Next, the coating film was rinsed by spin showering and was cleaned with pure water. Next, the coating film was heated using a hot plate at 200°C for 5 minutes. As a result, in the dot removal pattern of the infrared cut filter, the infrared transmitting filter was patterned in a missing portion where the colored pattern was not formed. This filter was incorporated into a solid-state imaging element using a known method.

The obtained solid-state imaging element was irradiated with infrared rays by an infrared light emitting diode (infrared LED) in a low-illuminance environment (0.001 Lux) to acquire images. Next, the imaging performance of the solid-state imaging element was evaluated. Regardless of the combination of curable compositions, the image could be clearly recognized even in a low-illuminance environment.

The Red composition, the Green composition, and the Blue composition used for the above-described patterning are as follows.

-Red composition-

The following components were mixed and stirred, and the obtained mixture was filtered through a nylon filter (manufactured by Nihon Pall Corporation) having a pore size of 0.45 μm to prepare a Red composition.

Red pigment dispersion liquid: 51.7 parts by mass
Resin 1 (40 mass% PGMEA solution): 0.6 parts by mass
Polymerizable compound 2: 0.6 parts by mass
Photopolymerization initiator 1: 0.3 parts by mass
Surfactant 1: 4.2 parts by mass
PGMEA: 42.6 parts by mass

-Green composition-

The following components were mixed and stirred, and the obtained mixture was filtered through a nylon filter (manufactured by Nihon Pall Corporation) having a pore size of 0.45 μm to prepare a Green composition.

Green pigment dispersion liquid: 73.7 parts by mass
Resin 1 (40 mass% PGMEA solution): 0.3 parts by mass
Polymerizable compound 1: 1.2 parts by mass
Photopolymerization initiator 1: 0.6 parts by mass
Surfactant 1: 4.2 parts by mass
Ultraviolet absorber (UV-503, manufactured by Daito Chemical Co., Ltd.): 0.5 parts by mass
PGMEA: 19.5 parts by mass

-Blue composition-

The following components were mixed and stirred, and the obtained mixture was filtered through a nylon filter (manufactured by Nihon Pall Corporation) having a pore size of 0.45 μm to prepare a Blue composition.

Blue pigment dispersion liquid: 44.9 parts by mass
Resin 1 (40 mass% PGMEA solution): 2.1 parts by mass

Polymerizable compound 1: 1.5 parts by mass
Polymerizable compound 2: 0.7 parts by mass
Photopolymerization initiator 1: 0.8 parts by mass
Surfactant 1: 4.2 parts by mass
PGMEA: 45.8 parts by mass

Raw materials used in the Red composition, the Green composition, and the Blue composition are as follows.

• Red pigment dispersion liquid

A mixed solution consisting of 9.6 parts by mass of C. I. Pigment Red 254, 4.3 parts by mass of C. I. Pigment Yellow 139, 6.8 parts by mass of a dispersant (Disperbyk-161, manufactured by BYK Chemie), and 79.3 parts by mass of PGMEA was mixed and dispersed using a beads mill (zirconia beads; diameter: 0.3 mm) for 3 hours to prepare a pigment dispersion liquid. Next, using a high-pressure disperser NANO-3000-10 (manufactured by Nippon BEE Chemical Co., Ltd.) equipped with a pressure reducing mechanism, the pigment dispersion liquid was further dispersed under a pressure of 2,000 $kg/cm^3$ at a flow rate of 500 g/min. This dispersion treatment was repeated 10 times, thereby obtaining a Red pigment dispersion liquid.

• Green pigment dispersion liquid

A mixed solution consisting of 6.4 parts by mass of C. I. Pigment Green 36, 5.3 parts by mass of C. I. Pigment Yellow 150, 5.2 parts by mass of a dispersant (Disperbyk-161, manufactured by BYK Chemie), and 83.1 parts by mass of PGMEA was mixed and dispersed using a beads mill (zirconia beads; diameter: 0.3 mm) for 3 hours to prepare a pigment dispersion liquid. Next, using a high-pressure disperser NANO-3000-10 (manufactured by Nippon BEE Chemical Co., Ltd.) equipped with a pressure reducing mechanism, the pigment dispersion liquid was further dispersed under a pressure of 2,000 $kg/cm^3$ at a flow rate of 500 g/min. This dispersion treatment was repeated 10 times. As a result, a Green pigment dispersion liquid was obtained.

• Blue pigment dispersion liquid

A mixed solution consisting of 9.7 parts by mass of C. I. Pigment Blue 15:6, 2.4 parts by mass of C. I. Pigment Violet 23, 5.5 parts by mass of a dispersant (Disperbyk-161, manufactured by BYK Chemie), and 82.4 parts by mass of PGMEA was mixed and dispersed using a beads mill (zirconia beads; diameter: 0.3 mm) for 3 hours to prepare a pigment dispersion liquid. Next, using a high-pressure disperser NANO-3000-10 (manufactured by Nippon BEE Chemical Co., Ltd.) equipped with a pressure reducing mechanism, the pigment dispersion liquid was further dispersed under a pressure of 2,000 $kg/cm^3$ at a flow rate of 500 g/min. This dispersion treatment was repeated 10 times, thereby obtaining a Blue pigment dispersion liquid.

Details of the abbreviations for the components used above are shown below.

- Polymerizable compound 1: KAYARAD DPHA (mixture of dipentaerythritol hexaacrylate and dipentaerythritol pentaacrylate, manufactured by Nippon Kayaku Co., Ltd.)
- Polymerizable compound 2: following structure

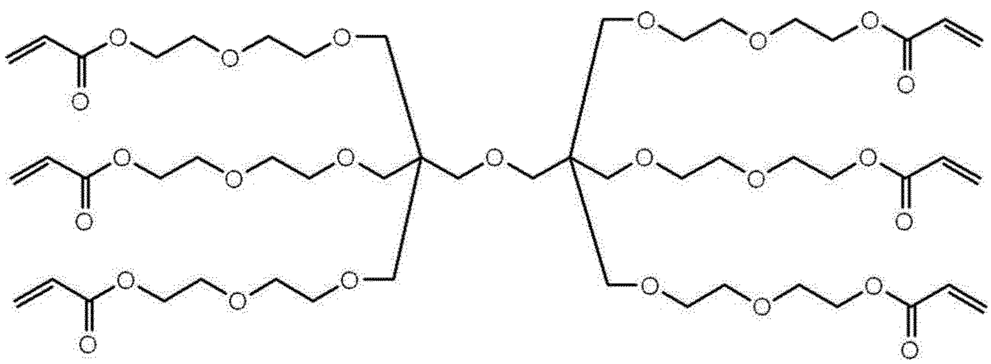

• Resin 1: following structure (acid value: 70 mgKOH/g, Mw = 11,000; a ratio in a constitutional unit is a molar ratio)

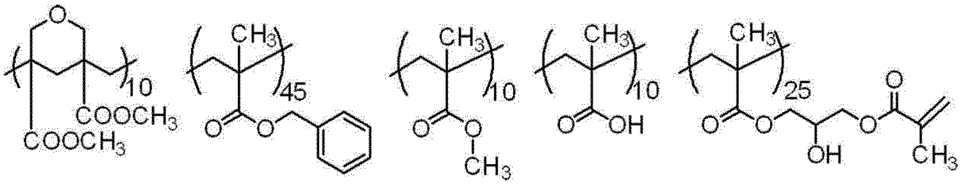

• Photopolymerization initiator 1: IRGACURE OXE01 (1-[4-(phenylthio)phenyl]-1,2-octanedione-2-(O-benzoyloxime), manufactured by BASF)

• Surfactant 1: 1 mass% PGMEA solution of the following mixture (Mw: 14,000; in the following formula, "%" (62% and 38%) indicating the proportion of a constitutional unit is molar ratio)

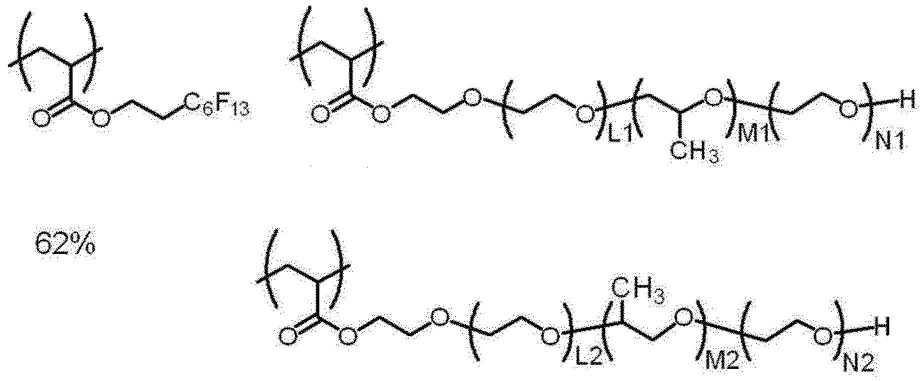

62%

L1+N1+L2+N2=14

M1+M2=17

38%

Explanation of References

110: solid-state imaging element
111: infrared cut filter
112: color filter
114: infrared transmitting filter
115: microlens
116: planarizing layer

## Claims

**1.** A composition comprising:

a pigment;
a pigment derivative which has at least one group selected from the group consisting of groups represented by any one of Formula (1) to Formula (4);
a dispersant which has a constitutional unit having an adsorbing group and a constitutional unit having a steric repulsive group, and is a random copolymer or an alternating copolymer; and

a solvent,

Formula (1): $-NH-R^1$

in Formula (1), $R^1$ is a substituent represented by $-COR^{11}$, $-SO_2R^{11}$, or $PO(R^{11})_2$, which has a total carbon number of 10 or less, and $R^{11}$'s each independently represent a hydrogen atom or a monovalent organic group having 1 or more carbon atoms,

Formula (2): $-L-NH-R^2$

in Formula (2), L represents -CO-, $-SO_2-$, or $-PO(R^{21})-$, $R^{21}$ represents a hydrogen atom or a monovalent organic group having 1 or more carbon atoms, $R^2$ represents $-COR^{22}$, $-SO_2R^{22}$, or $-PO(R^{22})_2$, and $R^{22}$'s each independently represent a hydrogen atom or a monovalent organic group having 1 or more carbon atoms,

Formula (3): $-N^+(R^3)_3\ X^-$

in Formula (3), $R^3$'s each independently represent a hydrogen atom or a monovalent organic group having 1 or more carbon atoms, at least one of three $R^3$'s is an alkyl group having 3 or more carbon atoms, and $X^-$ represents a counter anion,

Formula (4): $-L-N^+(R^4)_3\ X^-$

in Formula (4), L represents -CO-, $-SO_2-$, or $-PO(R^{42})-$, $R^{42}$ represents a hydrogen atom or a monovalent organic group having 1 or more carbon atoms, $R^4$'s each independently represent a hydrogen atom or a monovalent organic group having 1 or more carbon atoms, at least one of three $R^4$'s is an alkyl group having 3 or more carbon atoms, and $X^-$ represents a counter anion.

**2.** The composition according to claim 1,
wherein the pigment derivative has a group represented by Formula (2).

**3.** The composition according to claim 2,
wherein L in Formula (2) represents -CO-, $R^2$ represents $-SO_2R^{22}$, and $R^{22}$ represents a monovalent organic group having 1 or more carbon atoms.

**4.** The composition according to claim 2 or 3,
wherein L in Formula (2) represents -CO-, $R^2$ represents $-SO_2R^{22}$, and $R^{22}$ represents a monovalent organic group including a fluorine atom and having 1 or more carbon atoms.

**5.** The composition according to any one of claims 1 to 4,
wherein the dispersant is a random copolymer.

**6.** The composition according to any one of claims 1 to 5,
wherein the dispersant has a basic group as the adsorbing group.

**7.** The composition according to any one of claims 1 to 6,
wherein the pigment includes a pigment having absorption in an infrared region.

**8.** The composition according to any one of claims 1 to 7,
wherein the pigment and the pigment derivative have the same coloring agent skeleton.

**9.** The composition according to claim 8,
wherein the coloring agent skeleton is a squarylium coloring agent skeleton or a croconium coloring agent skeleton.

**10.** The composition according to any one of claims 1 to 9,
wherein the pigment includes a chromatic pigment.

**11.** The composition according to any one of claims 1 to 10, further comprising:

a polymerizable compound; and
a polymerization initiator.

**12.** A film which consists of the composition according to any one of claims 1 to 11 or is obtained by curing the composition.

**13.** An optical filter comprising:
the film according to claim 12.

**14.** The optical filter according to claim 13,
wherein the optical filter is an infrared cut filter or an infrared transmitting filter.

**15.** A solid-state imaging element comprising:
the film according to claim 12.

**16.** An infrared sensor comprising:
the film according to claim 12.

**17.** A method for manufacturing an optical filter, comprising:

applying the composition according to claim 11 to a support to form a composition layer;
exposing the composition layer in a patterned manner; and
developing and removing a non-exposed portion of the composition layer to form a pattern.

**18.** A method for manufacturing an optical filter, comprising:

applying the composition according to claim 11 to a support to form a composition layer and curing the composition to form a cured composition layer;
forming a photoresist layer on the cured composition layer;
obtaining a resist pattern by patterning the photoresist layer by exposure and development; and
dry-etching the layer using the resist pattern as an etching mask.

**19.** A sensor module comprising:

a photoelectric conversion element; and
the optical filter according to claim 13 or 14.

FIG. 1

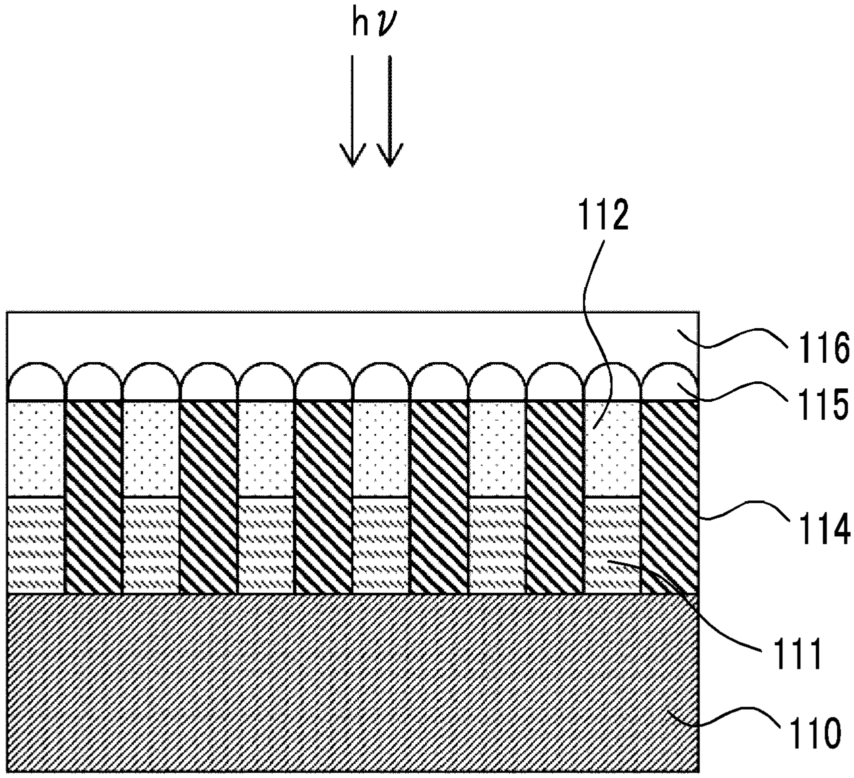

**INTERNATIONAL SEARCH REPORT**

International application No. PCT/JP2020/028984

A. CLASSIFICATION OF SUBJECT MATTER
G02B 5/22(2006.01)i; C09B 67/20(2006.01)i; G03F 7/004(2006.01)i; G03F 7/027(2006.01)i; H01L 27/144(2006.01)i; H01L 27/146(2006.01)i; H01L 31/0232(2014.01)i
FI: G02B5/22; C09B67/20 F; C09B67/20 L; H01L27/146 D; H01L27/144 K; H01L31/02 D; G03F7/004 504; G03F7/004 505; G03F7/027
According to International Patent Classification (IPC) or to both national classification and IPC

B. FIELDS SEARCHED

Minimum documentation searched (classification system followed by classification symbols)
G02B5/22; C09B67/20; G03F7/004; G03F7/027; H01L27/144; H01L27/146; H01L31/0232

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X | WO 2018/230387 A1 (FUJIFILM CORPORATION) 20.12.2018 (2018-12-20) paragraphs [0135]-[0180], [0269]-[0275], [0293]-[0305], [0328]-[0334], [0339], [0348], fig. 1 | 1-19 |
| A | JP 2015-138133 A (TOYO INK SC HOLDINGS CO., LTD.) 30.07.2015 (2015-07-30) entire text | 1-19 |
| A | JP 2012-224718 A (DAINICHISEIKA COLOR & CHEMICALS MFG. CO., LTD.) 15.11.2012 (2012-11-15) entire text | 1-19 |
| A | JP 2012-211228 A (DAINICHISEIKA COLOR & CHEMICALS MFG. CO., LTD.) 01.11.2012 (2012-11-01) entire text | 1-19 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 September 2020 (24.09.2020) | 06 October 2020 (06.10.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/028984

| Patent Documents referred in the Report | Publication Date | Patent Family | Publication Date |
|---|---|---|---|
| WO 2018/230387 A1 | 20 Dec. 2018 | TW 201903061 A | |
| JP 2015-138133 A | 30 Jul. 2015 | (Family: none) | |
| JP 2012-224718 A | 15 Nov. 2012 | (Family: none) | |
| JP 2012-211228 A | 01 Nov. 2012 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018087939 A
- WO 2018230387 A
- JP 2011208101 A
- JP 6065169 B
- WO 2016181987 A
- WO 2013133099 A
- WO 2014088063 A
- JP 2014126642 A
- JP 2016146619 A
- JP 2015176046 A
- JP 2017025311 A
- WO 2016154782 A
- JP 5884953 B
- JP 6036689 B
- JP 5810604 B
- JP 2017068120 A
- JP 2007271745 A
- JP 2007031644 A
- JP 2007169315 A
- JP 2009263614 A
- JP 2011068731 A
- WO 2015166873 A
- WO 2017146092 A
- WO 2013098836 A
- WO 2015118720 A
- CN 20106909027 A
- WO 2012102395 A
- JP 2018180023 A
- JP 2012247591 A
- JP 2011157478 A
- JP 2018203798 A
- JP 2018062578 A
- JP 6432077 B
- JP 6432076 B
- JP 2018155881 A
- JP 2018111757 A
- JP 2018040835 A
- JP 2017197640 A
- JP 2016145282 A
- JP 2014085565 A
- JP 2014021139 A
- JP 2013209614 A
- JP 2013209435 A
- JP 2013181015 A
- JP 2013061622 A
- JP 2013054339 A
- JP 2013032486 A
- JP 2012226110 A
- JP 2008074987 A
- JP 2008081565 A
- JP 2008074986 A
- JP 2008074985 A
- JP 2008050420 A
- JP 2008031281 A
- JP 48032765 B
- JP S4832765 B
- JP 6443711 B
- JP 2014026228 A
- JP 2019008014 A
- JP 2018062644 A
- JP 2017201384 A
- JP 6248838 B
- WO 2012102399 A
- WO 2012117965 A
- JP 2012229344 A
- JP 2015047520 A
- JP 2011075786 A
- WO 2013061621 A
- JP 2015164881 A
- JP 2007302836 A
- JP 2012169556 A
- WO 2018230486 A
- WO 2014003111 A
- JP 48041708 B
- JP S4841708 B
- JP 51037193 A
- JP S5137193 A
- JP 2032293 B
- JP H232293 B
- JP 2016765 B
- JP H216765 B
- JP 58049860 B
- JP S5849860 B
- JP 56017654 B
- JP S5617654 B
- JP 62039417 B
- JP 62039418 B
- JP S6239418 B
- JP 63277653 A
- JP 63260909 A
- JP 1105238 A
- JP H1105238 A
- JP 2007277514 A
- JP 2015187211 A
- JP 2014130173 A
- JP 2013029760 A
- JP 2001233842 A
- JP 2000080068 A

- JP 2006342166 A
- JP 2000066385 A
- JP 2004534797 A
- JP 2017019766 A
- JP 6065596 B
- WO 2015152153 A
- WO 2017051680 A
- JP 2012014052 A
- JP 2009519904 A
- US 7626957 B
- JP 2010015025 A
- US 2009292039 A
- WO 2009131189 A
- US 7556910 B
- JP 2009221114 A
- JP 2014137466 A
- WO 2015036910 A
- WO 2013083505 A
- JP 2010262028 A
- JP 2014500852 A
- JP 2013164471 A
- JP 2013114249 A
- JP 4223071 B
- JP 2010527339 A
- JP 2011524436 A
- WO 2015004565 A
- JP 2016532675 A
- WO 2017033680 A
- JP 2013522445 A
- WO 2016034963 A
- WO 2016088645 A
- JP 2017057265 A
- JP 2017032685 A
- JP 2017075248 A
- JP 2017066240 A
- US 20170102610 A
- EP 568993 B
- US 4508811 A
- US 5227227 A
- JP 2001125255 A
- JP 11271969 A
- JP H11271969 A
- JP 2015123351 A
- JP 2009145395 A
- JP 2003262716 A
- JP 2003185831 A
- JP 2003261827 A
- JP 2012126830 A
- JP 2006169325 A
- JP 2013064993 A
- WO 2015099060 A
- JP 2014041318 A
- JP 2012227478 A
- JP 2014179577 A
- JP 2003045676 A
- JP 2014043556 A
- JP 2016006476 A
- JP 2014197190 A
- US 3971065 A

**Non-patent literature cited in the description**


- *Journal of Photopolymer Science and Technology,* 1995, 202-232
- Extension of Use of Ink Jet -Infinite Possibilities in Patent. S. B. Research Co., Ltd, February 2005, 115-133
- **AKIO SASAKI ; KOGYO CHOSAKAI PUBLISHING CO., LTD.** Electronic Display Device. 1990
- **SUMIAKI IBUKI.** Display Device. Sangyo Tosho Co., Ltd, 1989
- Liquid Crystal Display Technology for Next Generation. Kogyo Chosakai Publishing Co., Ltd, 1994
- Forefront of Organic EL Technology Development -Know-How Collection of High Brightness, High Precision, and Long. Technical Information Institute, 2008